(19) Europäisches Patentamt
European Patent Office
Office européen des brevets

(11) **EP 2 478 563 B1**

(12) **EUROPEAN PATENT SPECIFICATION**

(45) Date of publication and mention
of the grant of the patent:
**07.04.2021 Bulletin 2021/14**

(21) Application number: **10817106.7**

(22) Date of filing: **03.09.2010**

(51) Int Cl.:
**H01L 29/786** *(2006.01)*     **H01L 29/66** *(2006.01)*

(86) International application number:
**PCT/JP2010/065568**

(87) International publication number:
**WO 2011/033993 (24.03.2011 Gazette 2011/12)**

(54) **METHOD FOR MANUFACTURING A SAMESEMICONDUCTOR DEVICE**

HERSTELLUNGSVERFAHREN FÜR HALBLEITERBAUELEMENT

PROCÉDÉ DE FABRICATION D'UN DISPOSITIF À SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **16.09.2009 JP 2009215077**
**19.02.2010 JP 2010035349**

(43) Date of publication of application:
**25.07.2012 Bulletin 2012/30**

(73) Proprietor: **Semiconductor Energy Laboratory Co, Ltd.**
**Atsugi-shi, Kanagawa, 243-0036 (JP)**

(72) Inventors:
• **YAMAZAKI, Shunpei**
**Atsugi-shi**
**Kanagawa-ken 243-0036 (JP)**
• **TSUBUKU, Masashi**
**Atsugi-shi**
**Kanagawa-ken 243-0036 (JP)**
• **GODO, Hiromichi**
**Atsugi-shi**
**Kanagawa-ken 243-0036 (JP)**

(74) Representative: **Grünecker Patent- und Rechtsanwälte**
**PartG mbB**
**Leopoldstraße 4**
**80802 München (DE)**

(56) References cited:
**EP-A2- 1 770 788**     **WO-A1-2008/062720**
**WO-A1-2008/126879**     **WO-A1-2008/126879**
**WO-A2-2009/041713**     **US-A1- 2008 277 663**

**Description**

TECHNICAL FIELD

The present invention relates to a method of forming a semiconductor device including an oxide semiconductor.
In this specification, a semiconductor device generally means a device which can function by utilizing semiconductor characteristics, and an electro-optical device, a semiconductor circuit, and an electronic device are all semiconductor devices.

BACKGROUND ART

In recent years, a technique for forming a thin film transistor (TFT) by using a semiconductor thin film (having a thickness of approximately several nanometers to several hundred nanometers) formed over a substrate having an insulating surface has attracted attention. Thin film transistors are applied to a wide range of electronic devices such as ICs or electro-optical devices, and prompt development of thin film transistors that are to be used as switching elements in image display devices, in particular, is being pushed. Various metal oxides are used for a variety of applications. Indium oxide is a well-known material and is used as a transparent electrode material which is necessary in a liquid crystal display and the like.
Some metal oxides have semiconductor characteristics. Examples of such metal oxides having semiconductor characteristics include tungsten oxide, tin oxide, indium oxide, zinc oxide, and the like. A thin film transistor in which a channel formation region is formed using such a metal oxide having semiconductor characteristics is known (Patent Documents 1 and 2).

[Reference]

[Patent Document]

[Patent Document 1] Japanese Published Patent Application No. 2007-123861
[Patent Document 2] Japanese Published Patent Application No. 2007-09605f

US 2008/0277663 discloses a method of forming an oxide semiconductor device using heat treatment steps.

DISCLOSURE OF INVENTION

In an active-matrix display device, the electric characteristics of thin film transistors included in a circuit are important and performance of the display device is dependent on the electric characteristics of the thin film transistors. Among the electric characteristics of the thin film transistors, in particular, a threshold voltage (hereinafter also referred to as a threshold value or Vth) is important. When the threshold voltage of the thin film transistor is high or negative even when the field effect mobility is high, it is difficult to control a circuit including the thin film transistor. When the thin film transistor has a high threshold voltage and a large absolute value of its threshold voltage, the thin film transistor cannot perform a switching function as a TFT when the thin film transistor is driven at low voltage and may be a load. Further, when the threshold voltage is negative, current tends to flow between source and drain electrodes even if gate voltage is 0 V, that is, the thin film transistor tends to be normally on.
In the case of an n-channel thin film transistor, a preferable thin film transistor has a structure in which a channel is formed and drain current begins to flow after positive voltage is applied as the gate voltage. A thin film transistor in which a channel is not formed unless driving voltage is raised and a thin film transistor in which a channel is formed and drain current flows even when negative voltage is applied are unsuitable for a thin film transistor used in a circuit.
For example, in a semiconductor device, when the characteristics of a thin film transistor included in a circuit are changed greatly, a malfunction could be caused due to a change in threshold voltage of the thin film transistor. Therefore, it is an object of an embodiment of the present invention to provide a thin film transistor which operates stably in a wide temperature range and a semiconductor device including the thin film transistor.
According to an embodiment of the present invention disclosed in this specification, a method for manufacturing a semiconductor device according to claim 1 includes the steps of:
forming a gate electrode layer over a substrate having an insulating surface, forming a gate insulating layer over the gate electrode layer, forming an oxide semiconductor layer over the gate insulating layer, performing first heat treatment after forming the oxide semiconductor layer, forming a source electrode layer and a drain electrode layer over the oxide semiconductor layer, forming an insulating layer in contact with part of the oxide semiconductor layer over the gate insulating layer, the oxide semiconductor, the source electrode layer, and the drain electrode layer, and performing second heat treatment after forming the insulating layer.

Note that the first heat treatment is preferably performed in a nitrogen atmosphere or a rare gas atmosphere. In addition, the first heat treatment is preferably performed at a temperature of greater than or equal to 350 °C and less than or equal to 750 °C.

The second heat treatment is preferably performed in air, an oxygen atmosphere, a nitrogen atmosphere, or a rare gas atmosphere. In addition, the second heat treatment is preferably performed at a temperature of greater than or equal to 100 °C and less than or equal to the temperature of the first heat treatment.

With the above method, at least one of the above objects can be achieved.

A thin film of a material expressed by $InMO_3(ZnOP)m$ ($m > 0$) is formed using an oxide semiconductor described in this specification, and a thin film transistor including the thin film as an oxide semiconductor layer is manufactured. Note that $m$ is not always an integer. Further, M denotes one metal element or a plurality of metal elements selected from Ga, Fe, Ni, Mn, and Co. As an example, M may be Ga or may include the above metal element in addition to Ga, for example, M may be Ga and Ni or Ga and Fe. Moreover, in the above oxide semiconductor, in some cases, a transition metal element such as Fe or Ni or an oxide of the transition metal element is contained as an impurity element in addition to a metal element contained as M. In this specification, as for an oxide semiconductor layer whose composition formula is represented by $InMO_3 (ZnO)_m$ ($m > 0$), an oxide semiconductor in which Ga is contained as M is referred to as an In-Ga-Zn-O-based oxide semiconductor, and a thin film thereof is referred to as an In-Ga-Zn-O-based non-single-crystal film.

As the oxide semiconductor which is applied to the oxide semiconductor layer, any of the following oxide semiconductors can be applied in addition to the above: an In-Sn-Zn-O-based oxide semiconductor; an In-Al-Zn-O-based oxide semiconductor; a Sn-Ga-Zn-O-based oxide semiconductor; an Al-Ga-Zn-O-based oxide semiconductor; a Sn-Al-Zn-O-based oxide semiconductor; an In-Zn-O-based oxide semiconductor; a Sn-Zn-O-based oxide semiconductor; an Al-Zn-O-based oxide semiconductor; an In-O-based oxide semiconductor; a Sn-O-based oxide semiconductor; and a Zn-O-based oxide semiconductor. Silicon oxide is contained in the oxide semiconductor layer. When silicon oxide ($SiO_x$ ($x > 0$)) which hinders crystallization is contained in the oxide semiconductor layer, crystallization of the oxide semiconductor layer can be suppressed in the case where heat treatment is performed after the formation of the oxide semiconductor layer in the manufacturing process. Note that the preferable state of the oxide semiconductor layer is amorphous, or partial crystallization thereof is acceptable.

The oxide semiconductor is preferably an oxide semiconductor containing In, more preferably, an oxide semiconductor containing In and Ga. Dehydration or dehydrogenation is effective in forming an i-type (intrinsic) oxide semiconductor layer.

Depending on conditions of the heat treatment or the material of the oxide semiconductor layer, the oxide semiconductor layer in an amorphous state may change into a microcrystalline film or a polycrystalline film. Even when the oxide semiconductor layer is a microcrystalline film or a polycrystalline film, switching characteristics as a TFT can be obtained.

A thin film transistor whose threshold voltage does not change greatly and whose electric characteristics are stable can be manufactured. Therefore, a semiconductor device which includes a highly reliable thin film transistor having favorable electric characteristics can be provided.

BRIEF DESCRIPTION OF DRAWINGS

FIGS. 1A to 1E are views illustrating a manufacturing process of a semiconductor device.
FIGS. 2A to 2C are views each illustrating a semiconductor device.
FIGS. 3A and 3B are a schematic cross-sectional structural view of a sample used in analysis and a graph showing the analysis result of the hydrogen concentration in an oxide semiconductor layer.
FIGS. 4A to 4C are graphs each showing current vs. voltage characteristics of a thin film transistor in Example 1.
FIGS. 5A and 5B are a table and a graph showing a relation between the operation temperature and the threshold voltage of a thin film transistor in Example 1.
FIG 6 is a graph showing how to define the threshold voltage in this specification.
FIGS. 7A and 7B are block diagrams of a semiconductor device.
FIGS. 8A and 8B are a diagram showing the structure of a signal line driver circuit and a timing chart showing its operation.
FIGS. 9A to 9D are circuit diagrams each showing the structure of a shift register.
FIGS. 10A and 10B are a diagram showing the structure of a shift register and a timing chart showing its operation.
FIGS. 11A-1 to 11B are views illustrating a semiconductor device.

FIG. 12 is a view illustrating a semiconductor device.

FIG. 13 is a view illustrating a semiconductor device.

FIG. 14 is a diagram showing an equivalent circuit of a pixel of a semiconductor device.

FIGS. 15A to 15C are views each illustrating a semiconductor device.

FIGS. 16A and 16B are views illustrating a semiconductor device.

FIG 17 is a view illustrating a semiconductor device.

FIG. 18 is a view illustrating a semiconductor device.

FIG. 19 is a view illustrating a semiconductor device.

FIG. 20 is a circuit diagram illustrating the structure of a semiconductor device.

FIG. 21 is a view illustrating a semiconductor device.

FIG 22 is a view illustrating a semiconductor device.

FIG. 23 is a view illustrating a semiconductor device.

FIG. 24 is a circuit diagram illustrating the structure of a semiconductor device.

FIG 25 is a view illustrating an example of an e-book reader.

FIGS. 26A and 26B are a view illustrating an example of a television set and a view illustrating an example of a digital photo frame, respectively.

FIGS. 27A and 27B are views illustrating examples of a game machine.

FIGS. 28A and 28B are a view illustrating an example of a portable computer and a view illustrating an example of a mobile phone, respectively.

FIGS. 29A to 29D are a view showing the cross-sectional structure of a semiconductor device used in calculation and graphs showing calculation results of the semiconductor device.

FIG. 30 is a graph showing current vs. voltage characteristics of a thin film transistor.

FIGS. 31A and 31B are a table and a graph showing a relation between the operation temperature and the threshold voltage of a thin film transistor.

FIGS. 32A and 32B are views each illustrating a cross-sectional structure used in calculation of a semiconductor device.

FIGS. 33A to 33D are graphs showing calculation results of semiconductor devices.

FIGS. 34A and 34B are graphs each showing current vs. voltage characteristics of a thin film transistor in Example 2.

FIGS. 35A and 35B are a table and a graph showing a relation between the operation temperature and the threshold voltage of a thin film transistor in Example 2.

BEST MODE FOR CARRYING OUT THE INVENTION

Hereinafter, embodiments of the present invention will be described in detail with reference to the accompanying drawings. However, the present invention is not limited to the description below, and it is easily understood by those skilled in the art that modes and details thereof can be modified in various ways. Therefore, the present invention is not construed as being limited to the description of the embodiments.

Note that a voltage refers to a difference between potentials of two points, and a potential refers to electrostatic energy (electric potential energy) of a unit charge at a given point in an electrostatic field. Note that in general, a difference between a potential of one point and a reference potential (such as a ground potential) is merely called a potential or a voltage, and a potential and a voltage are used as synonymous words in many cases. Thus, in this specification, a potential may be rephrased as a voltage and a voltage may be rephrased as a potential unless otherwise specified.

Note that a thin film transistor is an element having at least three terminals of a gate, a drain, and a source. The thin film transistor has a semiconductor in which a channel region is formed in a region overlapping with the gate, and current which flows between the drain and the source through the channel region can be controlled by controlling the potential of the gate. Here, since the source and the drain of the thin film transistor may interchange depending on the structure, the operating condition, and the like of the thin film transistor, it is difficult to define which is a source or a drain. Therefore, a region functioning as source or drain is not called the source or the drain in some cases. In such a case, for example, one of the source and the drain may be referred to as a first terminal and the other may be referred to as a second terminal.

[Embodiment 1]

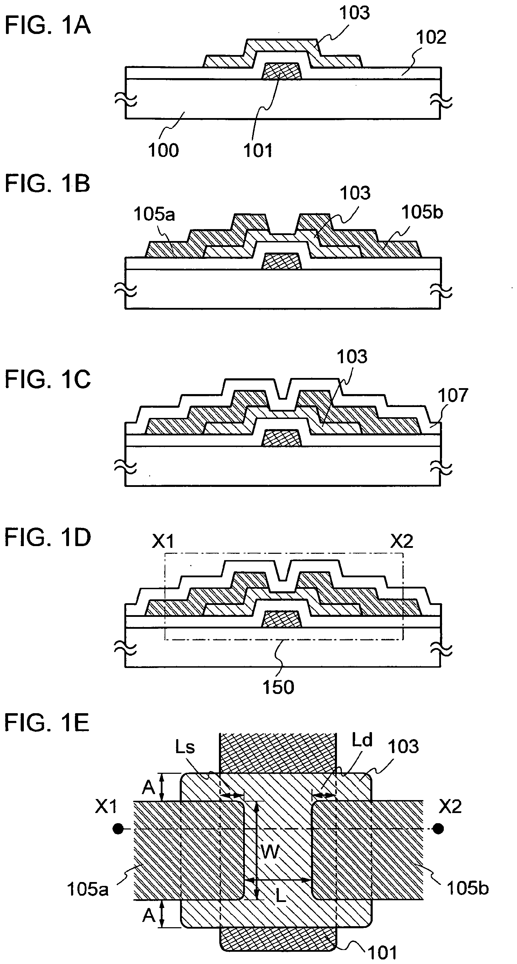

In this embodiment, an embodiment of a method for manufacturing a thin film transistor 150 illustrated in FIG. 1D will be described with reference to FIGS. 1A to 1D which are cross-sectional views illustrating a manufacturing process of a thin film transistor. FIG. IE is a top view of the thin film transistor 150 illustrated in FIG. 1D. The thin film transistor 150 is a kind of bottom-gate transistor called a channel-etched transistor and also a kind of an inverted staggered transistor.

First, over a substrate 100 which is a substrate having an insulating surface, a gate electrode layer 101 is provided through a photolithography step with the use of a photomask. Note that a resist mask may be formed by an ink-jet method. When the resist mask is formed by an ink-jet method, manufacturing costs can be reduced because a photomask is not used.

It is preferable that a glass substrate be used as the substrate 100. When the temperature of heat treatment performed later is high, a glass substrate having a strain point of greater than or equal to 730 °C is preferably used as the substrate 100. Further, as a material of the glass substrate 100, for example, a glass material such as aluminosilicate glass, aluminoborosilicate glass, or barium borosilicate glass is used. Note that by containing barium oxide (BaO) and boron oxide so that the amount of barium oxide is larger than that of boron oxide, a glass substrate that is heat-resistant and of more practical use can be obtained. Therefore, a glass substrate containing BaO and $B_2O_3$ so that the amount of BaO is larger than that of $B_2O_3$ is preferably used.

Note that the substrate 100 may be a substrate formed of an insulator such as a ceramic substrate, a quartz substrate, or a sapphire substrate instead of the above glass substrate. Alternatively, crystallized glass or the like can be used.

In addition, an insulating film serving as a base film may be provided between the substrate 100 and the gate electrode layer 101. The base film has a function of preventing diffusion of an impurity element from the substrate 100, and can be formed to have a single-layer or layered structure using one or more of a silicon nitride film, a silicon oxide film, a silicon nitride oxide film, and a silicon oxynitride film.

When the base film contains a halogen element such as chlorine or fluorine, a function of preventing diffusion of an impurity element from the substrate 100 can be further improved. The peak of the concentration of a halogen element to be contained in the base film is measured by analysis using a secondary ion mass spectrometer (SIMS) and is preferably in the range of $1 \times 10^{15}$ atoms/cm$^3$ to $1 \times 10^{20}$ atoms/cm$^3$ inclusive.

The gate electrode layer 101 can be formed using a metal conductive film. As the material of the metal conductive film, an element selected from Al, Cr, Cu, Ta, Ti, Mo, and W, an alloy containing any of these elements as a component, an alloy containing any of these elements in combination, or the like is preferably used. For example, a three-layer structure in which an aluminum layer is stacked over a titanium layer and a titanium layer is stacked over the aluminum layer, or a three-layer structure in which an aluminum layer is stacked over a molybdenum layer and a molybdenum layer is stacked over the aluminum layer is preferable. Needless to say, the metal conductive film may have a single-layer structure, a two-layer structure, or a layered structure of four or more layers.

Then, a gate insulating layer 102 is formed over the gate electrode layer 101.

The gate insulating layer 102 can be formed to have a single layer structure or a layered structure using one or more of a silicon oxide layer, a silicon nitride layer, a silicon oxynitride layer, and a silicon nitride oxide layer by a plasma CVD method, a sputtering method, or the like. For example, a silicon oxynitride layer may be formed by a plasma CVD method using $SiH_4$, oxygen, and nitrogen as a deposition gas. The thickness of the gate insulating layer 102 is set to 100 nm to 500 nm inclusive. In the case of a layered structure, for example, a layered structure of a first gate insulating layer with a thickness of 50 nm to 200 nm inclusive and a second gate insulating layer with a thickness of 5 nm to 300 nm inclusive over the first gate insulating layer is employed.

Before the formation of an oxide semiconductor film, heat treatment (at greater than or equal to 400 °C and less than the strain point of the substrate) may be performed in an inert gas atmosphere (such as a nitrogen atmosphere, a helium atmosphere, a neon atmosphere, or an argon atmosphere), to remove an impurity such as hydrogen or water contained in the gate insulating layer 102.

An oxide semiconductor film with a thickness of 5 nm to 200 nm inclusive, preferably 10 nm to 50 nm inclusive is formed over the gate insulating layer 102. The preferable thickness of the oxide semiconductor film is less than or equal to 50 nm, so that the oxide semiconductor film can have an amorphous structure even when heat treatment for dehydration or dehydrogenation is performed after the formation of the oxide semiconductor film. With the small thickness of the oxide semiconductor film, crystallization can be suppressed when the heat treatment follows the formation of the oxide semiconductor film.

Note that before the oxide semiconductor film is formed by a sputtering method, dust attached to a surface of the gate insulating layer 102 is preferably removed by reverse sputtering in which an argon gas is introduced and plasma is generated. The reverse sputtering refers to a method in which, without application of a voltage to a target side, an RF power source is used for application of a voltage to a substrate side in an argon atmosphere to generate plasma in the vicinity of the substrate and modify a surface. Note that instead of an argon atmosphere, a nitrogen atmosphere, a helium atmosphere, or the like may be used.

The oxide semiconductor film is formed using an In-Ga-Zn-O-based non-single-crystal film, an In-Sn-Zn-O-based oxide semiconductor film, an In-Al-Zn-O-based oxide semiconductor film, a Sn-Ga-Zn-O-based oxide semiconductor film, an Al-Ga-Zn-O-based oxide semiconductor film, a Sn-Al-Zn-O-based oxide semiconductor film, an In-Zn-O-based oxide semiconductor film, a Sn-Zn-O-based oxide semiconductor film, an Al-Zn-O-based oxide semiconductor film, an In-Ga-O-based oxide semiconductor film, an In-O-based oxide semiconductor film, a Sn-O-based oxide semiconductor film, or a Zn-O-based oxide semiconductor film. In this embodiment, for example, the oxide semiconductor film is formed by a sputtering method with the use of an In-Ga-Zn-O-based oxide semiconductor target. In addition, the oxide semiconductor film can be formed by a sputtering method in a rare gas (typically argon) atmosphere, an oxygen atmosphere, or an atmosphere containing a rare gas (typically argon) and oxygen. In the case of using a sputtering method, deposition is performed with the use of a target containing $SiO_2$ at 2 wt.% to 10 wt.% inclusive, so that $SiO_x$ (x > 0) which hinders crystallization is contained in the oxide semiconductor film. Thus, the oxide semiconductor film can be prevented from being crystallized in heat treatment for dehydration or dehydrogenation performed later. Note that it is preferable to use a pulsed direct-current (DC) power source as a power source, with which dusts can be reduced and a thickness distribution can be evened.

The relative density of the oxide semiconductor in the oxide semiconductor target is preferably greater than or equal to 99%, which results in a reduction of the impurity concentration in the formed oxide semiconductor film; thus, a thin film transistor having high electric characteristics or reliability can be obtained. In this embodiment, an oxide semiconductor target in which the relative density of an oxide semiconductor is 97% is used.

Examples of a sputtering method include an RF sputtering method in which a high-frequency power source is used as a sputtering power source, a DC sputtering method, and a pulsed DC sputtering method in which a bias is applied in a pulsed manner. An RF sputtering method is mainly used in the case where an insulating film is formed, and a DC sputtering method is mainly used in the case where a metal film is formed.

In addition, there is also a multi-source sputtering apparatus in which a plurality of targets of different materials can be set. With the multi-source sputtering apparatus, films of different materials can be deposited to be stacked in the same chamber, or a film of plural kinds of materials can be deposited by electric discharge at the same time in the same chamber.

In addition, there are a sputtering apparatus provided with a magnet system inside the chamber and used for a magnetron sputtering method, and a sputtering apparatus used for an ECR sputtering method in which plasma generated with the use of microwaves is used without using glow discharge.

Furthermore, as a deposition method using a sputtering method, there are also a reactive sputtering method in which a target substance and a sputtering gas component are chemically reacted with each other during deposition to form a thin compound film thereof, and a bias sputtering method in which a voltage is also applied to a substrate during deposition.

The gate insulating layer 102 and the oxide semiconductor film may be formed successively without being exposed to the air. Film formation without exposure to the air makes it possible to obtain an interface between the stacked layers, which is not contaminated with atmospheric components or impurity elements contained in the air, such as water or hydrocarbon. Therefore, variation in characteristics of the thin film transistor can be reduced.

The oxide semiconductor film is then processed into an island-like oxide semiconductor layer 103 through a photolithography step (see FIG 1A). A resist mask for forming the island-like oxide semiconductor layer 103 may be formed by an ink-jet method. When the resist mask is formed by an ink-jet method, manufacturing costs can be reduced because a photomask is not used.

Next, first heat treatment is performed, so that the oxide semiconductor layer 103 is dehydrated or dehydrogenated. The temperature of the first heat treatment for dehydration or dehydrogenation is greater than or equal to 350 °C and less than 750 °C, preferably greater than or equal to 425 °C. Note that the heat treatment may be performed for one hour or shorter when the temperature is greater than or equal to 425 °C, and the heat treatment is preferably performed for longer than one hour when the temperature is less than 425 °C. For example, the substrate is put in an electric furnace, which is a kind of heat treatment apparatus, and heat treatment is performed on the oxide semiconductor layer in a nitrogen atmosphere. Then, the oxide semiconductor layer is not exposed to the air, which prevents entry of water or hydrogen into the oxide semiconductor layer, so that the oxide semiconductor layer 103 can be obtained. In this embodiment, slow cooling is performed from a heating temperature T at which the oxide semiconductor layer 103 is dehydrated or dehydrogenated to a temperature low enough to prevent entry of water, specifically to a temperature lower than the heating temperature T by 100 °C or more, in a nitrogen atmosphere in one furnace. Without limitation to a nitrogen atmosphere, dehydration or dehydrogenation is performed in an atmosphere of helium, neon, argon, or the like.

Through the first heat treatment, rearrangement at the atomic level is caused in the oxide semiconductor included in the oxide semiconductor layer 103. The first heat treatment is important because it enables release of distortion which interrupts transfer of carriers in the oxide semiconductor layer 103.

Note that in the first heat treatment, it is preferable that water, hydrogen, or the like be not contained in nitrogen or a rare gas such as helium, neon, or argon. Alternatively, it is preferable that nitrogen or a rare gas such as helium, neon, or argon introduced into a heat treatment apparatus have a purity of greater than or equal to 6N (99.9999%), preferably greater than or equal to 7N (99.99999%); that is, the impurity concentration is set to less than or equal to 1 ppm, preferably less than or equal to 0.1 ppm.

The heat treatment apparatus for the first heat treatment is not limited to an electric furnace and may have a device for heating an object to be processed by thermal conduction or thermal radiation from a heating element such as a resistance heating element. For example, a rapid thermal annealing (RTA) apparatus such as a gas rapid thermal annealing (GRTA) apparatus or a lamp rapid thermal annealing (LRTA) apparatus can be used. An LRTA apparatus is an apparatus for heating an object to be processed by radiation of light (an electromagnetic wave) emitted from a lamp such as a halogen lamp, a metal halide lamp, a xenon arc lamp, a carbon arc lamp, a high pressure sodium lamp, or a high pressure mercury lamp. A GRTA apparatus is an apparatus for performing heat treatment using a high-temperature gas. As the gas, an inert gas which does not react with an object to be processed by heat treatment, such as nitrogen or a rare gas such as argon is used.

Depending on conditions of the first heat treatment or a material of the oxide semiconductor layer, the oxide semiconductor layer is crystallized and changed to a microcrystalline film or a polycrystalline film in some cases. The oxide semiconductor layer becomes a microcrystalline film whose degree of crystallinity is greater than or equal to 80% or greater than or equal to 90% in some cases. Further, depending on the material, the oxide semiconductor layer does not have a crystal in some cases.

The first heat treatment for the oxide semiconductor film can be performed on the oxide semiconductor film before being processed into the island-like oxide semiconductor layer 103. In that case, after the first heat treatment, the substrate is taken out of the heating apparatus and subjected to a photolithography step.

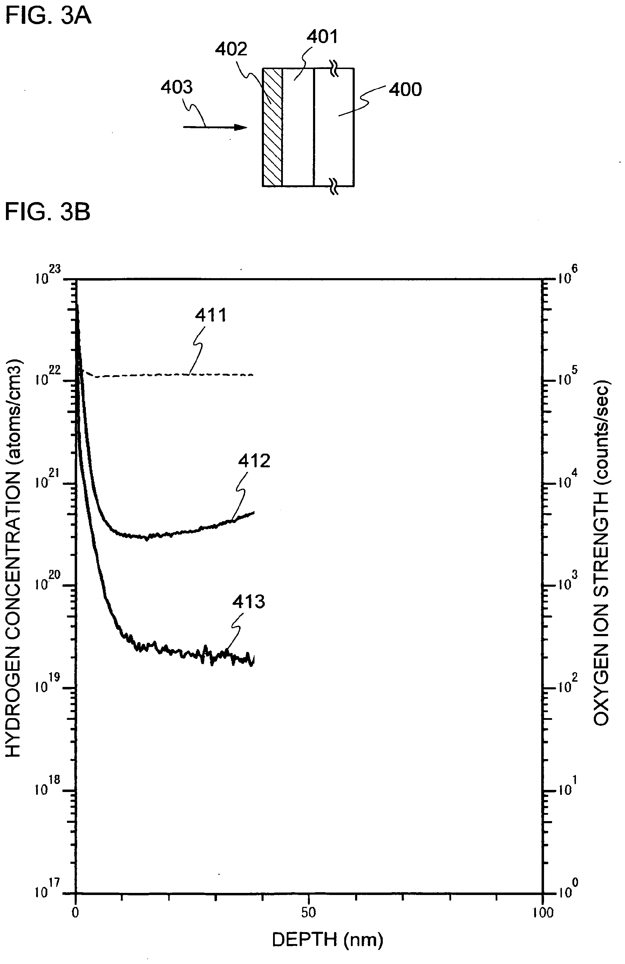

Here, results of analyzing the hydrogen concentration in an oxide semiconductor layer which has been dehydrogenated and the hydrogen concentration in an oxide semiconductor layer which has not been dehydrogenated are described. FIG. 3A is a schematic cross-sectional structural view of a sample used in the analysis. An oxynitride insulating layer 401 was formed over a glass substrate 400 by a plasma CVD method, and an In-Ga-Zn-O-based oxide semiconductor layer 402 was formed to a thickness of about 40 nm over the oxynitride insulating layer 401. This sample was divided into two samples; one was not dehydrogenated and the other was dehydrogenated by a GRTA method at 650 °C for six minutes in a nitrogen atmosphere. The effect of dehydrogenation by heat treatment was examined, by measuring the hydrogen concentration in the oxide semiconductor layer of each sample.

The hydrogen concentration in the oxide semiconductor layer was measured by secondary ion mass spectrometry (SIMS). FIG 3B is a graph of a SIMS analysis result showing a distribution of the hydrogen concentration in the thickness direction of the oxide semiconductor layer. A horizontal axis indicates a depth from a surface of the sample, and a left end where the depth is 0 nm corresponds to the outermost surface of the sample (outermost surface of the oxide semiconductor layer). An analysis direction 403 in FIG 3A shows the direction in which the SIMS analysis was performed. The analysis was performed in the direction from the outermost surface of the oxide semiconductor layer toward the glass substrate 400. That is, the analysis was performed in the direction from the left end of the horizontal axis of FIG 3B to the right end thereof. Vertical axes of FIG. 3B are logarithmic axes representing hydrogen concentration and ionic strength of oxygen at a certain depth of the sample.

In FIG. 3B, a hydrogen concentration profile 412 is a hydrogen concentration profile in the oxide semiconductor layer which was not dehydrogenated, and a hydrogen concentration profile 413 is a hydrogen concentration profile in the oxide semiconductor layer which was dehydrogenated by heat treatment. An oxygen ionic strength profile 411 shows the ionic strength of oxygen which was obtained in measurement of the hydrogen concentration profile 412. The oxygen ionic strength profile 411 was not drastically changed and substantially constant, which means that SIMS analysis was performed with precision. Although not shown, the ionic strength of oxygen was also measured when the hydrogen concentration profile 413 was measured, which was also substantially constant. The hydrogen concentration profile 412 and the hydrogen concentration profile 413 are quantified using a reference sample formed with the use of an In-Ga-Zn-O-based oxide semiconductor layer similarly to the samples.

It is known that, in the SIMS analysis, it is difficult to obtain accurate data in the vicinity of a surface of a sample or in the vicinity of an interface between stacked films formed using different materials due to its principle. In this analysis, since it is probable that data in a region from the outermost surface to a depth of about 15 nm in the sample was not accurate, the profile in a region whose depth was more than 15 nm was evaluated.

It is found from the hydrogen concentration profile 412 that hydrogen is contained in the oxide semiconductor layer which was not dehydrogenated at approximately greater than or equal to $3 \times 10^{20}$ atoms/cm$^3$ and less than or equal to $5 \times 10^{20}$ atoms/cm$^3$ and the average hydrogen concentration is approximately $4 \times 10^{20}$ atoms/cm$^3$. It is found from the hydrogen concentration profile 413 that the average hydrogen concentration in the oxide semiconductor layer can be reduced to approximately $2 \times 10^{19}$ atoms/cm$^3$ by dehydrogenation.

This analysis shows that dehydrogenation performed by heat treatment can reduce the hydrogen concentration in the oxide semiconductor layer and that dehydrogenation performed by a GRTA method at 650 °C for six minutes in a nitrogen atmosphere can reduce the hydrogen concentration in the oxide semiconductor layer to one tenth or less.

Next, a conductive film for forming a source electrode layer and a drain electrode layer is formed over the gate insulating layer 102 and the oxide semiconductor layer 103.

The conductive film for forming a source electrode layer and a drain electrode layer can be formed using a metal conductive film, in a manner similar to that of the gate electrode layer 101. As the material of the metal conductive film, an element selected from Al, Cr, Cu, Ta, Ti, Mo, and W; an alloy containing any of these elements as a component;

an alloy containing any of these elements in combination; or the like is preferably used. For example, a three-layer structure in which an aluminum layer is stacked over a titanium layer and a titanium layer is stacked over the aluminum layer, or a three-layer structure in which an aluminum layer is stacked over a molybdenum layer and a molybdenum layer is stacked over the aluminum layer is preferable. Needless to say, the metal conductive film may have a single-layer structure, a two-layer structure, or a layered structure of four or more layers.

The conductive film for forming a source electrode layer and a drain electrode layer is subjected to a photolithography step using a photomask, so that a source electrode layer 105a and a drain electrode layer 105b are formed (see FIG 1B). In addition, part of the oxide semiconductor layer 103 is also etched at this time, so that the oxide semiconductor layer 103 has a groove (a depression portion).

A resist mask used for forming the source electrode layer 105a and the drain electrode layer 105b may be formed by an ink-jet method. When the resist mask is formed by an ink-jet method, manufacturing costs can be reduced because a photomask is not used.

In addition, an oxide conductive layer which has lower resistance than the oxide semiconductor layer 103 may be formed between the oxide semiconductor layer 103 and the source electrode layer 105a and/or the drain electrode layer 105b. Such a layered structure can improve the withstand voltage of the thin film transistor. Specifically, the carrier concentration in the oxide conductive layer with low resistance is preferably in the range of $1 \times 10^{20}/cm^3$ to $1 \times 10^{21}/cm^3$ inclusive.

Next, a protective insulating layer 107 which covers the gate insulating layer 102, the oxide semiconductor layer 103, the source electrode layer 105a, and the drain electrode layer 105b and which is in contact with part of the oxide semiconductor layer 103 is formed (see FIG. 1C). The protective insulating layer 107 can be formed to a thickness of at least 1 nm using a method by which an impurity such as water or hydrogen is prevented from entering the protective insulating layer 107, such as a CVD method or a sputtering method, as appropriate. Here, the protective insulating layer 107 is formed by a sputtering method. The protective insulating layer 107 which is formed in contact with part of the oxide semiconductor layer 103 does not contain an impurity such as moisture, a hydrogen ion, or OH$^-$, and is formed using an inorganic insulating film which blocks entry thereof from the outside. Specifically, a silicon oxide film, a silicon nitride oxide film, a silicon nitride film, an aluminum oxide film, an aluminum oxynitride film, or an aluminum nitride film can be used.

Alternatively, the protective insulating layer 107 may have such a structure that a silicon nitride film or an aluminum nitride film is stacked over a silicon oxide film, a silicon nitride oxide film, an aluminum oxide film, or an aluminum oxynitride film. The silicon nitride film is preferable because it does not contain an impurity such as moisture, a hydrogen ion, or OH$^-$ and effectively blocks entry of the impurity from the outside.

The substrate temperature at the time of deposition of the protective insulating layer 107 may be in the range of room temperature to 300 °C inclusive. The formation of the silicon oxide film by a sputtering method can be performed in a rare gas (typically, argon) atmosphere, an oxygen atmosphere, or an atmosphere containing a rare gas (typically, argon) and oxygen. As a target, a silicon oxide target or a silicon target can be used. For example, with the use of a silicon target, a silicon oxide film can be formed by a sputtering method in an atmosphere containing oxygen and nitrogen.

Then, second heat treatment is performed. The second heat treatment is performed at a temperature of greater than or equal to 100 °C and less than or equal to the temperature of the first heat treatment. For example, the substrate is put in an electric furnace which is a kind of heat treatment apparatus and heat treatment is performed in a nitrogen atmosphere. The second heat treatment may be performed at any time as long as it is performed after the formation of the protective insulating layer 107.

Through the above-described process, the channel-etched thin film transistor 150 having the following structure can be formed: the gate electrode layer 101 is provided over the substrate 100 that is a substrate having an insulating surface, the gate insulating layer 102 is provided over the gate electrode layer 101, the oxide semiconductor layer 103 is provided over the gate insulating layer 102, the source and drain electrode layers 105a and 105b are provided over the oxide semiconductor layer 103, and the protective insulating layer 107 which is in contact with part of the oxide semiconductor layer 103 and covers the gate insulating layer 102, the oxide semiconductor layer 103, and the source and drain electrode layers 105a and 105b is provided (see FIG 1D).

FIG IE is a top view of the thin film transistor 150 described in this embodiment. FIG 1D illustrates a cross-sectional structure taken along line X1-X2 in FIG IE. In FIG IE, *L* represents the channel length and *W* represents the channel width. In addition, *A* represents the length of a region where the oxide semiconductor layer 103 does not overlap with the source electrode layer 105a or the drain electrode layer 105b in a direction parallel with a channel width direction. *Ls* represents the length of part of the source electrode layer 105a which overlaps with the gate electrode layer 101, and *Ld* represents the length of part of the drain electrode layer 105b which overlaps with the gate electrode layer 101.

In this embodiment, although a thin film transistor having a single-gate structure has been described as the thin film transistor 150, a thin film transistor having a multi-gate structure which includes a plurality of channel formation regions or a thin film transistor having a structure in which a second gate electrode layer is provided over the protective insulating layer 107 can be formed as needed.

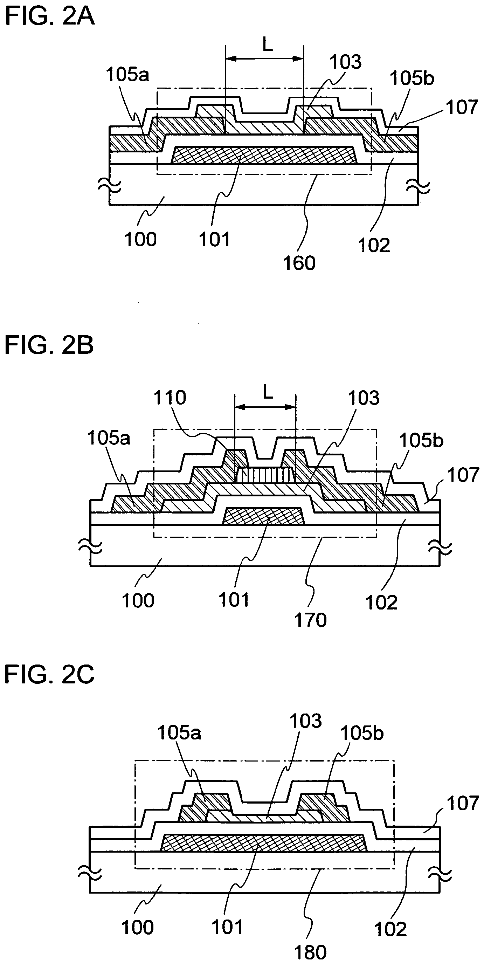

A manufacturing method of the channel-etched thin film transistor 150 has been described in this embodiment; however, the structure of this embodiment is not limited thereto. A bottom-gate bottom-contact (inverted-coplanar) thin film transistor 160 illustrated in FIG 2A, a channel-protective (channel-stop) thin film transistor 170 including a channel protective layer 110 illustrated in FIG. 2B, and the like can be formed using a material and a method which are similar to those of the thin film transistor 150. FIG. 2C illustrates another example of the channel-etched thin film transistor. A thin film transistor 180 illustrated in FIG 2C has a structure in which the end portion of the gate electrode layer 101 extends beyond an end portion of the oxide semiconductor layer 103.

Note that the channel length $L$ ($L$ in FIG. IE) of the thin film transistor 150 is defined as a distance between the source electrode layer 105a and the drain electrode layer 105b, and the channel length of the channel protective thin film transistor 170 is defined as the width of the channel protective layer in a direction parallel with a carrier flow direction.

In accordance with this embodiment, a thin film transistor including an oxide semiconductor layer can be formed in which the threshold voltage at which a channel is formed is as close to 0 V as possible.

In addition, when the channel length of the thin film transistor is 3 $\mu$m to 10 $\mu$m inclusive or 1.5 $\mu$m to 100 $\mu$m inclusive, the amount of change in threshold voltage of the thin film transistor can be less than or equal to 3 V, specifically, less than or equal to 1.5 V in the operation temperature range of room temperature to 180 °C inclusive.

Furthermore, the amount of change in threshold voltage of the thin film transistor can be less than or equal to 3 V, specifically, less than or equal to 1.5 V in the operation temperature range of -25 °C to 150 °C inclusive.

This embodiment can be implemented in appropriate combination with the structures described in other embodiments.

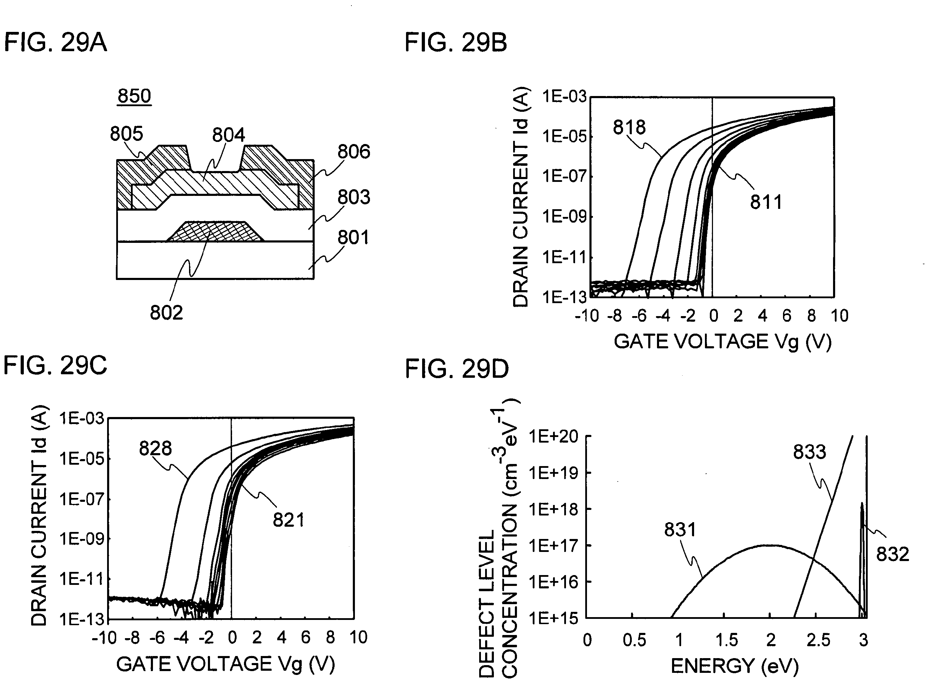

Now, evaluation results and two-dimensional device simulation of the characteristics of a thin film transistor in environments at room temperature to 180°C inclusive are described. A thin film transistor having a layered structure illustrated in FIG. 29A is used for the above. FIG. 29A illustrates a cross-sectional structure of a thin film transistor 850.

A tungsten layer was formed to a thickness of 100 nm as a gate electrode layer 802 over a glass substrate 801, an oxynitride layer was formed to a thickness of 100 nm as a gate insulating layer 803 over the gate electrode layer 802, an In-Ga-Zn-O-based oxide semiconductor layer 804 was formed to a thickness of 50 nm over the gate insulating layer 803, and titanium layers were formed as a source electrode layer 805 and a drain electrode layer 806 over the oxide semiconductor layer 804. The thin film transistor 850 was manufactured in this manner. Note that the channel length $L$ of the thin film transistor 850 was 10 $\mu$m and the channel width $W$ was 100 $\mu$m.

Then, current vs. voltage characteristics of the thin film transistor 850 were measured while changing the substrate temperature (operation temperature) in measurement as follows; room temperature (25 °C), 40 °C, 60 °C, 85 °C, 100 °C, 120 °C, 140 °C, 160 °C and 180 °C. The current vs. voltage characteristics were measured by setting a voltage between a source and a drain (hereinafter referred to as drain voltage or Vd) to 10 V and by changing a voltage between the source and a gate (hereinafter referred to as gate voltage or Vg) from -10 V to 10 V. In such a manner, a Vg-Id curve of the thin film transistor, which shows a change in drain current with respect to a change in gate voltage, was obtained.

FIG. 29B shows Vg-Id curves obtained in this measurement. In FIG. 29B, a curve 811 is a Vg-Id curve when the substrate temperature in measurement is room temperature (25 °C). As the substrate temperature in measurement is increased, the Vg-Id curve sequentially shifts in a left direction in FIG 29B, that is, a negative direction of Vg. Although not all the Vg-Id curves are denoted by reference numerals, the leftmost curve 818 is a Vg-Id curve when the substrate temperature is 180 °C. According to FIG. 29B, it is found that the threshold voltage is changed by 5 V or more when the threshold voltage at room temperature (25 °C) and the threshold voltage at 180 °C are compared.

Assuming that the change in threshold voltage shown in FIG 29B was caused by excitation of electrons due to the temperature, the change was reproduced by two-dimensional device simulation. The simulation was performed with a device simulator "ATLAS" produced by Silvaco Data Systems Inc. The band gap (Eg) of the oxide semiconductor layer and electron mobility ($\mu$n) were assumed to be 3.05 eV and 15 cm$^2$/Vs, and a bottom gate TFT with the same structure as the thin film transistor 850 was used for the simulation: current vs. voltage characteristics were calculated under this condition.

FIG 29C shows Vg-Id curves which were reproduced by the simulation. A curve 821 is a Vg-Id curve for room temperature (25 °C) and a curve 828 is a Vg-Id curve for 180 °C. The actual measured values in FIG 29B were well reproduced in FIG 29C.

FIG 29D shows state densities in the oxide semiconductor layer, which were obtained by the simulation results. The horizontal axis represents the band gap of the oxide semiconductor, and the vertical axis represents a state density. In FIG 29D, a curve 831 and a curve 832 show distributions of donor level densities in the band gap, and a curve 833 shows a distribution of acceptor level densities in the band gap.

The curve 831 shows that the donor level densities are widely distributed from the conduction band to a deep part of the band gap, and the curve 832 shows that the donor level densities are distributed in a very narrow range in the vicinity of the conduction band and have a very sharp peak. The curve 831 could be derived from oxygen deficiency and the curve 832 could be derived from hydrogen.

Then, a sample different from that obtained in FIG 29B was manufactured and a change in characteristics of the thin film transistor was measured in the environments at 0 °C to 150 °C inclsulvie. On the basis of the measured result, the temperature dependence of the threshold voltage was examined as follows.

The sample was manufactured by forming a silicon oxide film with a thickness of 300 nm by a sputtering method so as to cover a thin film transistor having the layered structure illustrated in FIG 29A, and current vs. voltage characteristics of the sample were measured. Note that the channel length $L$ of the thin film transistor was 3 $\mu$m and the channel width $W$ was 50 $\mu$m.

Then, current vs. voltage characteristics of the thin film transistor were measured while changing the substrate temperature (operation temperature) in measurement as follows; 0 °C, room temperature (25 °C), 50 °C, 100 °C, and 150 °C. The current vs. voltage characteristics were measured by setting drain voltage Vd to 10 V and by changing gate voltage Vg from -20 V to 20 V. In such a manner, a Vg-Id curve of the thin film transistor, which shows a change in drain current Id with respect to a change in gate voltage Vg, was obtained.

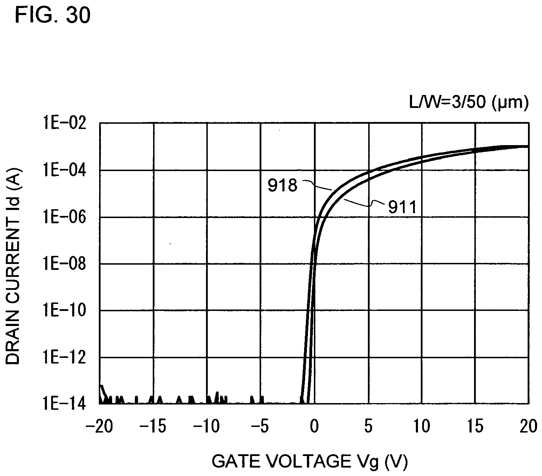

FIG 30 shows Vg-Id curves obtained in this measurement. In FIG 30, a curve 911 is a Vg-Id curve when the substrate temperature in measurement is 0 °C. As the substrate temperature in measurement is increased, the Vg-Id curve shifts in a left direction in FIG 30, that is, a negative direction of Vg. A thus obtained curve 918 positioned on the left side is a Vg-Id curve when the substrate temperature is 150 °C.

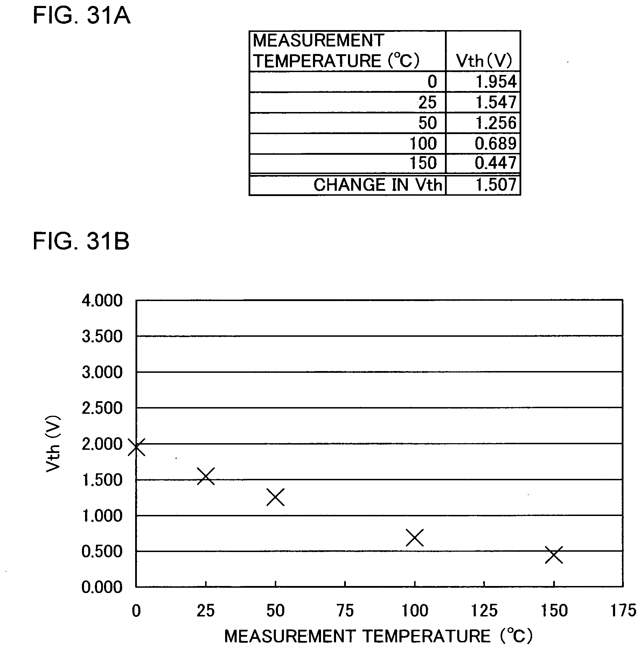

FIG. 31A is a table which shows Vth (threshold voltage) obtained from the Vg-Id curves. In FIG 31A, the amount of change in Vth in the bottom cell is a difference between Vth at 0 °C and Vth at 150 °C.

FIG 31B is a graph based on FIG 31A. The measurement temperature on the horizontal axis is a substrate temperature (operation temperature) in measuring current vs. voltage characteristics of the thin film transistor, and Vth on the vertical axis is the threshold voltage at each substrate temperature.

According to FIG. 31A, it is found that the amount of change in threshold voltage can be as small as about 1.5 V when Vth at 0 °C and Vth at 150 °C are compared.

The temperature dependence of the threshold voltage (Vth) is examined as follows.

A Fermi level comes close to an intrinsic Fermi level as the temperature becomes higher. An inverted threshold voltage is represented as a function of a Fermi potential as shown in Equation (1). A Fermi potential is defined as a difference between the intrinsic Fermi level and the Fermi level (Equation 2). That is, when a semiconductor which is likely to be n-type or p-type is used for a channel, the threshold voltage depends on the temperature.

[Equation 1]

$$V_{th} \quad = \quad V_{FB} + 2\phi_F + \frac{\sqrt{2K\varepsilon_0 q N_A (2\phi_F)}}{C_{OX}}$$

[Equation 2]

$$\phi_F \quad = \quad \frac{E_i - E_F}{q}$$

For example, in an n-type Si transistor in which a p-type semiconductor is used for a channel, $\phi_F$ comes close to zero when the temperature becomes higher, so that the threshold voltage negatively shifts. Note that when the channel is i-type (intrinsic), the threshold voltage does not shift.

In the thin film transistor having the measured results shown in FIG 30, the threshold voltage negatively shifts when the substrate temperature is raised. In general, an oxide semiconductor is unlikely to be p-type and likely to be n-type. When an oxide semiconductor used for forming the channel is assumed to be n-type, the Fermi level is changed reversely (the threshold voltage should shift positively when the channel is n-type). Therefore, a mechanism which is different from the Fermi level needs to be figured out as the cause of the change in threshold voltage of the oxide semiconductor.

The above discussion is an approximate solution assumed in an ideal single crystal semiconductor, and a crystal defect or temperature dependence due to various levels should be taken into account. In a Vg-Id curve showing the temperature dependence of the oxide semiconductor, the amount of current increases remarkably in a threshold region. In general, a defect is frequently assumed as a mechanism which controls the amount of current in that region. In particular, in the case of an oxide semiconductor having an amorphous state, a defect level is generally expressed as a function having a distribution.

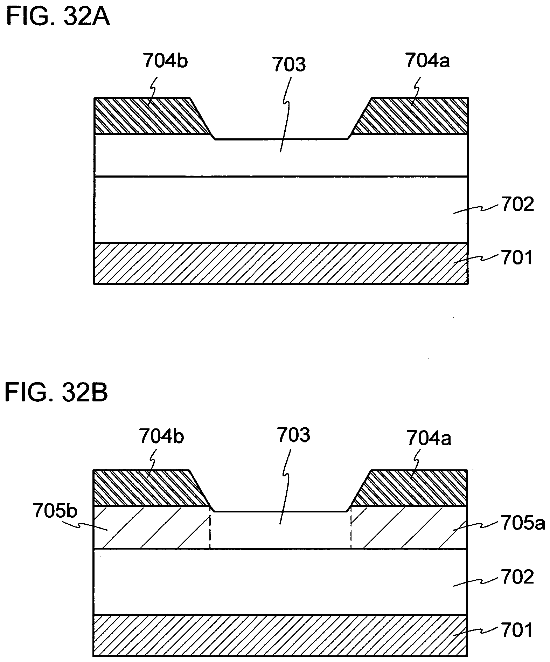

The temperature dependence of Vth of the thin film transistor whose channel is formed using an oxide semiconductor was reproduced by calculation. FIGS. 32A and 32B each illustrate a structure used in the calculation. An inverted staggered thin film transistor which includes a 100-nm-thick gate insulating layer 702 formed using a silicon oxynitride film and a 30-nm-thick channel 703 formed using an oxide semiconductor over a gate electrode layer 701 was used in the calculation. In the thin film transistor, the channel length $L$ was 3 $\mu$m and the channel width $W$ was 20 $\mu$m ($L/W$ = 3/20 $\mu$m). Two kinds of TFTs were assumed: a TFT with a structure in FIG 32A in which not only the channel 703 but also the entire oxide semiconductor layer is i-type and a TFT with a structure in FIG. 32B which includes the i-type channel 703 and N$^+$ regions 705a and 705b below source and drain electrode layers 704a and 704b. In the structure of FIG. 32B, the concentration of a donor (Nd) was assumed to be $1 \times 10^{19}$ /cm$^3$ in the N$^+$ regions 705a and 705b. The band gap Eg of the oxide semiconductor was set to be 3.15 eV, electron affinity $\chi$ was set to be 4.3 eV, and a dielectric constant was set to be 15. Further, the work function of a metal used for the source and drain electrode layers 704b and 704a was set to be 4.3 eV which was the same as the electron affinity of the oxide semiconductor.

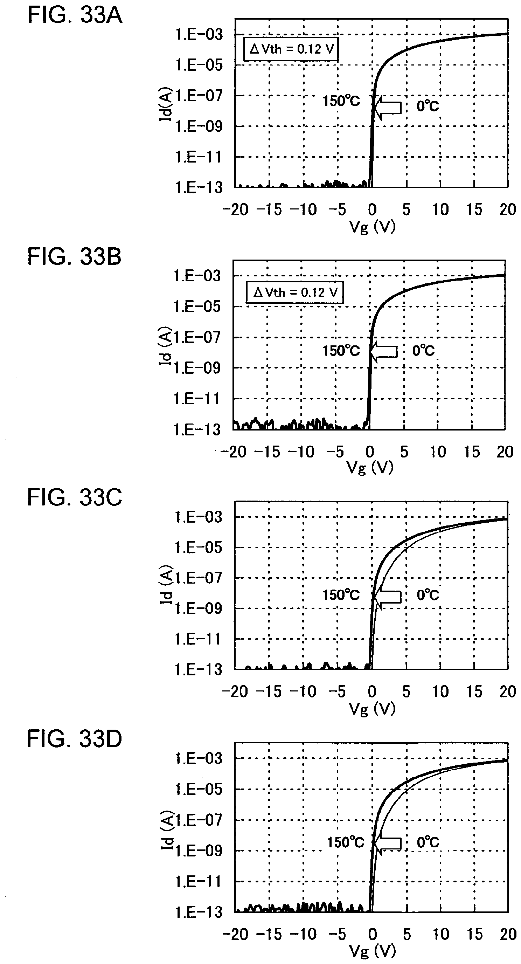

In addition, it was supposed that a defect level greatly influences the temperature dependence of an amorphous semiconductor, and the distribution of acceptor level densities in the band gap, which was the curve 833 in FIG 29D, was assumed in the calculation. The calculation results are shown in FIGS. 33A to 33D. FIGS. 33A to 33D show the results of performing calculation on the structure of FIG. 32A and the structure of FIG 32B in the case where the distribution of the acceptor level densities was assumed and in the case where it was not assumed. Further, in FIGS. 33A to 33D, Vg-Id curves obtained by increasing the temperature from 0 °C to 150 °C and a change in Vth ($\Delta$Vth) due to the increase are shown. FIG 33A shows the calculation results in the case where the distribution of the acceptor level densities was not assumed in the structure of FIG. 32A. FIG 33B shows the calculation results in the case where the distribution of the acceptor level densities was not assumed in the structure of FIG. 32B. FIG. 33C shows the calculation results in the case where the distribution of the acceptor level densities was assumed in the structure of FIG 32A. FIG 33D shows the calculation results in the case where the distribution of the acceptor level densities was assumed in the structure of FIG. 32B.

When the distribution of the acceptor level densities in the band gap was not assumed, that is, according to the results in FIGS. 33A and 33B, the change in Vth due to the temperature change was about 0.1 V both in the structure of FIG 32A and the structure of FIG. 32B. In accordance with Fermi-Dirac statistics, intrinsic carrier concentration is increased by about 11 digits when the temperature is increased from 0 °C to 150 °C. The increase in intrinsic carrier concentration (ni) increases carriers (electrons) in accordance with Equation (3).

[Equation 3]

$$n = n_i \exp\left[\frac{E_F - E_i}{kT}\right]$$

Consequently, only low gate voltage is needed for inducing carriers in a channel, and Vth shifts negatively. The amount of the shift corresponds to 0.1 V

When the distribution of the acceptor level densities in the band gap was assumed, that is, according to the results in FIGS. 33C and 33D, $\Delta$Vth was increased and values close to actual measured results were obtained in the calculation both in the structure of FIG. 32A and the structure of FIG. 32B. Even when the oxide semiconductor was assumed to be intrinsic, the temperature dependence could be observed when the distribution of the acceptor level densities existed in the band gap.

By assuming the distribution of the acceptor level densities in the band gap, carriers (electrons) were trapped but the trapped carriers were released by increasing the temperature; thus, the carrier concentration in the channel was increased and Vth shifted negatively. Although the oxide semiconductor is substantially intrinsic, the distribution of the acceptor level densities probably causes the temperature dependence of Vth.

When the results of the structure of FIG. 32A were compared with the results of the structure of FIG. 32B, there was no difference therebetween. Since the channel length L of the TFT used in the calculation is 3 $\mu$m, there is less influence by the N$^+$ region.

[Embodiment 2]

In this embodiment, an example will be described below in which at least part of a driver circuit and a thin film transistor arranged in a pixel portion are formed over one substrate.

The thin film transistor arranged in the pixel portion is formed in accordance with Embodiment 1. The thin film transistor described in Embodiment 1 is an n-channel TFT, and thus, part of a driver circuit that can include an n-channel TFT among driver circuits is formed over the same substrate as the thin film transistor of the pixel portion.

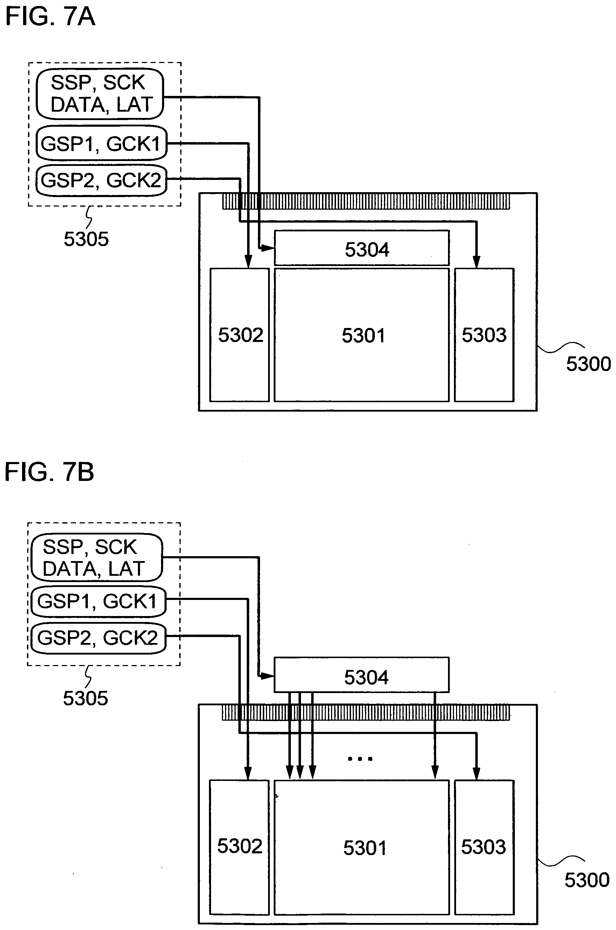

FIG 7A illustrates an example of a block diagram of an active matrix display device. Over a substrate 5300 in the display device, a pixel portion 5301, a first scan line driver circuit 5302, a second scan line driver circuit 5303, and a signal line driver circuit 5304 are provided. In the pixel portion 5301, a plurality of signal lines extended from the signal line driver circuit 5304 are arranged and a plurality of scan lines extended from the first scan line driver circuit 5302 and the second scan line driver circuit 5303 are arranged. Note that pixels each of which includes a display element are provided in a matrix in regions where the scan lines and the signal lines intersect with each other. Further, the substrate 5300 in the display device is connected to a timing control circuit 5305 (also referred to as a controller or a controller IC) through a connection portion such as a flexible printed circuit (FPC).

In FIG. 7A, the first scan line driver circuit 5302, the second scan line driver circuit 5303, and the signal line driver circuit 5304 are provided over the same substrate 5300 as the pixel portion 5301. Accordingly, the number of components such as a driver circuit which is provided outside is reduced, so that reduction in cost can be achieved. Further, if the driver circuit is provided outside the substrate 5300, wirings would need to be extended and the number of connections of wirings would be increased, but by providing the driver circuit over the substrate 5300, the number of connections of the wirings can be reduced. Accordingly, improvement in reliability and yield can be achieved.

Note that the timing control circuit 5305 supplies, for example, a first scan line driver circuit start signal (GSP1) (a start pulse) and a scan line driver circuit clock signal (GCK1) to the first scan line driver circuit 5302. The timing control circuit 5305 supplies, for example, a second scan line driver circuit start signal (GSP2) (also referred to as a start pulse) and a scan line driver circuit clock signal (GCK2) to the second scan line driver circuit 5303. The timing control circuit 5305 supplies, for example, a signal line driver circuit start signal (SSP), a signal line driver circuit clock signal (SCK), video signal data (DATA) (also simply referred to as a video signal), and a latch signal (LAT) to the signal line driver circuit 5304. Note that a clock signal may be a plurality of clock signals whose periods are different or may be supplied together with an inverted clock signal (CKB). Note that it is possible to omit one of the first scan line drive circuit 5302 and the second scan line drive circuit 5303.

FIG 7B illustrates a structure in which circuits with lower driving frequency (e.g., the first scan line driver circuit 5302 and the second scan line driver circuit 5303) are formed over the substrate 5300 where the pixel portion 5301 is formed, and the signal line driver circuit 5304 is formed over a substrate which is different from the substrate 5300 where the pixel portion 5301 is formed. With this structure, a driver circuit formed over the substrate 5300 can be constituted by thin film transistors with lower field-effect mobility than that of a transistor formed using a single crystal semiconductor. Accordingly, an increase in size of the display device, a reduction in the number of steps, a reduction in cost, an improvement in yield, and the like can be achieved.

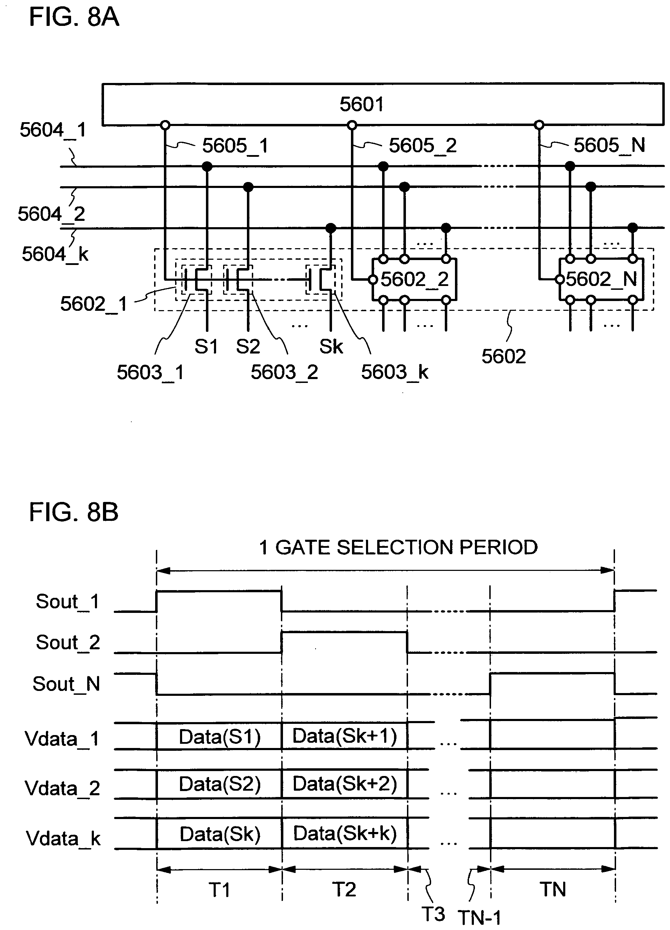

The thin film transistor described in Embodiment 1 is an n-channel TFT. With reference to FIGS. 8A and 8B, an example of a structure and an operation of a signal line driver circuit formed using an n-channel TFT is described.

The signal line driver circuit includes a shift register 5601 and a switching circuit 5602. The switching circuit 5602 includes a plurality of switching circuits 5602_1 to 5602_$N$ ($N$ is a natural number). The switching circuits 5602_1 to 5602_N each include a plurality of thin film transistors 5603_1 to 5603_$k$ ($k$ is a natural number). The case where the thin film transistors 5603_1 to 5603_$k$ are n-channel TFTs will be described.

A connection relation of the signal line driver circuit is described by using the switching circuit 5602_1 as an example. First terminals of the thin film transistors 5603_1 to 5603_$k$ are connected to wirings 5604_1 to 5604_$k$, respectively. Second terminals of the thin film transistors 5603_1 to 5603_$k$ are connected to signal lines S1 to Sk, respectively. Gates of the thin film transistors 5603_1 to 5603_$k$ are connected to a wiring 5604_1.

The shift register 5601 has a function of sequentially outputting an H level signal (also referred to as an H signal or a high power supply potential level) to the wirings 5605_1 to 5605_$N$ and sequentially selecting the switching circuits 5602_1 to 5602_$N$.

The switching circuit 5602_1 has a function of controlling electrical continuity between the wirings 5604_1 to 5604_$k$ and the signal lines S1 to Sk (electrical continuity between the first terminal and the second terminal), that is, a function of controlling whether or not to supply potentials of the wirings 5604_1 to 5604_$k$ to the signal lines S1 to Sk. As thus described, the switching circuit 5602_1 functions as a selector. Further, the thin film transistors 5603_1 to 5603_$k$ each have a function of controlling electrical continuity between the wirings 5604_1 to 5604_$k$ and their respective signal lines S1 to Sk, that is, a function of supplying potentials of the wirings 5604_1 to 5604_$k$ to their respective signal lines S1 to Sk. In this manner, each of the thin film transistors 5603_1 to 5603_$k$ functions as a switch.

Note that video signal data (DATA) is input to each of the wirings 5604_1 to 5604_$k$. The video signal data (DATA) is an analog signal corresponding to image data or an image signal in many cases.

Next, an operation of the signal line driver circuit in FIG. 8A is described with reference to a timing chart in FIG 8B. FIG 8B illustrates examples of signals Sout_1 to Sout_$N$ and signals Vdata_1 to Vdata_$k$. The signals Sout_1 to Sout_$N$ are examples of output signals of the shift register 5601, and the signals Vdata_1 to Vdata_$k$ are examples of signals which are input to the wirings 5604_1 to 5604_$k$. Note that one operation period of the signal line driver circuit corresponds to one gate selection period in a display device. For example, one gate selection period is divided into periods T1 to TN. The periods T1 to TN are periods for writing video signal data (DATA) to the pixels which belong to a selected row.

Note that signal waveform distortion and the like in each structure illustrated in drawings and the like in this embodiment are exaggerated for simplicity in some cases. Therefore, this embodiment is not necessarily limited to the scale illustrated in the drawings and the like.

In the periods T1 to TN, the shift register 5601 sequentially outputs H level signals to the wirings 5605_1 to 5605_N. For example, in the period T1, the shift register 5601 outputs a high level signal to the wiring 5605_1. Then, the thin film transistors 5603_1 to 5603_k are turned on, so that the wirings 5604_1 to 5604_k and the signal lines S1 to Sk have electrical continuity. In this case, Data (S1) to Data (Sk) are input to the wirings 5604_1 to 5604_k, respectively. The Data (S1) to Data (Sk) are input to pixels in a selected row in first to k_th columns through the thin film transistors 5603_1 to 5603_k, respectively. Thus, in the periods T1 to TN, video signal data (DATA) is sequentially written to the pixels in the selected row by k columns.

By writing video signal data (DATA) to pixels by plurality of columns, the number of video signal data (DATA) or the number of wirings can be reduced. Thus, the number of connections to an external circuit can be reduced. By writing video signals to pixels by plurality of columns, writing time can be extended and insufficient writing of video signals can be prevented.

Note that a circuit including the thin film transistor described in Embodiment 1 can be used as the shift register 5601 and the switching circuit 5602. In that case, the shift register 5601 can be constituted by only n-channel transistors or only p-channel transistors.

Described next is a structure of a scan line driver circuit. The scan line driver circuit includes a shift register. In addition, the scan line driver circuit may include a level shifter, a buffer, or the like in some cases. In the scan line driver circuit, when the clock signal (CK) and the start pulse signal (SP) are input to the shift register, a selection signal is generated. The generated selection signal is buffered and amplified by the buffer, and the resulting signal is supplied to a corresponding scan line. Gate electrodes of transistors in pixels of one line are connected to the scan line. Since the transistors in the pixels of one line have to be turned on all at once, a buffer which can supply a large current is used.

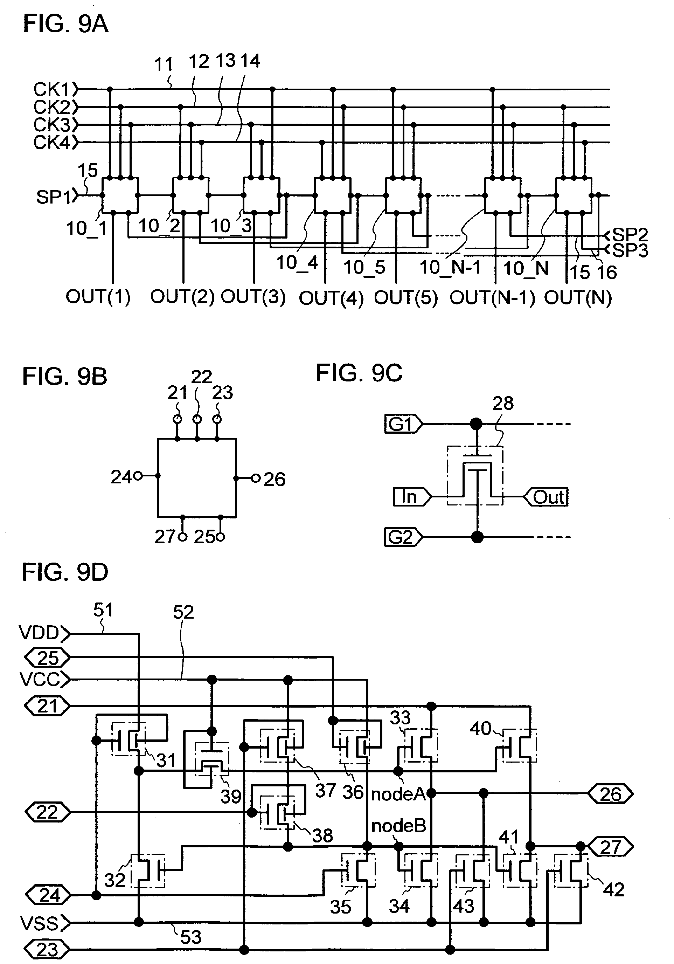

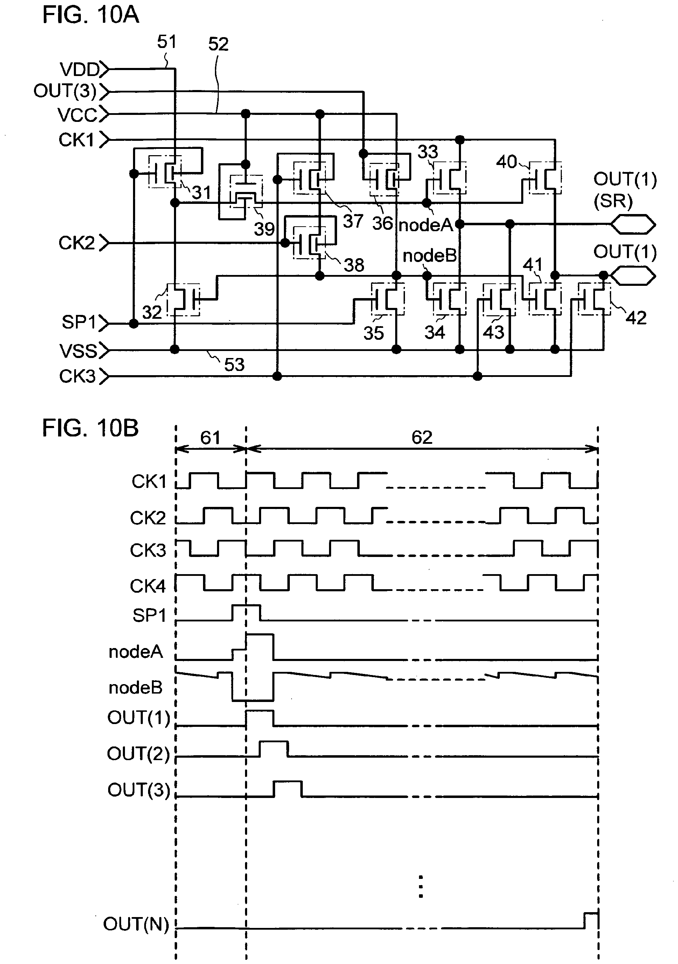

An embodiment of a shift register which is used for part of the scan line driver circuit and/or the signal line driver circuit is described with reference to FIGS. 9A to 9D and FIGS. 10A and 10B.

A shift register of a scan line driver circuit and/or a signal line driver circuit is described with reference to FIGS. 9A to 9D and FIGS. 10A and 10B. The shift register includes first to $N$-th pulse output circuits 10_1 to 10_$N$ ($N$ is a natural number and greater than or equal to 3) (see FIG 9A). In the shift register illustrated in FIG. 9A, a first clock signal CK1, a second clock signal CK2, a third clock signal CK3, and a fourth clock signal CK4 are supplied from a first wiring 11, a second wiring 12, a third wiring 13, and a fourth wiring 14, respectively, to the first to $N$th pulse output circuits 10_1 to 10_$N$. A start pulse SP1 (a first start pulse) from a fifth wiring 15 is input to the first pulse output circuit 10_1. A signal from a pulse output circuit of the preceding stage (also referred to as a preceding stage signal OUT ($n$ - 1) ($n$ is a natural number of greater than or equal to 2) is input to the $n$-th pulse output circuit 10_$n$ ($n$ is a natural number of greater than or equal to 2 and less than or equal to $N$) of the second and subsequent stages. A signal from the third pulse output circuit 10_3 which is two stages after the first pulse output circuit 10_1 is input to the first pulse output circuit 10_1. In a similar manner, a signal from the ($n$ + 2)-th pulse output circuit 10_($n$ + 2) which is two stages after the $n$-th pulse output circuit 10_$n$ (also referred to as a subsequent stage signal OUT ($n$ + 2)) is input to the n-th pulse output circuit 10_$n$ of the second and subsequent stages. Therefore, from the pulse output circuit of each stage, a first output signal (OUT (1) (SR) to OUT $N$ (SR)) to be input to a pulse output circuit of the next stage and/or the pulse output circuit of the stage before the preceding stage and a second output signal (OUT (1) to OUT ($N$)) which is input to a different wiring or the like are output. Note that since the subsequent-stage signal OUT(n+2) is not input to the last two stages of the shift register as illustrated in FIG 9A, a second start pulse SP2 and a third start pulse SP3 may be input to the pulse output circuits of the last two stages, for example.

Note that a clock signal (CK) is a signal which becomes an H level and an L level (also referred to as an L signal or a low power supply potential level) repeatedly at a constant interval. The first to fourth clock signals (CK1) to (CK4) are delayed by 1/4 period sequentially. In this embodiment, by using the first to fourth clock signals (CK1) to (CK4), control or the like of driving of the pulse output circuit is performed. Note that the clock signal is also referred to as GCK or SCK in some cases depending on a driver circuit to which the clock signal is input; the clock signal is referred to as CK in the following description.

Each of the first to $N$-th pulse output circuits 10_1 to 10_$N$ includes a first input terminal 21, a second input terminal 22, a third input terminal 23, a fourth input terminal 24, a fifth input terminal 25, a first output terminal 26, and a second output terminal 27 (see FIG 9B). The first input terminal 21, the second input terminal 22, and the third input terminal 23 are electrically connected to any of the first to fourth wirings 11 to 14. For example, in FIG. 9A, the first input terminal 21 of the first pulse output circuit 10_1 is electrically connected to the first wiring 11, the second input terminal 22 of the first pulse output circuit 10_1 is electrically connected to the second wiring 12, and the third input terminal 23 of the first pulse output circuit 10_1 is electrically connected to the third wiring 13. In addition, the first input terminal 21 of the second pulse output circuit 10_2 is electrically connected to the second wiring 12, the second input terminal 22 of the second pulse output circuit 10_2 is electrically connected to the third wiring 13, and the third input terminal 23 of the second pulse output circuit 10_2 is electrically connected to the fourth wiring 14.

In the first pulse output circuit 10_1, the first clock signal CK1 is input to the first input terminal 21; the second clock signal CK2 is input to the second input terminal 22; the third clock signal CK3 is input to the third input terminal 23; a start pulse SP1 is input to the fourth input terminal 24; a subsequent-stage signal OUT(3) (SR) is input to the fifth input terminal 25; the first output signal OUT(1)(SR) is output from the first output terminal 26; and the second output signal OUT(1) is output from the second output terminal 27.

In the first to $N$th pulse output circuits 10_1 to 10_$N$, a thin film transistor having four terminals can be used in addition to a thin film transistor having three terminals. FIG 9C illustrates the symbol of a thin film transistor 28 having four terminals which is used below in the drawings and the like. The thin film transistor 28 is an element which can control electric current between an IN terminal and an OUT terminal with a first control signal G1 which is input to a first gate electrode and a second control signal G2 which is input to a second gate electrode.

The threshold voltage of the thin film transistor 28 illustrated in FIG. 9C can be controlled to be a desired level by providing gate electrodes above and below a channel formation region of the thin film transistor 28 with a gate insulating film interposed between the upper gate electrode and the channel formation region and between the lower gate electrode and the channel formation region, and by controlling a potential of the upper gate electrode and/or a potential of the lower gate electrode.

Next, an example of a specific circuit configuration of the pulse output circuit is described with reference to FIG 9D.

The first pulse output circuit 10_1 includes first to thirteenth transistors 31 to 43 (see FIG 9D). Signals or power supply potentials are supplied to the first to thirteenth transistors 31 to 43 from a power supply line 51 which supplies a first high power supply potential $VDD,$ a power supply line 52 which supplies a second high power supply potential $VCC,$ and a power supply line 53 which supplies a low power supply potential $VSS,$ in addition to the above-described first to fifth input terminals 21 to 25, the first output terminal 26, and the second output terminal 27. The relation of the power supply potentials of the power supply lines in FIG 9D is as follows: the first power supply potential $VDD$ is higher than or equal to the second power supply potential $VCC,$ and the second power supply potential $VCC$ is higher than the third power supply potential $VSS.$ The first to fourth clock signals (CK1) to (CK4) are signals which become an H level and an L level repeatedly at a constant interval. The potential is $VDD$ when the clock signal is at an H level, and the potential is $VSS$ when the clock signal is at an L level. Note that when the potential $VDD$ of the power supply line 51 is set to be higher than the potential $VCC$ of the power supply line 52, a potential applied to the gate electrode of the transistor can be kept low without adversely affecting the operation; thus, the shift of the threshold voltage of the transistor can be reduced and deterioration can be suppressed. Note that as in FIG 9D, the thin film transistor 28 having four terminals which is illustrated in FIG 9C is preferably used as the first transistor 31 and the sixth to ninth transistors 36 to 39 among the first to thirteenth transistors 31 to 43. The first transistor 31 and the sixth to ninth transistors 36 to 39 need to switch a potential of a node to which one electrode serving as a source or a drain is connected depending on a control signal of a gate electrode, and can reduce a malfunction of the pulse output circuit by quick response (sharp rise of on-current) to the control signal input to the gate electrode. By using the thin film transistor 28 having four terminals which is illustrated in FIG 9C, the threshold voltage can be controlled, and a malfunction of the pulse output circuit can be further reduced. Note that although the first control signal G1 and the second control signal G2 are the same control signals in FIG. 9D, the first control signal G1 and the second control signal G2 may be different control signals.

In FIG 9D, a first terminal of the first transistor 31 is electrically connected to the power supply line 51, a second terminal of the first transistor 31 is electrically connected to a first terminal of the ninth transistor 39, and gate electrodes (a first gate electrode and a second gate electrode) of the first transistor 31 are electrically connected to the fourth input terminal 24. A first terminal of the second transistor 32 is electrically connected to the power supply line 53, a second terminal of the second transistor 32 is electrically connected to the first terminal of the ninth transistor 39, and a gate electrode of the second transistor 32 is electrically connected to a gate electrode of the fourth transistor 34. A first terminal of the third transistor 33 is electrically connected to the first input terminal 21, and a second terminal of the third transistor 33 is electrically connected to the first output terminal 26. A first terminal of the fourth transistor 34 is electrically connected to the power supply line 53, and a second terminal of the fourth transistor 34 is electrically connected to the first output terminal 26. A first terminal of the fifth transistor 35 is electrically connected to the power supply line 53, a second terminal of the fifth transistor 35 is electrically connected to the gate electrode of the second transistor 32 and the gate electrode of the fourth transistor 34, and a gate electrode of the fifth transistor 35 is electrically connected to the fourth input terminal 24. A first terminal of the sixth transistor 36 is electrically connected to the power supply line 52, a second terminal of the sixth transistor 36 is electrically connected to the gate electrode of the second transistor 32 and the gate electrode of the fourth transistor 34, and gate electrodes (a first gate electrode and a second gate electrode) of the sixth transistor 36 are electrically connected to the fifth input terminal 25. A first terminal of the seventh transistor 37 is electrically connected to the power supply line 52, a second terminal of the seventh transistor 37 is electrically connected to a second terminal of the eighth transistor 38, and gate electrodes (a first gate electrode and a second gate electrode) of the seventh transistor 37 are electrically connected to the third terminal 23. A first terminal of the eighth transistor 38 is electrically connected to the gate electrode of the second transistor 32 and the gate electrode of the fourth transistor 34, and gate electrodes (a first gate electrode and a second gate electrode) of the eighth transistor 38 are electrically connected to the second input terminal 22. A first terminal of the ninth transistor 39 is electrically connected to the second terminal of the first transistor 31 and the second terminal of the second transistor 32, a second terminal of the ninth transistor 39 is electrically connected to the gate electrode of the third transistor 33 and a gate electrode of the tenth transistor 40, and gate electrodes (a first gate electrode and a second gate electrode) of the ninth transistor 39 are electrically connected to the power supply line 52. A first terminal of the tenth transistor 40 is electrically connected to the first input terminal 21, a second terminal of the tenth transistor 40 is electrically connected to the second output terminal 27, and the gate electrode of the tenth transistor 40 is electrically connected to the second terminal of the ninth transistor 39. A first terminal of the eleventh transistor 41 is electrically connected to the power supply line 53, a second terminal of the eleventh transistor 41 is electrically connected to the second output terminal 27, and the gate electrode of the eleventh transistor 41 is electrically connected to the gate electrode of the second transistor 32 and the gate electrode of the fourth transistor 34. A first terminal of the twelfth transistor 42 is electrically connected to the power supply line 53, a second terminal of the twelfth transistor 42 is electrically connected to the second output terminal 27, and a gate electrode of the twelfth transistor 42 is electrically connected to the gate electrodes (the first gate electrode and thet second gate electrode) of the seventh transistor 37. A first terminal of the thirteenth transistor 43 is electrically connected to the power supply line 53, a second terminal of the thirteenth transistor 43 is electrically connected to the first output terminal 26, and a gate electrode of the thirteenth transistor 43 is electrically connected to the gate electrodes (the first gate electrode and the second gate electrode) of the seventh transistor 37.

In FIG 9D, a portion where the gate electrode of the third transistor 33, the gate electrode of the tenth transistor 40, and the second terminal of the ninth transistor 39 are connected to each other is referred to as a node A. A portion where the gate electrode of the second transistor 32, the gate electrode of the fourth transistor 34, the second terminal of the fifth transistor 35, the second terminal of the sixth transistor 36, the first terminal of the eighth transistor 38, and the gate electrode of the eleventh transistor 41 are connected to each other is referred to as a node B.

FIG 10A illustrates signals that are input to or output from the first to fifth input terminals 21 to 25 and the first and second output terminals 26 and 27 in the case where the pulse output circuit illustrated in FIG 9D is applied to the first pulse output circuit 10_1.

Specifically, the first clock signal CK1 is input to the first input terminal 21, the second clock signal CK2 is input to the second input terminal 22, the third clock signal CK3 is input to the third input terminal 23, the start pulse is input to the fourth input terminal 24, the subsequent stage signal OUT (3) is input to the fifth input terminal 25, the first output signal OUT (1) (SR) is output from the first output terminal 26, and the second output signal OUT (1) is output from the second output terminal 27.

Note that a thin film transistor is an element having at least three terminals of a gate, a drain, and a source. The thin film transistor has a semiconductor in which a channel region is formed in a region overlapping with the gate, and current which flows between the drain and the source through the channel region can be controlled by controlling the potential of the gate. Here, since the source and the drain of the thin film transistor may interchange depending on the structure, the operating condition, and the like of the thin film transistor, it is difficult to define which is a source or a drain. Therefore, a region functioning as source or a drain is not called the source or the drain in some cases. In such a case, for example, one of the source and the drain may be referred to as a first terminal and the other may be referred to as a second terminal.

Note that in FIG. 9D and FIG. 10A, a capacitor for performing bootstrap operation by bringing the node A into a floating state may be additionally provided. A capacitor whose one electrode is electrically connected to the node B may be additionally provided in order to hold the potential of the node B.

FIG 10B is a timing chart of a shift register including a plurality of the pulse output circuits illustrated in FIG 10A. Note that when the shift register is included in a scan line driver circuit, a period 61 in FIG 10B corresponds to a vertical retrace period and a period 62 corresponds to a gate selection period.

Note that as illustrated in FIG. 10A, when the ninth transistor 39 having the gate to which the second power supply potential *VCC* is applied is provided, there are the following advantages before or after the bootstrap operation.

In the case where the ninth transistor 39 having the gate electrode to which the second potential *VCC* is applied is not provided, when the potential at the node A is increased due to the bootstrap operation, the potential of a source which is the second terminal of the first transistor 31 increases to a value higher than the first power supply potential *VDD.* Then, the first terminal of the first transistor 31, that is, the terminal on the power supply line 51 side, becomes to serve as a source. Therefore, in the first transistor 31, a large bias voltage is applied and thus significant stress is applied between the gate and the source and between the gate and the drain, which can cause deterioration in the transistor. By providing of the ninth transistor 39 having the gate electrode to which the second power supply potential *VCC* is supplied, the potential at the node A is raised by the bootstrap operation, but at the same time, an increase in potential of the second terminal of the first transistor 31 can be prevented. In other words, by providing the ninth transistor 39, a negative bias voltage applied between the gate and the source of the first transistor 31 can be reduced. Accordingly, with a circuit structure in this embodiment, a negative bias voltage applied between the gate and the source of the first transistor 31 can be reduced, so that deterioration in the first transistor 31, which is due to stress, can further be restrained.

Note that the ninth transistor 39 may be provided so as to be connected between the second terminal of the first transistor 31 and the gate of the third transistor 33 with the first terminal and the second terminal. Further, when the shift register including a plurality of the pulse output circuits in this embodiment is included in a signal line driver circuit having a larger number of stages than a scan line driver circuit, the ninth transistor 39 can be omitted, which is advantageous in that the number of transistors is reduced.

Note that when oxide semiconductors are used for semiconductor layers for the first to the thirteenth transistors 31 to 43, the off current of the thin film transistors can be reduced, the on current and the field effect mobility can be increased, and the degree of deterioration can be reduced, whereby a malfunction in a circuit can decrease. Further, the degree of deterioration of the transistor using an oxide semiconductor caused by applying high potential to the gate electrode is small compared to the transistor using amorphous silicon. Therefore, even when the first power supply potential *VDD* is supplied to a power supply line to which the second power supply potential *VCC* is supplied, a similar operation can be performed, and the number of power supply lines which are provided in a circuit can be reduced, so that the circuit can be miniaturized.

Note that even if a wiring connection is changed so that the clock signal which is supplied to the gate electrodes (the first gate electrode and the second gate electrode) of the seventh transistor 37 through the third input terminal 23 and the clock signal which is supplied to the gate electrodes (the first gate electrode and the second gate electrode) of the eighth transistor 38 through the second input terminal 22 are the clock signal which is supplied to the gate electrodes (the first gate electrode and the second gate electrode) of the seventh transistor 37 through the second input terminal 22 and the clock signal which is supplied to the gate electrodes (the first gate electrode and the second gate electrode) of the eighth transistor 38 through the third input terminal 23, respectively, a similar effect can be obtained. Note that in the shift register illustrated in FIG. 10A, after the seventh transistor 37 and the eighth transistor 38 are both turned on, the seventh transistor 37 is turned off and the eighth transistor 38 is still on, and then, the seventh transistor 37 is still off and the eighth transistor 38 is turned off. Therefore, a decrease in potential of the node B, which is caused by a decrease in potentials of the second input terminal 22 and the third input terminal 23, occurs twice because of a decrease in potential of the gate electrode of the seventh transistor 37 and a decrease in potential of the gate electrode of the eighth transistor 38. On the other hand, when a state of the seventh transistor 37 and the eighth transistor 38 in the shift register illustrated in FIG. 10A is changed so that both the seventh transistor 37 and the eighth transistor 38 are on, then the seventh transistor 37 is on and the eighth transistor 38 is off, and then the seventh transistor 37 and the eighth transistor 38 are off, a decrease in potential of the node B due to a decrease in potentials of the second input terminal 22 and the third input terminal 23 is caused only once by a decrease in potential of the gate electrode of the eighth transistor 38. Consequently, it is preferable to supply the clock signal CK3 to the gate electrodes (the first gate electrode and the second gate electrode) of the seventh transistor 37 from the third input terminal 23 and the clock signal CK2 to the gate electrodes (the first gate electrode and the second gate electrode) of the eighth transistor 38 from the second input terminal 22 in order to reduce a change in potential of the node B and thus to reduce noise.

In this way, in a period during which the potentials of the first output terminal 26 and the second output terminal 27 are held at an L level, an H level signal is regularly supplied to the node B; therefore, a malfunction of the pulse output circuit can be suppressed.

By manufacturing the thin film transistor included in the above driver circuit with the use of the method for manufacturing a thin film transistor described in Embodiment 1, high-speed operation of the thin film transistor included in the driver circuit portion can be achieved, so that power consumption can be reduced.

This embodiment can be implemented in appropriate combination with the structures described in other embodiments.

[Embodiment 3]

In this embodiment, the case where thin film transistors are manufactured and a semiconductor device (also referred to as a display device) having a display function in which the thin film transistors are used for a pixel portion and a driver circuit is manufactured will be described. Further, part or whole of the driver circuit can be formed over the same substrate as the pixel portion with the use of a thin film transistor, whereby a system-on-panel can be obtained.

The display device includes a display element. As the display element, a liquid crystal element (also referred to as a liquid crystal display element) or a light-emitting element (also referred to as a light-emitting display element) can be used. The light-emitting element includes, in its category, an element whose luminance is controlled by a current or a voltage, and specifically includes, in its category, an inorganic electroluminescent (EL) element, an organic EL element, and the like. Furthermore, a display medium whose contrast is changed by an electric effect, such as electronic ink, can be used.

In addition, the display device includes a panel in which the display element is sealed, and a module in which an IC or the like including a controller is mounted on the panel. The display device relates to an embodiment of an element substrate before the display element is completed in a manufacturing process of the display device, and the element substrate is provided with a means for supplying a current to the display element in each of a plurality of pixels. Specifically, the element substrate may be in a state in which only a pixel electrode of the display element is provided, a state after formation of a conductive film to be a pixel electrode and before etching of the conductive film to form the pixel electrode, or any other states.

Note that a display device in this specification means an image display device, a display device, or a light source (including a lighting device). Further, the display device includes the following modules in its category: a module including a connector such as a flexible printed circuit (FPC), a tape automated bonding (TAB) tape, or a tape carrier package (TCP); a module having a TAB tape or a TCP which is provided with a printed wiring board at the end thereof; and a module having an integrated circuit (IC) which is directly mounted on a display element by a chip on glass (COG) method.

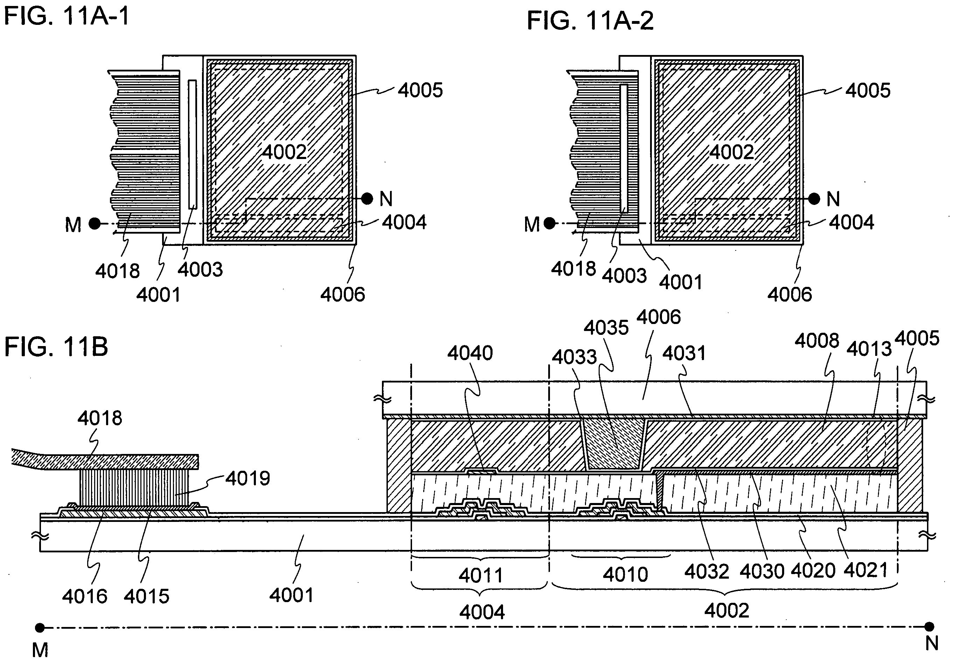

In this embodiment, an example of a liquid crystal display device is described as a semiconductor device which is an embodiment of the present invention. First, the appearance and the cross section of a liquid crystal display panel, which is an embodiment of a semiconductor device, are described with reference to FIGS. 11A-1, 11A-2, and 11B. FIGS. 11A-1 and 11A-2 are each a top view of a panel in which highly reliable thin film transistors 4010 and 4011 each including a semiconductor layer of an In-Ga-Zn-O-based non-single-crystal film, and a liquid crystal element 4013, which are formed over a first substrate 4001, are sealed between the first substrate 4001 and a second substrate 4006 with a sealant 4505. FIG 11B corresponds to a cross-sectional view of FIGS. 11A-1 and 11A-2 along line M-N.

The sealant 4005 is provided so as to surround a pixel portion 4002 and a scan line driver circuit 4004 which are provided over the first substrate 4001. The second substrate 4006 is provided over the pixel portion 4002 and the scan line driver circuit 4004. Therefore, the pixel portion 4002 and the scan line driver circuit 4004 are sealed together with a liquid crystal layer 4008, by the first substrate 4001, the sealant 4005, and the second substrate 4006. A signal line driver circuit 4003 that is formed using a single crystal semiconductor film or a polycrystalline semiconductor film over a substrate separately prepared is mounted in a region that is different from the region surrounded by the sealant 4005 over the first substrate 4001.

Note that a connection method of a driver circuit which is separately formed is not particularly limited, and a COG method, a wire bonding method, a TAB method, or the like can be used. FIG. 11A-1 illustrates an example of mounting the signal line driver circuit 4003 by a COG method, and FIG. 11A-2 illustrates an example of mounting the signal line driver circuit 4003 by a TAB method.

Further, the pixel portion 4002 and the scan line driver circuit 4004 provided over the first substrate 4001 each include a plurality of thin film transistors. FIG 11B illustrates the thin film transistor 4010 included in the pixel portion 4002 and the thin film transistor 4011 included in the scan line driver circuit 4004. Over the thin film transistors 4010 and 4011, insulating layers 4020 and 4021 are provided.

The highly reliable thin film transistor including the oxide semiconductor layer which is described in Embodiment 1 can be used as each of the thin film transistors 4010 and 4011. In this embodiment, the thin film transistors 4010 and 4011 are n-channel thin film transistors.

A conductive layer 4040 is provided over part of the insulating layer 4021, which overlaps with a channel formation region of the oxide semiconductor layer in the thin film transistor 4011 for the drive circuit. The conductive layer 4040 is provided at the position overlapping with the channel formation region of the oxide semiconductor layer, whereby the amount of change in threshold voltage of the thin film transistor 4011 before and after the BT test can be reduced. A potential of the conductive layer 4040 may be the same as or different from that of a gate electrode layer of the thin film transistor 4011. The conductive layer 4040 can also function as a second gate electrode layer. In addition, the potential of the conductive layer 4040 may be GND or 0 V, or the conductive layer 4040 may be in a floating state.

A pixel electrode layer 4030 included in the liquid crystal element 4013 is electrically connected to the thin film transistor 4010. A counter electrode layer 4031 of the liquid crystal element 4013 is provided on the second substrate 4006. A portion where the pixel electrode layer 4030, the counter electrode layer 4031, and the liquid crystal layer 4008 overlap with each other corresponds to the liquid crystal element 4013. Note that the pixel electrode layer 4030 and the counter electrode layer 4031 are provided with an insulating layer 4032 and an insulating layer 4033 respectively which each function as an alignment film, and the liquid crystal layer 4008 is sandwiched between the pixel electrode layer 4030 and the counter electrode layer 4031 with the insulating layers 4032 and 4033 therebetween.

Note that the first substrate 4001 and the second substrate 4006 can be formed of glass, metal (typically, stainless steel), ceramic, or plastic. As plastic, a fiberglass-reinforced plastic (FRP) plate, a polyvinyl fluoride (PVF) film, a polyester film, or an acrylic resin film can be used. In addition, a sheet with a structure in which an aluminum foil is sandwiched between PVF films or polyester films can be used.

A spacer 4035 is a columnar spacer obtained by selective etching of an insulating film and is provided in order to control the distance (a cell gap) between the pixel electrode layer 4030 and the counter electrode layer 4031. Alternatively, a spherical spacer may be used. In addition, the counter electrode layer 4031 is electrically connected to a common potential line formed over the same substrate as the thin film transistor 4010. With the use of a common connection portion, the counter electrode layer 4031 and the common potential line can be electrically connected to each other by conductive particles arranged between a pair of substrates. Note that the conductive particles are included in the sealant 4005.

In addition, liquid crystal exhibiting a blue phase for which an alignment film is unnecessary may be used. A blue phase is one of liquid crystal phases, which is generated just before a cholesteric phase changes into an isotropic phase while temperature of cholesteric liquid crystal is increased. Since the blue phase is only generated within a narrow range of temperatures, a liquid crystal composition containing a chiral agent at greater than or equal to 5 wt% is used for the liquid crystal layer 4008 in order to widen the temperature range. The liquid crystal composition which includes a liquid crystal exhibiting a blue phase and a chiral agent has a short response time of less than or equal to 1 msec, has optical isotropy, which makes the alignment process unneeded, and has a small viewing angle dependence.

Note that the liquid crystal display device described in this embodiment is an example of a transmissive liquid crystal display device; however, the liquid crystal display device can be applied to either a reflective liquid crystal display device or a semi-transmissive liquid crystal display device.

An example of the liquid crystal display device described in this embodiment is illustrated in which a polarizing plate is provided on the outer surface of the substrate (on the viewer side) and a coloring layer and an electrode layer used for a display element are provided on the inner surface of the substrate in this order; however, the polarizing plate may be provided on the inner surface of the substrate. The layered structure of the polarizing plate and the coloring layer is not limited to that in this embodiment and may be set as appropriate depending on materials of the polarizing plate and the coloring layer or conditions of the manufacturing process. Further, a light-blocking film serving as a black matrix may be provided as needed.

In addition, in this embodiment, in order to reduce the surface roughness of the thin film transistor and to improve the reliability of the thin film transistor, the thin film transistor is covered with the insulating layers (the insulating layer 4020 and the insulating layer 4021) each serving as a protective film or a planarization insulating film. Note that the protective film is provided to prevent entry of contaminant impurities such as organic substance, metal, or water vapor contained in the air and is preferably a dense film. The protective film may be formed with a single layer or stacked layers using one or more of a silicon oxide film, a silicon nitride film, a silicon oxynitride film, a silicon nitride oxide film, an aluminum oxide film, an aluminum nitride film, an aluminum oxynitride film, and an aluminum nitride oxide film by a sputtering method. Although an example in which the protective film is formed by a sputtering method is described in this embodiment, the present invention is not limited to this method and a variety of methods may be employed.

In this embodiment, the insulating layer 4020 having a layered structure is formed as a protective film. Here, a silicon oxide film is formed by a sputtering method, as a first layer of the insulating layer 4020. The use of a silicon oxide film as a protective film has an effect of preventing hillock of an aluminum film which is used as source and drain electrode layers.

As a second layer of the protective film, an insulating layer is formed. Here, a silicon nitride film is formed by a sputtering method, as a second layer of the insulating layer 4020. The use of the silicon nitride film as the protective film can prevent ions of sodium or the like from entering a semiconductor region so that variation in electrical characteristics of the TFT can be suppressed.

After the protective film is formed, the semiconductor layer may be subjected to annealing (300 °C to 400 °C).

The insulating layer 4021 is formed as the planarization insulating film. As the insulating layer 4021, an organic material having heat resistance such as polyimide, acrylic, benzocyclobutene, polyamide, or epoxy can be used. Other than such organic materials, it is also possible to use a low-dielectric constant material (a low-k material), a siloxane-based resin, PSG (phosphosilicate glass), BPSG (borophosphosilicate glass), or the like. Note that the insulating layer 4021 may be formed by stacking a plurality of insulating films formed of these materials.

Note that the siloxane-based resin corresponds to a resin including a Si-O-Si bond formed using a siloxane-based material as a starting material. The siloxane-based resin may include as a substituent an organic group (e.g., an alkyl group or an aryl group) or a fluoro group. In addition, the organic group may include a fluoro group.

There is no particular limitation on the method for forming the insulating layer 4021. The insulating layer 4021 can be formed, depending on the material, by a method such as a sputtering method, an SOG method, a spin coating method, a dipping method, a spray coating method, or a droplet discharge method (e.g., an ink-jet method, screen printing, or offset printing), or a tool (equipment) such as a doctor knife, a roll coater, a curtain coater, or a knife coater. In the case of forming the insulating layer 4021 using a material solution, annealing (300 °C to 400 °C) of the semiconductor layer may be performed at the same time as a baking step. The baking step of the insulating layer 4021 also serves as annealing of the semiconductor layer, whereby a semiconductor device can be manufactured efficiently.

The pixel electrode layer 4030 and the counter electrode layer 4031 can be formed using a light-transmitting conductive material such as indium oxide containing tungsten oxide, indium zinc oxide containing tungsten oxide, indium oxide containing titanium oxide, indium tin oxide containing titanium oxide, indium tin oxide (hereinafter referred to as ITO), indium zinc oxide, indium tin oxide to which silicon oxide is added, or the like.

A conductive composition containing a conductive high molecule (also referred to as a conductive polymer) can be used for the pixel electrode layer 4030 and the counter electrode layer 4031. The pixel electrode formed using the conductive composition preferably has a sheet resistance of less than or equal to 10000 ohms per square and a transmittance of greater than or equal to 70 % at a wavelength of 550 nm. Further, the resistivity of the conductive high molecule contained in the conductive composition is preferably less than or equal to 0.1 $\Omega\cdot$cm.

As the conductive high molecule, a so-called $\pi$-electron conjugated conductive polymer can be used. For example, polyaniline or a derivative thereof, polypyrrole or a derivative thereof, polythiophene or a derivative thereof, a copolymer of two or more kinds of them, and the like can be given.

Further, a variety of signals and potentials are supplied to the signal line driver circuit 4003 which is formed separately, the scan line driver circuit 4004, or the pixel portion 4002 from an FPC 4018.

In this embodiment, a connection terminal electrode 4015 is formed from the same conductive film as the pixel electrode layer 4030 included in the liquid crystal element 4013, and a terminal electrode 4016 is formed from the same conductive film as the source and drain electrode layers of the thin film transistors 4010 and 4011.

The connection terminal electrode 4015 is electrically connected to a terminal included in the FPC 4018 via an anisotropic conductive film 4019.

FIGS. 11A-1, 11A-2, and 11B illustrate an example in which the signal line driver circuit 4003 is formed separately and mounted on the first substrate 4001; however, this embodiment is not limited to this structure. The scan line driver circuit may be separately formed and then mounted, or only part of the signal line driver circuit or part of the scan line driver circuit may be separately formed and then mounted.

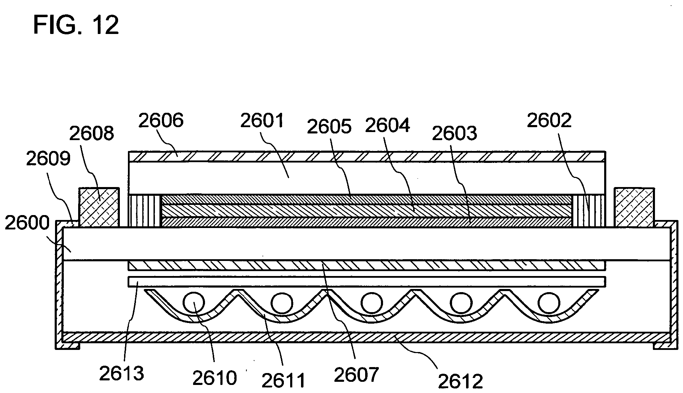

FIG 12 illustrates an example in which a liquid crystal display module which corresponds to an embodiment of a semiconductor device is formed using a TFT substrate 2600.

FIG. 12 illustrates an example of a liquid crystal display module, in which the TFT substrate 2600 and a counter substrate 2601 are fixed to each other with a sealant 2602, and a pixel portion 2603 including a TFT or the like, a display element 2604 including a liquid crystal layer, and a coloring layer 2605 are provided between the substrates to form a display region. The coloring layer 2605 is necessary to perform color display. In the RGB system, respective coloring layers corresponding to colors of red, green, and blue are provided for respective pixels. Polarizing plates 2606 and 2607 and a diffusion plate 2613 are provided outside the TFT substrate 2600 and the counter substrate 2601. A light source includes a cold cathode tube 2610 and a reflective plate 2611, and a circuit substrate 2612 is connected to a wiring circuit portion 2608 of the TFT substrate 2600 by a flexible wiring board 2609 and includes an external circuit such as a control circuit or a power source circuit. The polarizing plate and the liquid crystal layer may be stacked with a retardation plate therebetween.

The liquid crystal display module can employ a TN (Twisted Nematic) mode, an IPS (In-Plane-Switching) mode, an FFS (Fringe Field Switching) mode, an MVA (Multi-domain Vertical Alignment) mode, a PVA (Patterned Vertical Alignment) mode, an ASM (Axially Symmetric aligned Micro-cell) mode, an OCB (Optical Compensated Birefringence) mode, an FLC (Ferroelectric Liquid Crystal) mode, an AFLC (Anti Ferroelectric Liquid Crystal) mode, or the like.

Through this process, a highly reliable liquid crystal display device as a semiconductor device can be manufactured.

By manufacturing a thin film transistor in the pixel portion of the liquid crystal display device using the thin film transistor described in Embodiment 1, display unevenness due to variations in threshold voltage of thin film transistors of pixels can be suppressed.

By manufacturing a thin film transistor in the driver circuit of the liquid crystal display device using the method for manufacturing a thin film transistor described in Embodiment 1, high-speed operation of the thin film transistor in the driver circuit portion can be achieved, so that power consumption can be reduced.

This embodiment can be implemented in appropriate combination with the structures described in other embodiments.

[Embodiment 4]

An example of an electronic paper will be described as an embodiment of a semiconductor device.

The thin film transistor described in Embodiment 1 can be used for an electronic paper in which electronic ink is driven by an element electrically connected to a switching element. The electronic paper is also called an electrophoretic display device (electrophoretic display) and has advantages in that it has the same level of readability as regular paper, less power consumption than other display devices, and can be set to have a thin and light form.

Electrophoretic displays can have various modes. Electrophoretic displays contain a plurality of microcapsules dispersed in a solvent or a solute, each microcapsule containing first particles which are positively charged and second particles which are negatively charged. By applying an electric field to the microcapsules, the particles in the microcapsules move in opposite directions to each other and only the color of the particles gathering on one side is displayed. Note that the first particles and the second particles each contain pigment and do not move without an electric field. Moreover, the first particles and the second particles have different colors (which may be colorless).

Thus, an electrophoretic display is a display that utilizes a so-called dielectrophoretic effect by which a substance having a high dielectric constant moves to a high-electric field region.

A solution in which the above microcapsules are dispersed in a solvent is referred to as electronic ink. This electronic ink can be printed on a surface of glass, plastic, cloth, paper, or the like. Furthermore, by using a color filter or particles that have a pigment, color display can be achieved.

In addition, if a plurality of the above microcapsules are arranged as appropriate over an active matrix substrate so as to be interposed between two electrodes, an active matrix display device can be completed, and display can be performed by application of an electric field to the microcapsules. For example, the active matrix substrate obtained by using the thin film transistor described in Embodiment 1 can be used.

Note that the first particles and the second particles in the microcapsules may each be formed of a single material selected from a conductive material, an insulating material, a semiconductor material, a magnetic material, a liquid crystal material, a ferroelectric material, an electroluminescent material, an electrochromic material, and a magnetophoretic material, or formed of a composite material of any of these.

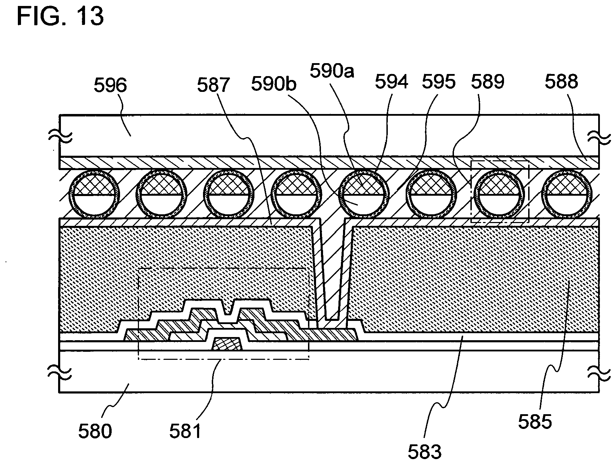

FIG. 13 illustrates an active matrix electronic paper as an example of a semiconductor device. A thin film transistor 581 used for the semiconductor device can be formed in a manner similar to that of the thin film transistor described in Embodiment 1, which is a highly reliable thin film transistor including an oxide semiconductor layer.

The electronic paper in FIG. 13 is an example of a display device using a twisting ball display system. The twisting ball display system refers to a method in which spherical particles each colored in black and white are arranged between a first electrode layer and a second electrode layer which are electrode layers used for a display element, and a potential difference is generated between the first electrode layer and the second electrode layer to control orientation of the spherical particles, so that display is performed.

The thin film transistor 581 formed over a substrate 580 is a bottom gate thin film transistor and is covered with an insulating film 583 which is in contact with a semiconductor layer. A source or drain electrode layer of the thin film transistor 581 is in contact with and electrically connected to a first electrode layer 587 through an opening formed in the insulating layers 583 and 585. Spherical particles 589 are provided between the first electrode layer 587 and a second electrode layer 588 formed on a substrate 596. Each of the spherical particles 589 includes a black region 590a, a white region 590b, and a cavity 594 filled with liquid around the black region 590a and the white region 590b. The circumference of the spherical particles 589 is filled with a filler 595 such as a resin (see FIG. 13). The first electrode layer 587 corresponds to a pixel electrode, and the second electrode layer 588 corresponds to a common electrode. The second electrode layer 588 is electrically connected to a common potential line provided over the same substrate as the thin film transistor 581. With the use of a common connection portion, the second electrode layer 588 can be electrically connected to the common potential line through conductive particles provided between a pair of substrates.

Further, instead of the twisting ball, an electrophoretic element can be used. A microcapsule having a diameter of about 10 $\mu$m to 200 $\mu$m in which transparent liquid, positively charged white microparticles, and negatively charged black microparticles are encapsulated, is used. In the microcapsule which is provided between the first electrode layer and the second electrode layer, when an electric field is applied by the first electrode layer and the second electrode layer, the white microparticles and the black microparticles move in opposite directions, so that white or black can be displayed. A display element using this principle is an electrophoretic display element and is generally called electronic paper. The electrophoretic display element has higher reflectance than a liquid crystal display element, and thus, an auxiliary light is unnecessary, power consumption is low, and a display portion can be recognized in a dim place. In addition, even when power is not supplied to the display portion, an image which has been displayed once can be maintained. Accordingly, a displayed image can be stored even if a semiconductor device having a display function (which may be referred to simply as a display device or a semiconductor device provided with a display device) is distanced from an electric wave source.

Through the above process, a highly reliable electronic paper as a semiconductor device can be manufactured.

This embodiment can be implemented in appropriate combination with the structures described in other embodiments.

[Embodiment 5]

An example of a light-emitting display device will be described as a semiconductor device. As a display element included in a display device, a light-emitting element utilizing electroluminescence is described here. Light-emitting elements utilizing electroluminescence are classified according to whether a light-emitting material is an organic compound or an inorganic compound. In general, the former is referred to as an organic EL element, and the latter is referred to as an inorganic EL element.

In an organic EL element, by application of voltage to a light-emitting element, electrons and holes are separately injected from a pair of electrodes into a layer containing a light-emitting organic compound, and current flows. The carriers (electrons and holes) are recombined, and thus, the light-emitting organic compound is excited. The light-emitting organic compound returns to a ground state from the excited state, thereby emitting light. Owing to such a mechanism, this light-emitting element is referred to as a current-excitation light-emitting element.

The inorganic EL elements are classified according to their element structures into a dispersion-type inorganic EL element and a thin-film inorganic EL element. A dispersion-type inorganic EL element has a light-emitting layer in which particles of a light-emitting material are dispersed in a binder, and its light emission mechanism is donor-acceptor recombination type light emission that utilizes a donor level and an acceptor level. A thin-film inorganic EL element has a structure in which a light-emitting layer is sandwiched between dielectric layers, which are further sandwiched between electrodes, and its light emission mechanism is localized type light emission that utilizes inner-shell electron transition of metal ions. Note that an example of an organic EL element as a light-emitting element is described here.

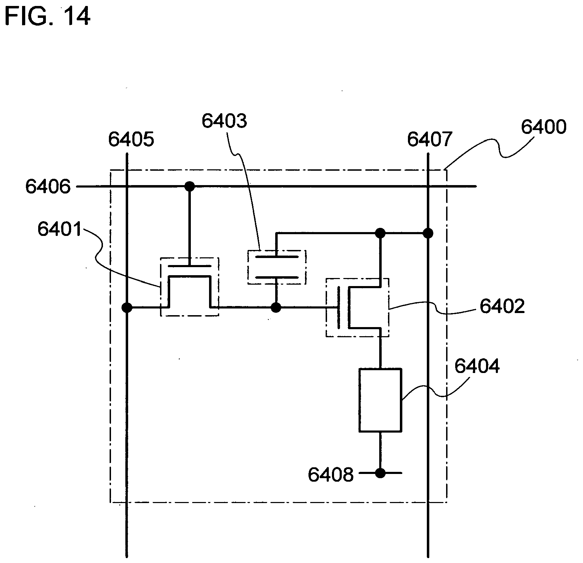

FIG. 14 illustrates an example of a pixel structure to which digital time grayscale driving can be applied, as an example of a semiconductor device.

A structure and an operation of a pixel to which digital time grayscale driving can be applied are described. Here, one pixel includes two n-channel transistors each of which includes an oxide semiconductor layer as a channel formation region.

A pixel 6400 includes a switching transistor 6401, a transistor 6402 for driving a light-emitting element, a light-emitting element 6404, and a capacitor 6403. A gate of the switching transistor 6401 is connected to a scan line 6406, a first electrode (one of a source electrode and a drain electrode) of the switching transistor 6401 is connected to a signal line 6405, and a second electrode (the other of the source electrode and the drain electrode) of the switching transistor 6401 is connected to a gate of the transistor 6402 for driving a light-emitting element. The gate of the transistor 6402 for driving a light-emitting element is connected to a power supply line 6407 through the capacitor 6403, a first electrode of the transistor 6402 is connected to the power supply line 6407, and a second electrode of the transistor 6402 is connected to a first electrode (pixel electrode) of the light-emitting element 6404. A second electrode of the light-emitting element 6404 corresponds to a common electrode 6408. The common electrode 6408 is electrically connected to a common potential line provided over the same substrate.

The second electrode (common electrode 6408) of the light-emitting element 6404 is set to have a low power supply potential. Note that the low power supply potential is a potential satisfying the low power supply potential < a high power supply potential with reference to the high power supply potential that is set for the power supply line 6407. As the low power supply potential, GND, 0 V, or the like may be employed, for example. A potential difference between the high power supply potential and the low power supply potential is applied to the light-emitting element 6404 and current is supplied to the light-emitting element 6404, so that the light-emitting element 6404 emits light. Here, in order to make the light-emitting element 6404 emit light, each potential is set so that the potential difference between the high power supply potential and the low power supply potential is greater than or equal to a forward threshold voltage of the light-emitting element 6404.

When the gate capacitance of the transistor 6402 for driving a light-emitting element is used as a substitute for the capacitor 6403, the capacitor 6403 can be omitted. The gate capacitance of the transistor 6402 for driving a light-emitting element may be formed between a channel region and a gate electrode.

Here, in the case of using a voltage-input voltage driving method, a video signal is input to the gate of the transistor 6402 for driving a light-emitting element to make the transistor 6402 for driving a light-emitting element completely turned on or off. That is, the transistor 6402 for driving a light-emitting element operates in a linear region. Since the transistor 6402 for driving a light-emitting element operates in a linear region, voltage higher than the voltage of the power supply line 6407 is applied to the gate of the transistor 6402 for driving a light-emitting element. Note that a voltage greater than or equal to (power supply line voltage + Vth of the transistor 6402 for driving a light-emitting element) is applied to the signal line 6405.

In the case of performing analog grayscale driving instead of digital time grayscale driving, the same pixel structure as that in FIG 14 can be used by changing signal input.

In the case of using the analog grayscale driving, a voltage greater than or equal to (forward voltage of the light-emitting element 6404 + Vth of the transistor 6402 for driving a light-emitting element) is applied to the gate of the transistor 6402 for driving a light-emitting element. The forward voltage of the light-emitting element 6404 indicates a voltage at which a desired luminance is obtained, and includes at least forward threshold voltage. By inputting a video signal to enable the transistor 6402 for driving a light-emitting element to operate in a saturation region, current can be supplied to the light-emitting element 6404. In order that the transistor 6402 for driving a light-emitting element can operate in the saturation region, the potential of the power supply line 6407 is higher than a gate potential of the transistor 6402 for driving a light-emitting element. When an analog video signal is used, it is possible to feed current to the light-emitting element 6404 in accordance with the video signal and perform analog grayscale driving.

Note that the pixel structure is not limited to that illustrated in FIG. 14. For example, a switch, a resistor, a capacitor, a transistor, a logic circuit, or the like may be added to the pixel illustrated in FIG 14.

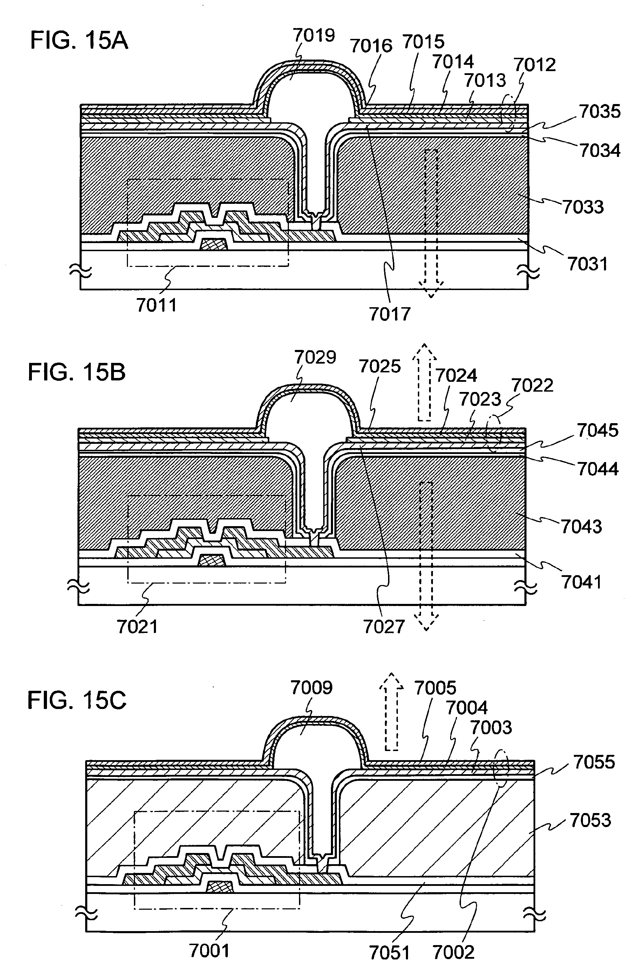

Next, structures of the light-emitting element will be described with reference to FIGS. 15A to 15C. Here, a cross-sectional structure of a pixel is described by taking an n-channel driving TFT as an example. Driving TFTs 7011, 7021, and 7001 which are each a TFT for driving a light-emitting element used in semiconductor devices illustrated in FIGS. 15A, 15B, and 15C respectively can be formed in a manner similar to that of the thin film transistor described in Embodiment 1 and are highly reliable thin film transistors each including an oxide semiconductor layer.

In order to extract light emitted from the light-emitting element, it is sufficient that at least one of an anode and a cathode is transparent. A thin film transistor and a light-emitting element are formed over a substrate. A light-emitting element can have a top emission structure in which light emission is extracted through the surface opposite to the substrate; a bottom emission structure in which light emission is extracted through the surface on the substrate side; or a dual emission structure in which light emission is extracted through the surface opposite to the substrate and the surface on the substrate side. The pixel structure can be applied to a light-emitting element having any of these emission structures.

Next, a light-emitting element having a bottom emission structure will be described with reference to FIG. 15A.

FIG. 15A is a cross-sectional view of a pixel in the case where the TFT 7011 is an n-channel transistor and light is emitted from a light-emitting element 7012 to a cathode 7013 side. In FIG 15A, the cathode 7013 of the light-emitting element 7012 is formed over a light-transmitting conductive film 7017 which is electrically connected to the TFT 7011, and an EL layer 7014 and an anode 7015 are stacked in this order over the cathode 7013. Note that the light-transmitting conductive film 7017 is electrically connected to a drain electrode layer of the TFT 7011 through a contact hole formed in an oxide insulating layer 7031, an overcoat layer 7034, and a protective insulating layer 7035.

As the light-transmitting conductive film 7017, a light-transmitting conductive film such as a film of indium oxide containing tungsten oxide, indium zinc oxide containing tungsten oxide, indium oxide containing titanium oxide, indium tin oxide containing titanium oxide, indium tin oxide (hereinafter referred to as ITO), indium zinc oxide, or indium tin oxide to which silicon oxide is added can be used.

Any of a variety of materials can be used for the cathode 7013. Specifically, the cathode 7013 is preferably formed using a material having a low work function such as an alkali metal such as Li or Cs; an alkaline earth metal such as Mg, Ca, or Sr; an alloy containing any of these metals (e.g., Mg:Ag or Al:Li); or a rare earth metal such as Yb or Er. In FIG. 15A, the thickness of the cathode 7013 is a thickness with which light can be transmitted (preferably, about 5 nm to 30 nm). For example, an aluminum film having a thickness of 20 nm is used for the cathode 7013.

Note that the light-transmitting conductive film and the aluminum film may be stacked and selectively etched to form the light-transmitting conductive film 7017 and the cathode 7013; in this case, the light-transmitting conductive film and the aluminum film can be etched with the use of the same mask, which is preferable.

The peripheral portion of the cathode 7013 is covered with a partition 7019. The partition 7019 is formed using an organic resin film of polyimide, acrylic, polyamide, epoxy, or the like, an inorganic insulating film, or organic polysiloxane. It is particularly preferable that the partition 7019 be formed using a photosensitive resin material to have an opening over the cathode 7013 so that a sidewall of the opening is formed as an inclined surface with continuous curvature. In the case where a photosensitive resin material is used for the partition 7019, a step of forming a resist mask can be omitted.

The EL layer 7014 which is formed over the cathode 7013 and the partition 7019 may be formed using a single layer or a plurality of layers stacked. When the EL layer 7014 is formed using a plurality of layers, the EL layer 7014 is formed by stacking an electron-injection layer, an electron-transport layer, a light-emitting layer, a hole-transport layer, and a hole-injection layer in this order over the cathode 7013. It is not necessary to form all of these layers.

The stacking order is not limited to the above stacking order, and a hole-injection layer, a hole-transport layer, a light-emitting layer, an electron-transport layer, and an electron-injection layer may be stacked in this order over the cathode 7013. However, when power consumption is compared, an electron-injection layer, an electron-transport layer, a light-emitting layer, a hole-transport layer, and a hole-injection layer are preferably stacked in this order over the cathode 7013 because of lower power consumption.

As the anode 7015 formed over the EL layer 7014, various materials can be employed, and a material having a high work function such as titanium nitride, ZrN, Ti, W, Ni, Pt, or Cr; or a transparent conductive material such as ITO, IZO (indium oxide zinc oxide), or ZnO is preferably used, for example. As a light-blocking film 7016 over the anode 7015, for example, a metal which blocks light, a metal which reflects light, or the like is used. In this embodiment, an ITO film is used for the anode 7015, and a Ti film is used for the light-blocking film 7016.

The light-emitting element 7012 corresponds to a region where the cathode 7013 and the anode 7015 sandwich the EL layer 7014. In the case of the element structure illustrated in FIG. 15A, light is emitted from the light-emitting element 7012 to the cathode 7013 side as indicated by an arrow.

Note that an example in which a light-transmitting conductive film is used as a gate electrode layer is illustrated in FIG. 15A, and light emitted from the light-emitting element 7012 passes through a color filter layer 7033 and gate and source electrode layers of the TFT 7011 to be emitted. A light-transmitting conductive film is used as the gate and source electrode layers of the TFT 7011, and thus, an aperture ratio can be improved.

The color filter layer 7033 is formed by a droplet discharge method such as an ink-jet method, a printing method, an etching method with the use of a photolithography technique, or the like.

The color filter layer 7033 is covered with the overcoat layer 7034, and also covered with the protective insulating layer 7035. Note that the overcoat layer 7034 with a small thickness is illustrated in FIG. 15A; however, the overcoat layer 7034 has a function to planarize a surface with unevenness due to the color filter layer 7033.

The contact hole which is formed in the oxide insulating layer 7031, the overcoat layer 7034, and the protective insulating layer 7035 and reaches the drain electrode layer is provided in a portion which overlaps with the partition 7019. In FIG. 15A, the contact hole which reaches the drain electrode layer and the partition 7019 overlap with each other, whereby an aperture ratio can be improved.

Next, a light-emitting element having a dual emission structure will be described with reference to FIG. 15B.

In FIG. 15B, a cathode 7023 of a light-emitting element 7022 is formed over a light-transmitting conductive film 7027 which is electrically connected to the TFT 7021, and an EL layer 7024 and an anode 7025 are stacked in this order over the cathode 7023. Note that the light-transmitting conductive film 7027 is electrically connected to a drain electrode layer of the TFT 7021 through a contact hole formed in an oxide insulating layer 7041, an overcoat layer 7044, and a protective insulating layer 7045.

For the light-transmitting conductive film 7027, a light-transmitting conductive film of indium oxide containing tungsten oxide, indium zinc oxide containing tungsten oxide, indium oxide containing titanium oxide, indium tin oxide containing titanium oxide, indium tin oxide (hereinafter referred to as ITO), indium zinc oxide, indium tin oxide to which silicon oxide is added, or the like can be used.

Any of a variety of materials can be used for the cathode 7023. Specifically, the cathode 7023 is preferably formed using a material having a low work function such as an alkali metal such as Li or Cs; an alkaline earth metal such as Mg, Ca, or Sr; an alloy containing any of these metals (e.g., Mg:Ag or Al:Li); or a rare earth metal such as Yb or Er. In this embodiment, the thickness of the cathode 7023 is formed to a thickness with which light can be transmitted (preferably, about 5 nm to 30 nm). For example, a 20-nm-thick aluminum film is used as the cathode 7023.

Note that the light-transmitting conductive film and an aluminum film may be stacked and then selectively etched, whereby the light-transmitting conductive film 7027 and the cathode 7023 may be formed. In this case, etching can be performed with the use of the same mask, which is preferable.

The periphery of the cathode 7023 is covered with a partition 7029. The partition 7029 is formed using an organic resin film of polyimide, acrylic, polyamide, epoxy, or the like, an inorganic insulating film, or organic polysiloxane. It is particularly preferable that the partition 7029 be formed using a photosensitive resin material to have an opening over the cathode 7023 so that a sidewall of the opening is formed as an inclined surface with continuous curvature. In the case where a photosensitive resin material is used for the partition 7029, a step of forming a resist mask can be omitted.

The EL layer 7024 which is formed over the cathode 7023 and the partition 7029 may be formed using a single layer or a plurality of layers stacked. When the EL layer 7024 is formed using a plurality of layers, the EL layer 7024 is formed by stacking an electron-injection layer, an electron-transport layer, a light-emitting layer, a hole-transport layer, and a hole-injection layer in this order over the cathode 7023. It is not necessary to form all of these layers.

The stacking order is not limited to the above stacking order, and a hole-injection layer, a hole-transport layer, a light-emitting layer, an electron-transport layer, and an electron-injection layer may be stacked in this order over the cathode 7023. Note that when power consumption is compared, stacking an electron-injection layer, an electron-transport layer, a light-emitting layer, a hole-transport layer, and a hole-injection layer in this order over the cathode 7023 leads to low power consumption and thus is more preferable.

Any of a variety of materials can be used for the anode 7025 which is formed over the EL layer 7024. For example, a material having a high work function such as a transparent conductive material such as ITO, IZO, or ZnO is preferable. In this embodiment, an ITO film containing silicon oxide is used for the anode 7025.

The light-emitting element 7022 corresponds to a region where the EL layer 7024 is sandwiched between the cathode 7023 and the anode 7025. In the case of the element structure illustrated in FIG. 15B, light is emitted from the light-emitting element 7022 to both the anode 7025 side and the cathode 7023 side as indicated by arrows.

Note that in FIG. 15B, an example in which a light-transmitting conductive film is used as the gate electrode layer is illustrated. Light emitted from the light-emitting element 7022 to the cathode 7023 side passes through a color filter layer 7043 and then passes through the gate electrode layer and the source electrode layer of the TFT 7021 to be emitted. When a light-transmitting conductive film is used for the gate electrode layer and the source electrode layer of the TFT 7021, the aperture ratio on the anode 7025 side can be approximately the same as the aperture ratio on the cathode 7023 side.

The color filter layer 7043 is formed by a droplet discharge method such as an ink-jet method, a printing method, an etching method with the use of a photolithography technique, or the like.

In addition, the color filter layer 7043 is covered with the overcoat layer 7044, and also covered with the protective insulating layer 7045.

The contact hole which is formed in the oxide insulating layer 7041, the overcoat layer 7044, and the protective insulating layer 7045 and reaches the drain electrode layer is provided in a portion which overlaps with the partition 7029. The contact hole which reaches the drain electrode layer and the partition 7029 overlap with each other, whereby the aperture ratio on the anode 7025 side can be approximately the same as the aperture ratio on the cathode 7023 side.

Note that when a light-emitting element having a dual emission structure is used and full color display is performed on both display surfaces, light from the anode 7025 side does not pass through the color filter layer 7043; therefore, a sealing substrate provided with another color filter layer is preferably provided over the anode 7025.

Next, a light-emitting element having a top emission structure is described with reference to FIG 15C.

FIG. 15C is a cross-sectional view of a pixel in the case where the driving TFT 7001 is an n-channel transistor and light is emitted from a light-emitting element 7002 to an anode 7005 side. In FIG. 15C, a cathode 7003 of the light-emitting element 7002 is electrically connected to the TFT 7001, and an EL layer 7004 and the anode 7005 are stacked in this order over the cathode 7003.

Any of a variety of materials can be used for the cathode 7003. Specifically, the cathode 7003 is preferably formed using a material having a low work function such as an alkali metal such as Li or Cs; an alkaline earth metal such as Mg, Ca, or Sr; an alloy containing any of these metals (e.g., Mg:Ag or Al:Li); or a rare earth metal such as Yb or Er.

The periphery of the cathode 7003 is covered with a partition 7009. The partition 7009 is formed using an organic resin film of polyimide, acrylic, polyamide, epoxy, or the like, an inorganic insulating film, or organic polysiloxane. It is particularly preferable that the partition 7009 be formed using a photosensitive resin material to have an opening over the cathode 7003 so that a sidewall of the opening is formed as an inclined surface with continuous curvature. In the case where a photosensitive resin material is used for the partition 7009, a step of forming a resist mask can be omitted.

The EL layer 7004 which is formed over the cathode 7003 and the partition 7009 may be formed using a single layer or a plurality of layers stacked. When the EL layer 7004 is formed using a plurality of layers, the EL layer 7004 is formed by stacking an electron-injection layer, an electron-transport layer, a light-emitting layer, a hole-transport layer, and a hole-injection layer in this order over the cathode 7003. It is not necessary to form all of these layers.

The stacking order is not limited to the above stacking order, and a hole-injection layer, a hole-transport layer, a light-emitting layer, an electron-transport layer, and an electron-injection layer may be stacked in this order over the cathode 7003. In the case where these layers are stacked in this order, the cathode 7003 functions as an anode.

In FIG. 15C, a hole-injection layer, a hole-transport layer, a light-emitting layer, an electron-transport layer, and an electron-injection layer are stacked in this order over a stacked film in which a Ti film, an aluminum film, and a Ti film are stacked in this order, and thereover, a stacked layer of a Mg:Ag alloy thin film and ITO is formed.

However, when power consumption is compared, it is preferable that an electron-injection layer, an electron-transport layer, a light-emitting layer, a hole-transport layer, and a hole-injection layer are preferably stacked in this order over the cathode 7003 because of lower power consumption.

The anode 7005 is formed using a light-transmitting conductive material, and for example, a light-transmitting conductive film of indium oxide containing tungsten oxide, indium zinc oxide containing tungsten oxide, indium oxide containing titanium oxide, indium tin oxide containing titanium oxide, indium tin oxide, indium zinc oxide, indium tin oxide to which silicon oxide is added, or the like may be used.

The light-emitting element 7002 corresponds to a region where the cathode 7003 and the anode 7005 sandwich the EL layer 7004. In the case of the pixel illustrated in FIG. 15C, light is emitted from the light-emitting element 7002 to the anode 7005 side as indicated by an arrow.

In FIG. 15C, an example in which the thin film transistor 150 is used as the TFT 7001 is illustrated; however, there is no particular limitation, and any of the thin film transistors 160, 170, and 180 can be used.

In addition, in FIG. 15C, the cathode 7003 is electrically connected to a drain electrode layer of the TFT 7001 through a contact hole formed in an oxide insulating layer 7051, a planarization insulating layer 7053, and an insulating layer 7055. The planarization insulating layer 7053 can be formed using a resin material such as polyimide, acrylic, benzocyclobutene, polyamide, or epoxy. In addition to such resin materials, it is also possible to use a low-dielectric constant material (low-k material), a siloxane-based resin, phosphosilicate glass (PSG), borophosphosilicate glass (BPSG), or the like. Note that the planarization insulating layer 7053 may be formed by stacking a plurality of insulating films formed of these materials. There is no particular limitation on the method for forming the planarization insulating layer 7053, and the planarization insulating layer 7053 can be formed, depending on the material, by a method such as a sputtering method, an SOG method, spin coating, dipping, spray coating, or a droplet discharge method (e.g., an ink-jet method, screen printing, or offset printing), or with a tool (equipment) such as a doctor knife, a roll coater, a curtain coater, or a knife coater.

The partition 7009 is provided so as to insulate the cathode 7003 and a cathode of an adjacent pixel. The partition 7009 is formed using an organic resin film of polyimide, acrylic, polyamide, epoxy, or the like, an inorganic insulating film, or organic polysiloxane. It is particularly preferable that the partition 7009 be formed using a photosensitive resin material to have an opening over the cathode 7003 so that a sidewall of the opening is formed as an inclined surface with continuous curvature.

In the structure illustrated in FIG. 15C, for performing full-color display, the light-emitting element 7002, one of adjacent light-emitting elements, and the other of the adjacent light-emitting elements are, for example, a green emissive light-emitting element, a red emissive light-emitting element, and a blue emissive light-emitting element, respectively. Alternatively, a light-emitting display device capable of full color display may be manufactured using four kinds of light-emitting elements which include a white light-emitting element in addition to three kinds of light-emitting elements.

Further alternatively, in the structure of FIG. 15C, all of a plurality of light-emitting elements which are arranged may be white light-emitting elements and a sealing substrate having a color filter or the like may be arranged over the light-emitting element 7002, so that a light-emitting display device capable of full color display may be manufactured. A material which exhibits a single color such as white is formed and combined with a color filter or a color conversion layer, whereby full color display can be performed.

Needless to say, display with monochromatic light emission can be performed. For example, a lighting system may be formed with the use of white light emission, or an area-color light-emitting device may be formed with the use of monochromatic light emission.

If necessary, an optical film such as a polarizing film including a circularly polarizing plate may be provided.

Note that, although the organic EL elements are described here as the light-emitting elements, an inorganic EL element can be provided as a light-emitting element.

Note that the example is described in which a thin film transistor (a driving TFT) which controls the driving of a light-emitting element is electrically connected to the light-emitting element; however, a structure may be employed in which a TFT for current control is connected between the driving TFT and the light-emitting element.

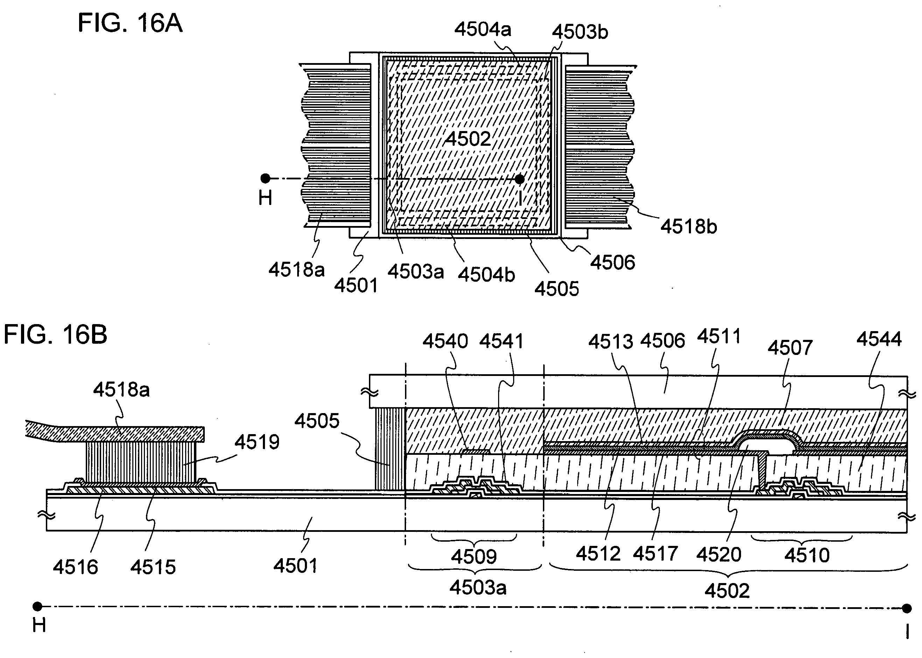

Next, the appearance and the cross section of a light-emitting display panel (also referred to as a light-emitting panel) which corresponds to an embodiment of a semiconductor device is described with reference to FIGS. 16A and 16B. FIG 16A is a plan view of a panel in which a thin film transistor and a light-emitting element formed over a first substrate are sealed between the first substrate and a second substrate with a sealant. FIG 16B is a cross-sectional view taken along line H-I of FIG. 16A.

A sealant 4505 is provided so as to surround a pixel portion 4502, signal line driver circuits 4503a and 4503b, and scan line driver circuits 4504a and 4504b which are provided over a first substrate 4501. In addition, a second substrate 4506 is provided over the pixel portion 4502, the signal line driver circuits 4503a and 4503b, and the scan line driver circuits 4504a and 4504b. Accordingly, the pixel portion 4502, the signal line driver circuits 4503a and 4503b, and the scan line driver circuits 4504a and 4504b are sealed together with a filler 4507, by the first substrate 4501, the sealant 4505, and the second substrate 4506. It is preferable that a panel be packaged (sealed) with a protective film (such as a laminate film or an ultraviolet curable resin film) or a cover material with high air-tightness and little degasification so that the panel is not exposed to the outside air, in this manner.

The pixel portion 4502, the signal line driver circuits 4503a and 4503b, and the scan line driver circuits 4504a and 4504b formed over the first substrate 4501 each include a plurality of thin film transistors, and a thin film transistor 4510 included in the pixel portion 4502 and a thin film transistor 4509 included in the signal line driver circuit 4503a are illustrated as an example in FIG 16B.

For the thin film transistors 4509 and 4510, the highly reliable thin film transistor including an oxide semiconductor layer described in Embodiment 1 can be employed. In this embodiment, the thin film transistors 4509 and 4510 are n-channel thin film transistors.

A conductive layer 4540 is provided over part of an insulating layer 4544, which overlaps with a channel formation region of an oxide semiconductor layer in the thin film transistor 4509 for the driver circuit. The conductive layer 4540 is provided at the position overlapping with the channel formation region of the oxide semiconductor layer, whereby the amount of change in threshold voltage of the thin film transistor 4509 before and after the BT test can be reduced. A potential of the conductive layer 4540 may be the same as or different from that of a gate electrode layer of the thin film transistor 4509. The conductive layer 4540 can also function as a second gate electrode layer. In addition, the potential of the conductive layer 4540 may be GND or 0 V, or the conductive layer 4540 may be in a floating state.

In the thin film transistor 4509, an insulating layer 4541 is formed in contact with the semiconductor layer including the channel formation region, as a protective insulating film. The insulating layer 4541 can be formed using a material and a method which are similar to those of the protective insulating layer 107 described in Embodiment 1. Moreover, the insulating layer 4544 functioning as a planarization insulating film covers the thin film transistors in order to reduce surface unevenness caused by the thin film transistors. Here, as the insulating layer 4541, a silicon oxide film is formed by a sputtering method in a manner similar to that of the protective insulating layer 107 in Embodiment 1.

The insulating layer 4544 is formed as the planarization insulating film. The insulating layer 4544 may be formed using a material and a method which are similar to those of the insulating layer 4021 described in Embodiment 2. Here, acrylic is used for the insulating layer 4544.

Moreover, reference numeral 4511 denotes a light-emitting element. A first electrode layer 4517 which is a pixel electrode included in the light-emitting element 4511 is electrically connected to a source electrode layer or a drain electrode layer of the thin film transistor 4510. Note that the structure of the light-emitting element 4511 is, but not limited to, the layered structure which includes the first electrode layer 4517, an electroluminescent layer 4512, and a second electrode layer 4513. The structure of the light-emitting element 4511 can be changed as appropriate depending on the direction in which light is extracted from the light-emitting element 4511, or the like.

A partition 4520 is formed using an organic resin film, an inorganic insulating film, or organic polysiloxane. It is particularly preferable that the partition 4520 be formed using a photosensitive material and an opening be formed over the first electrode layer 4517 so that a sidewall of the opening is formed as an inclined surface with continuous curvature.

The electroluminescent layer 4512 may be formed with a single layer or a plurality of layers stacked.

A protective film may be formed over the second electrode layer 4513 and the partition 4520 in order to prevent entry of oxygen, hydrogen, moisture, carbon dioxide, or the like into the light-emitting element 4511. As the protective film, a silicon nitride film, a silicon nitride oxide film, a DLC film, or the like can be formed.

In addition, a variety of signals and potentials are supplied to the signal line driver circuits 4503a and 4503b, the scan line driver circuits 4504a and 4504b, or the pixel portion 4502 from FPCs 4518a and 4518b.

A connection terminal electrode 4515 is formed from the same conductive film as the first electrode layer 4517 included in the light-emitting element 4511, and a terminal electrode 4516 is formed from the same conductive film as the source and drain electrode layers included in the thin film transistors 4509 and 4510.

The connection terminal electrode 4515 is electrically connected to a terminal included in the FPC 4518a via an anisotropic conductive film 4519.

A substrate located in the direction in which light is extracted from the light-emitting element 4511 needs to have a light-transmitting property. In that case, a light-transmitting material such as a glass plate, a plastic plate, a polyester film, or an acrylic film is used for the second substrate 4506.

As the filler 4507, an ultraviolet curable resin or a thermosetting resin can be used, in addition to an inert gas such as nitrogen or argon. For example, PVC (polyvinyl chloride), acrylic, polyimide, an epoxy resin, a silicone resin, PVB (polyvinyl butyral), or EVA (ethylene vinyl acetate) can be used. For example, nitrogen is used for the filler.

In addition, if needed, an optical film, such as a polarizing plate, a circularly polarizing plate (including an elliptically polarizing plate), a retardation plate (a quarter-wave plate or a half-wave plate), or a color filter, may be provided as appropriate on a light-emitting surface of the light-emitting element. Further, the polarizing plate or the circularly polarizing plate may be provided with an anti-reflection film. For example, anti-glare treatment by which reflected light can be diffused by projections and depressions on the surface so as to reduce the glare can be performed.

The signal line driver circuits 4503a and 4503b and the scan line driver circuits 4504a and 4504b may be mounted as driver circuits formed using a single crystal semiconductor film or a polycrystalline semiconductor film over a substrate separately prepared. Alternatively, only the signal line driver circuits or part thereof, or the scan line driver circuits or part thereof may be separately formed and mounted. This embodiment is not limited to the structure illustrated in FIGS. 16A and 16B.

Through the above process, a highly reliable light-emitting display device (display panel) as a semiconductor device can be manufactured.

By manufacturing the thin film transistor in the pixel portion of the light-emitting display device using the method for manufacturing a thin film transistor described in Embodiment 1, display unevenness due to variations in threshold voltage of thin film transistors of pixels can be suppressed.

By manufacturing the thin film transistor for the driver circuit of the light-emitting display device using the method for manufacturing a thin film transistor described in Embodiment 1, high-speed operation of the thin film transistor in the driver circuit portion can be achieved, so that power consumption can be reduced.

This embodiment can be implemented in appropriate combination with the structures described in other embodiments.

[Embodiment 6]

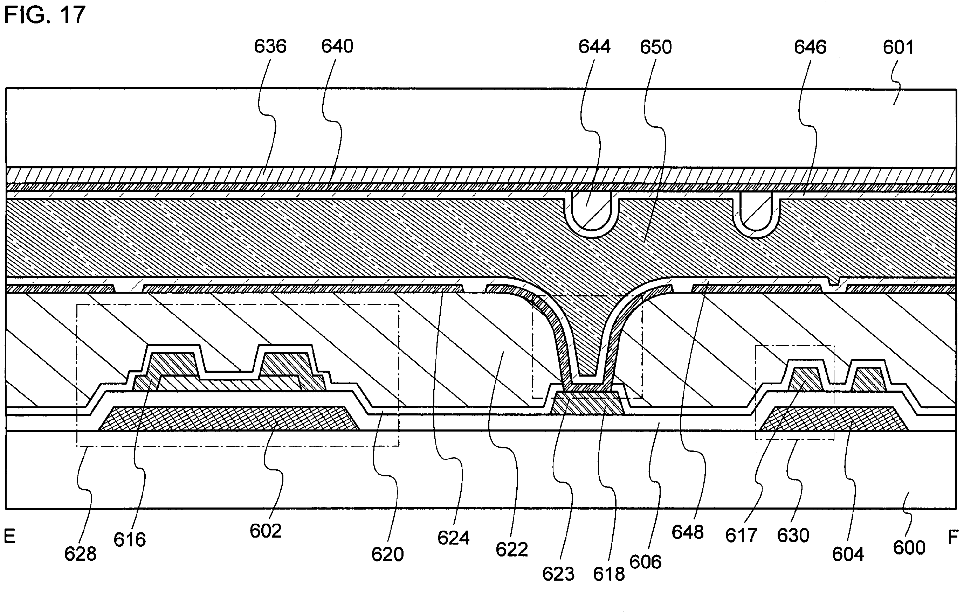

In this embodiment, as an embodiment of a semiconductor device, an example of a liquid crystal display device which includes the thin film transistor described in Embodiment 1 and uses a liquid crystal element will be described with reference to FIG. 17, FIG. 18, FIG. 19, and FIG. 20. The thin film transistor described in Embodiment 1 can be used for TFTs 628 and 629, which are used for the liquid crystal display device illustrated in FIG. 17, FIG. 18, FIG. 19, and FIG. 20. Further, the TFTs 628 and 629 can be manufactured through a process similar to that of Embodiment 1, and have high electric characteristics and high reliability. The TFT 628 and the TFT 629 each include an oxide semiconductor layer as a channel formation region. The case where the thin film transistor illustrated in FIG. 2C is used as an example of the thin film transistor is described with reference to FIG. 17, FIG. 18, FIG 19, and FIG. 20, but this embodiment is not limited thereto.

Hereinafter, a vertical alignment (VA) mode liquid crystal display device is described. The VA-mode liquid crystal display device has a kind of form in which alignment of liquid crystal molecules of a liquid crystal display panel is controlled. In the VA-mode liquid crystal display device, liquid crystal molecules are aligned in a vertical direction with respect to a panel surface when no voltage is applied. In this embodiment, in particular, a pixel is divided into some regions (subpixels), and molecules are aligned in different directions in their respective regions. This is referred to as multi-domain or multi-domain design. Hereinafter, a liquid crystal display device of multi-domain design is described.

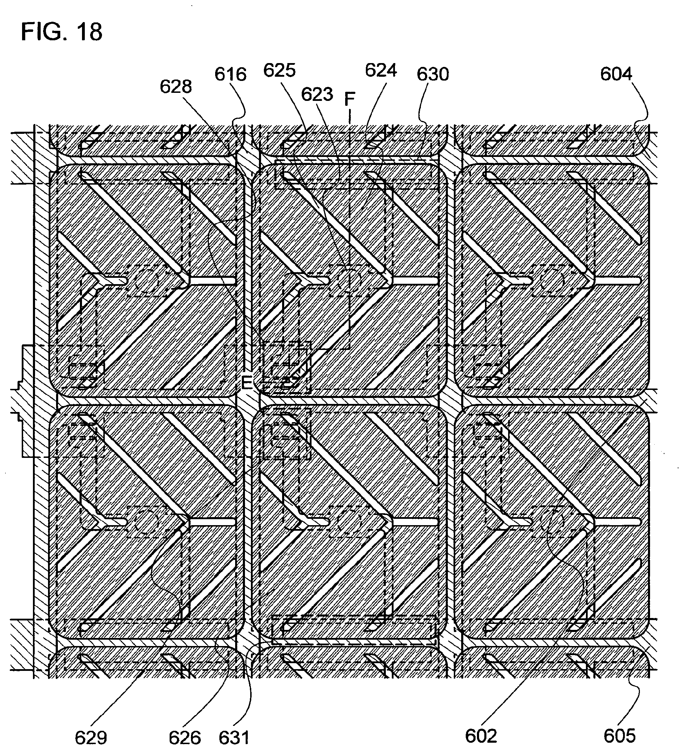

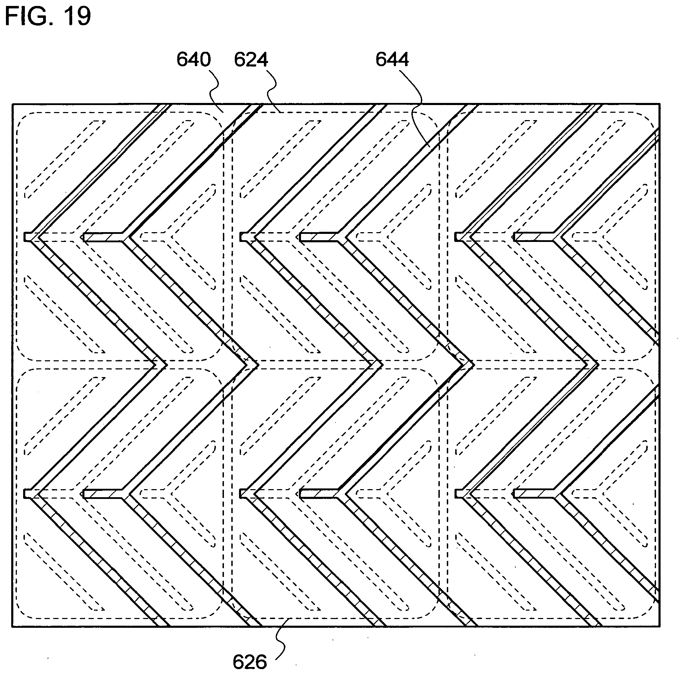

FIG. 18 and FIG. 19 illustrate a pixel electrode and a counter electrode, respectively. FIG. 18 is a plan view of a substrate side provided with the pixel electrode. FIG. 17 illustrates a cross-sectional structure taken along line E-F of FIG. 18. FIG. 19 is a plan view on a substrate side over which the counter electrode is formed. Hereinafter, description is made with reference to these drawings.

In FIG. 17, a substrate 600 over which the TFT 628, a pixel electrode layer 624 connected to the TFT 628, and a storage capacitor portion 630 are formed and a counter substrate 601 over which a counter electrode layer 640 and the like are provided are overlapped with each other, and liquid crystals are injected between the substrate 600 and the counter substrate 601.

Although not illustrated, a columnar spacer which is higher than a projection 644 is formed between the substrate 600 and the counter substrate 601 so that a distance between the pixel electrode layer 624 and the counter electrode layer 640 (cell gap) is made uniform. An alignment film 648 is formed over the pixel electrode layer 624, and an alignment film 646 is similarly formed on the counter electrode layer 640. A liquid crystal layer 650 is formed between the alignment films 646 and 648.

Although a columnar spacer is used for the spacer here, bead spacers may be dispersed. Further, the spacer may be formed over the pixel electrode layer 624 provided over the substrate 600.

The TFT 628, the pixel electrode layer 624 connected to the TFT 628, and the storage capacitor portion 630 are formed over the substrate 600. The pixel electrode layer 624 is connected to a wiring 618 through a contact hole 623 which penetrates an insulating film 620 which covers the TFT 628, a wiring 616, and the storage capacitor portion 630 and also penetrates an insulating film 622 which covers the insulating film 620. The thin film transistor described in Embodiment 1 can be used as appropriate for the TFT 628. Further, the storage capacitor portion 630 includes a first capacitor wiring 604 that is formed at the same time as a gate wiring 602 of the TFT 628; a gate insulating film 606; and a second capacitor wiring 617 that is formed at the same time as the wiring 616 and the wiring 618.

The pixel electrode layer 624, the liquid crystal layer 650, and the counter electrode layer 640 overlap with each other, so that a liquid crystal element is formed.

FIG. 18 illustrates a planar structure over the substrate 600. The pixel electrode layer 624 can be formed using a light-transmitting conductive material such as indium oxide containing tungsten oxide, indium zinc oxide containing tungsten oxide, indium oxide containing titanium oxide, indium tin oxide containing titanium oxide, indium tin oxide (hereinafter referred to as ITO), indium zinc oxide, or indium tin oxide to which silicon oxide is added.

A conductive composition containing a conductive high molecule (also referred to as a conductive polymer) can be used for the pixel electrode layer 624. The pixel electrode formed using the conductive composition preferably has a sheet resistance of less than or equal to 10000 ohms per square and a transmittance of greater than or equal to 70 % at a wavelength of 550 nm. Further, the resistivity of the conductive high molecule included in the conductive composition is preferably less than or equal to 0.1 $\Omega$-cm.

As the conductive high molecule, a so-called $\pi$-electron conjugated conductive polymer can be used. For example, polyaniline or a derivative thereof, polypyrrole or a derivative thereof, polythiophene or a derivative thereof, a copolymer of two or more kinds of them, and the like can be given.

Slits 625 are formed in the pixel electrode layer 624. The slits 625 are formed to control alignment of the liquid crystals.

A TFT 629, a pixel electrode layer 626 connected to the TFT 628, and a storage capacitor portion 631, which are illustrated in FIG 18, can be formed in a similar manner to those of the TFT 628, the pixel electrode layer 624, and the storage capacitor portion 630, respectively. Both the TFTs 628 and 629 are connected to the wiring 616. A pixel of this liquid crystal display panel includes the pixel electrode layers 624 and 626. The pixel electrode layers 624 and 626 each constitute a subpixel.

FIG. 19 illustrates a planar structure of the counter substrate side. The counter electrode layer 640 is preferably formed using a material similar to that of the pixel electrode layer 624. The projections 644 that control alignment of liquid crystals are formed on the counter electrode layer 640.

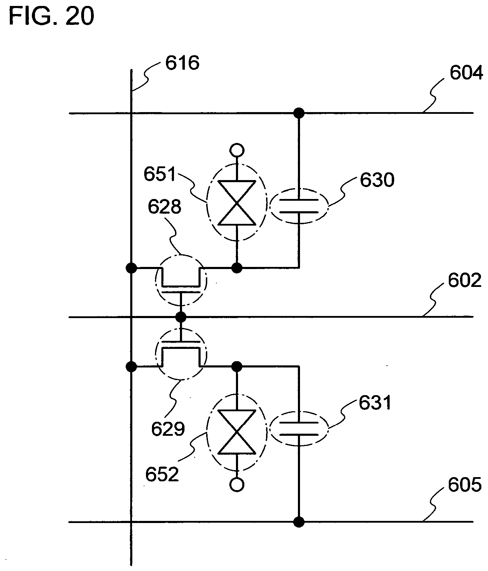

FIG. 20 illustrates an equivalent circuit of this pixel structure. Both the TFTs 628 and 629 are connected to the gate wiring 602 and the wiring 616. In this case, when potentials of the capacitor wiring 604 and a capacitor wiring 605 are different from each other, operations of liquid crystal elements 651 and 652 can vary. That is, alignment of the liquid crystal is precisely controlled and a viewing angle is increased by individual control of potentials of the capacitor wirings 604 and 605.

When a voltage is applied to the pixel electrode layer 624 provided with the slit 625, distortion of an electric field (an oblique electric field) is generated in the vicinity of the slit 625. The slit 625 and the projection 644 on the counter substrate 601 side are alternately arranged, and thus, an oblique electric field is effectively generated to control alignment of the liquid crystal, so that a direction of alignment of the liquid crystal varies depending on location. That is, a viewing angle of the liquid crystal display panel is increased by domain multiplication.

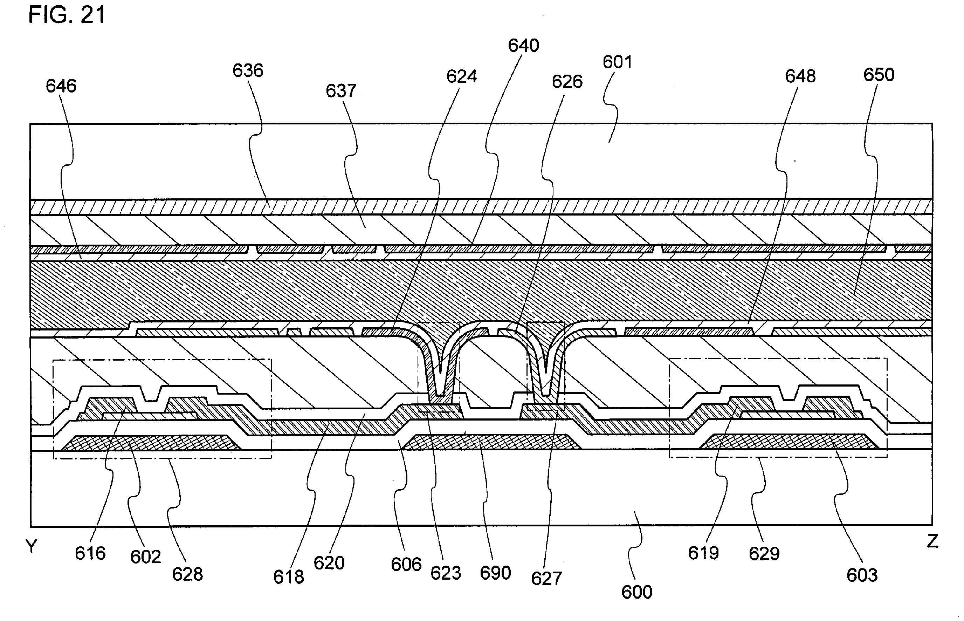

Next, a VA-mode liquid crystal display device different from the above is described with reference to FIG. 21, FIG. 22, FIG. 23, and FIG. 24.

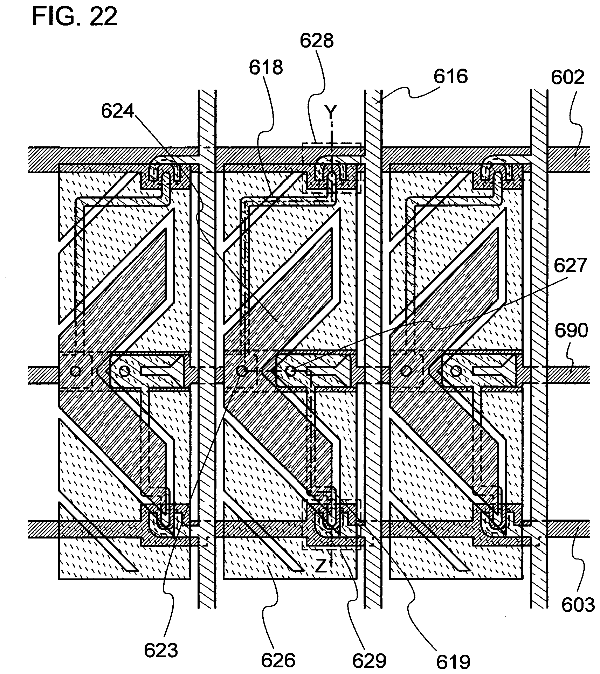

FIG. 21 and FIG. 22 illustrate a pixel structure of a VA-mode liquid crystal display panel. FIG. 22 is a plan view of a substrate 600. FIG. 21 illustrates a cross-sectional structure taken along line Y-Z in FIG. 22. Description below is given with reference to both the drawings.

In this pixel structure, a plurality of pixel electrodes are provided in one pixel, and a TFT is connected to each pixel electrode. A plurality of TFTs are constructed so as to be driven by different gate signals. That is, signals that are applied to individual pixel electrodes in a multi-domain pixel are controlled independently of each other.

A pixel electrode layer 624 is connected to a TFT 628 in a contact hole 623 through a wiring 618. In addition, a pixel electrode layer 626 is connected to a TFT 629 in a contact hole 627 through a wiring 619. A gate wiring 602 of the TFT 628 is separated from a gate wiring 603 of the TFT 629 so that different gate signals can be supplied. On the other hand, a wiring 616 serving as a data line is shared by the TFTs 628 and 629. The thin film transistor described in Embodiment 1 can be used as appropriate for the TFTs 628 and 629. Also, a capacitor wiring 690 is provided.

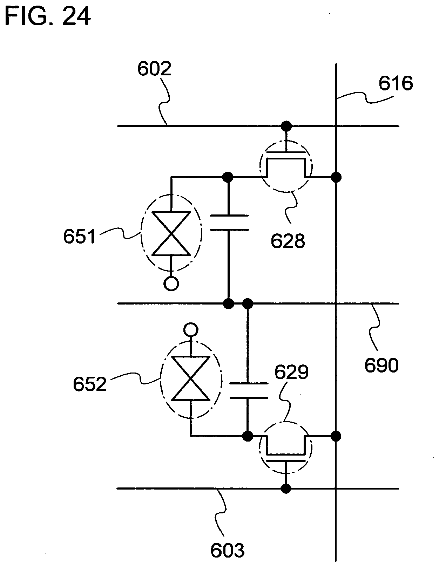

The shape of the pixel electrode layer 624 is different from that of the pixel electrode layer 626, and the pixel electrode layer 626 is formed so as to surround the external side of the pixel electrode layer 624 which spreads into a V-shape. The TFTs 628 and 629 make voltages applied to the pixel electrode layers 624 and 626 different from each other, thereby controlling alignment of liquid crystals. FIG 24 illustrates an equivalent circuit of this pixel structure. The TFT 628 is connected to the gate wiring 602, and the TFT 629 is connected to the gate wiring 603. Both the TFT 628 and the TFT 629 are connected to the wiring 616. When signals supplied to the gate wirings 602 and 603 are controlled independently of each other, voltages applied to liquid crystal elements 651 and 652 can vary. In other words, when operation of the TFTs 628 and 629 is individually controlled, alignment of liquid crystal in the liquid crystal elements 651 and 652 can vary; accordingly, viewing angle can be increased.

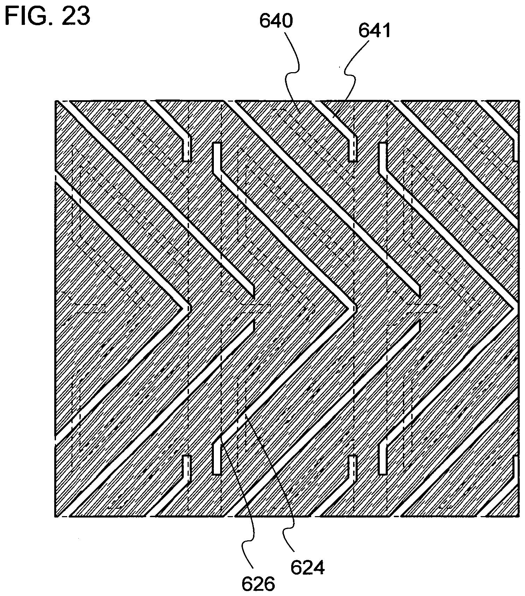

A counter substrate 601 is provided with a coloring film 636 and a counter electrode layer 640. Moreover, a planarization film 637 is formed between the coloring film 636 and the counter electrode layer 640 to prevent alignment disorder of the liquid crystal. FIG 23 illustrates the structure of the counter substrate side. The counter electrode layer 640 is shared by plural pixels, and slits 641 are formed in the counter electrode 640. The slits 641 and the slits 625 on the pixel electrode layers 624 and 626 side are alternately arranged so that an oblique electric field is effectively generated to control alignment of the liquid crystals. Accordingly, the orientation of the liquid crystals can be varied depending on the location, so that the viewing angle is widened. Note that in FIG. 23, the dashed line indicates the pixel electrode layers 624 and 626 which are formed over the substrate 600, and the counter electrode layer 640 is provided to overlap with the pixel electrode layers 624 and 626.

An alignment film 648 is formed over the pixel electrode layers 624 and 626, and an alignment film 646 is formed on the counter electrode layer 640 in a similar manner. A liquid crystal layer 650 is formed between the substrate 600 and the counter substrate 601. Further, the pixel electrode layer 624, the liquid crystal layer 650, and the counter electrode layer 640 overlap with each other, so that a first liquid crystal element is formed. In addition, the pixel electrode layer 626, the liquid crystal layer 650, and the counter electrode layer 640 overlap with each other, so that a second liquid crystal element is formed. The pixel structure of the display panel illustrated in FIG. 21, FIG. 22, FIG. 23, and FIG. 24 is a multi-domain structure in which the first liquid crystal element and the second liquid crystal element are provided in one pixel.

Although the VA-mode liquid crystal display device is described in this embodiment as a liquid crystal display device including the thin film transistor described in Embodiment 1, the thin film transistor described in Embodiment 1 can be applied to an IPS-mode liquid crystal display device, a TN-mode liquid crystal display device, or the like.

By manufacturing the thin film transistor included in the pixel portion of the liquid crystal display device with the use of the method for manufacturing a thin film transistor described in Embodiment 1, display unevenness due to variations in threshold voltage of thin film transistors in pixels can be suppressed.

[Embodiment 7]

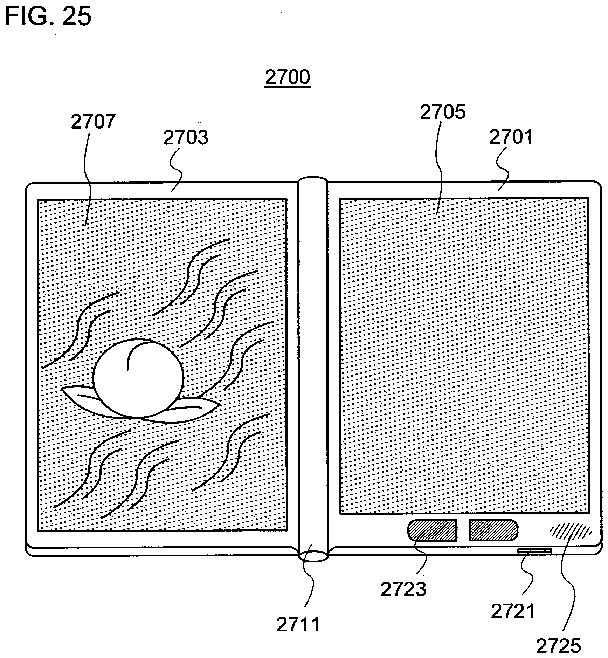

A semiconductor device disclosed in this specification can be applied to an electronic paper. An electronic paper can be used for electronic devices of a variety of fields as long as they can display data. For example, an electronic paper can be applied to an e-book reader (electronic book), a poster, an advertisement in a vehicle such as a train, displays of various cards such as a credit card, and the like. An example of the electronic device is illustrated in FIG. 25.

FIG. 25 illustrates an example of an e-book reader. For example, an e-book reader 2700 includes two housings, a housing 2701 and a housing 2703. The housing 2701 and the housing 2703 are combined with a hinge 2711 so that the e-book reader 2700 can be opened and closed with the hinge 2711 as an axis. With such a structure, the e-book reader 2700 can operate like a paper book.

A display portion 2705 and a display portion 2707 are incorporated in the housing 2701 and the housing 2703, respectively. The display portion 2705 and the display portion 2707 may display one image or different images. In the case where the display portion 2705 and the display portion 2707 display different images, for example, text can be displayed on a display portion on the right side (the display portion 2705 in FIG. 25) and graphics can be displayed on a display portion on the left side (the display portion 2707 in FIG. 25).

FIG. 25 illustrates an example in which the housing 2701 is provided with an operation portion and the like. For example, the housing 2701 is provided with a power switch 2721, an operation key 2723, a speaker 2725, and the like. With the operation key 2723, pages can be turned. Note that a keyboard, a pointing device, or the like may be provided on the surface of the housing, on which the display portion is provided. Furthermore, an external connection terminal (an earphone terminal, a USB terminal, a terminal that can be connected to various cables such as an AC adapter and a USB cable, or the like), a recording medium insertion portion, and the like may be provided on the back surface or the side surface of the housing. Moreover, the e-book reader 2700 may have a function of an electronic dictionary.

The e-book reader 2700 may have a configuration capable of wirelessly transmitting and receiving data. Through wireless communication, desired book data or the like can be purchased and downloaded from an electronic book server.

[Embodiment 8]

A semiconductor device disclosed in this specification can be applied to a variety of electronic devices (including game machines). Examples of the electronic devices include television sets (also referred to as televisions or television receivers), monitor of computers or the like, cameras such as digital cameras or digital video cameras, digital photo frames, mobile phones (also referred to as mobile telephones or mobile phone sets), portable game consoles, portable information terminals, audio reproducing devices, large-sized game machines such as pachinko machines, and the like.

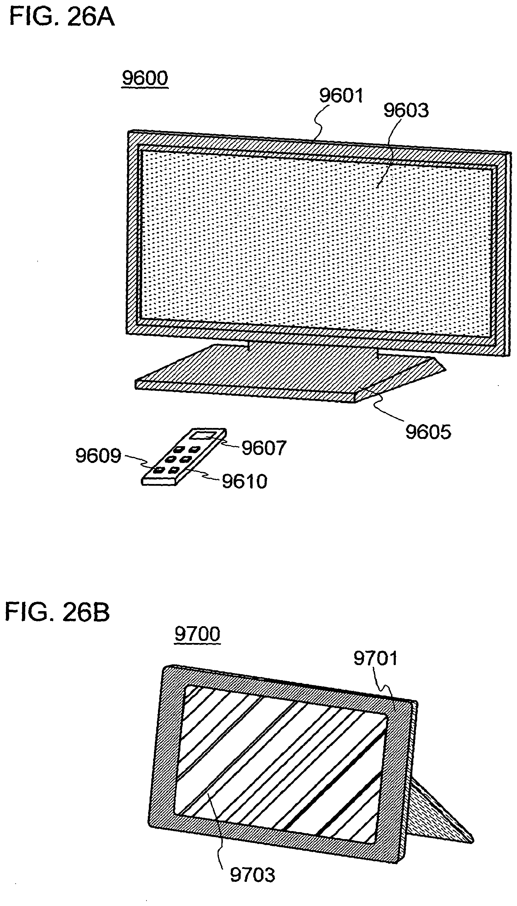

FIG. 26A illustrates an example of a television set. In a television set 9600, a display portion 9603 is incorporated in a housing 9601. The display portion 9603 can display images. Here, the housing 9601 is supported by a stand 9605.

The television set 9600 can be operated with an operation switch of the housing 9601 or a separate remote controller 9610. Channels and volume can be controlled with an operation key 9609 of the remote controller 9610 so that an image displayed on the display portion 9603 can be controlled. Furthermore, the remote controller 9610 may be provided with a display portion 9607 for displaying data output from the remote controller 9610.

Note that the television set 9600 is provided with a receiver, a modem, and the like. With the use of the receiver, general television broadcasting can be received. Moreover, when the television set is connected to a communication network with or without wires via the modem, one-way (from a sender to a receiver) or two-way (between a sender and a receiver or between receivers) data communication can be performed.

FIG. 26B illustrates an example of a digital photo frame. For example, in a digital photo frame 9700, a display portion 9703 is incorporated in a housing 9701. The display portion 9703 can display a variety of images. For example, the display portion 9703 can display data of an image taken with a digital camera or the like and function as a normal photo frame

Note that the digital photo frame 9700 is provided with an operation portion, an external connection portion (a USB terminal, a terminal that can be connected to various cables such as a USB cable, or the like), a recording medium insertion portion, and the like. Although these components may be provided on the surface on which the display portion is provided, it is preferable to provide them on the side surface or the back surface for the design of the digital photo frame 9700. For example, a memory storing data of an image taken with a digital camera is inserted in the recording medium insertion portion of the digital photo frame, whereby the image data can be transferred and then displayed on the display portion 9703.

The digital photo frame 9700 may be configured to transmit and receive data wirelessly. The structure may be employed in which desired image data is transferred wirelessly to be displayed.

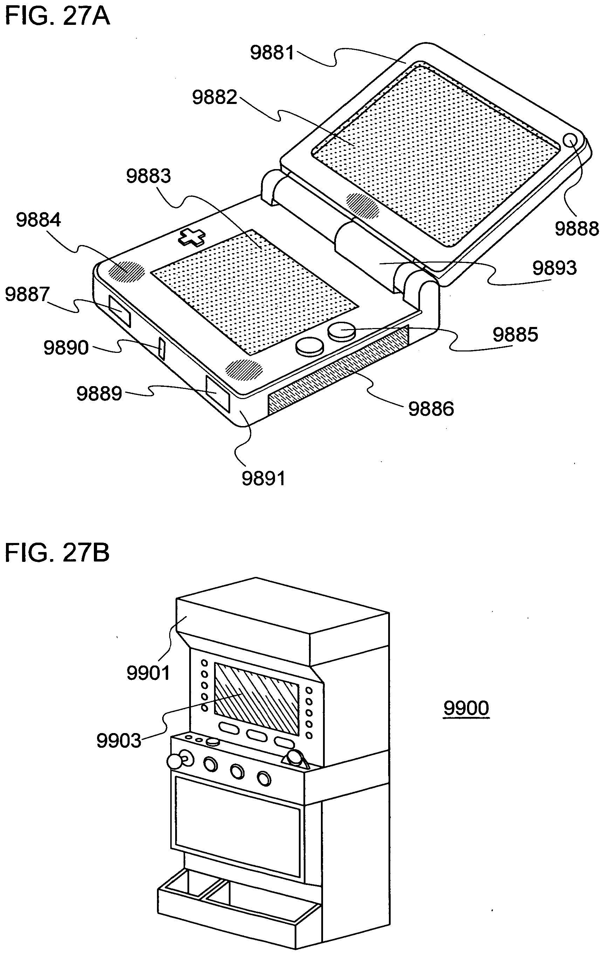

FIG. 27A is a portable game machine including two housings, a housing 9881 and a housing 9891. The housings 9881 and 9891 are connected with a connection portion 9893 so that the portable game machine can be opened and closed. A display portion 9882 and a display portion 9883 are incorporated in the housing 9881 and the housing 9891, respectively. In addition, the portable game machine illustrated in FIG. 27A includes a speaker portion 9884, a recording medium insertion portion 9886, an LED lamp 9890, an input means (an operation key 9885, a connection terminal 9887, a sensor 9888 (a sensor having a function of measuring force, displacement, position, speed, acceleration, angular velocity, rotational frequency, distance, light, liquid, magnetism, temperature, chemical substance, sound, time, hardness, electric field, current, voltage, electric power, radiation, flow rate, humidity, gradient, oscillation, odor, or infrared rays), or a microphone 9889), and the like. It is needless to say that the structure of the portable game machine is not limited to the above and other structures provided with at least a semiconductor device disclosed in this specification can be employed. The portable game machine may include other accessory equipment as appropriate. The portable game machine illustrated in FIG. 27A has a function of reading a program or data stored in a recording medium to display it on the display portion, and a function of sharing information with another portable game machine by wireless communication. The portable game machine illustrated in FIG. 27A can have various functions without limitation to the above.

FIG. 27B illustrates an example of a slot machine which is a large-sized game machine. In a slot machine 9900, a display portion 9903 is incorporated in a housing 9901. In addition, the slot machine 9900 includes an operation means such as a start lever or a stop switch, a coin slot, a speaker, and the like. It is needless to say that the structure of the slot machine 9900 is not limited to the above and other structures provided with at least a semiconductor device disclosed in this specification may be employed. The slot machine 9900 may include other accessory equipment as appropriate.

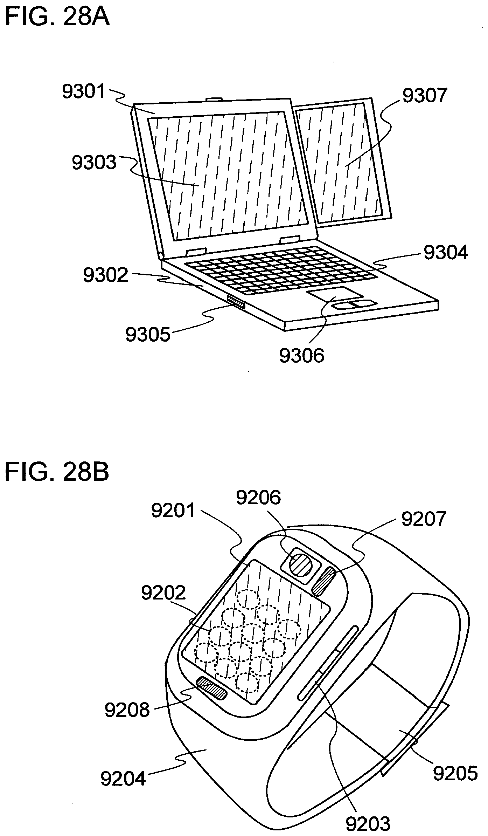

FIG. 28A is a perspective view illustrating an example of a portable computer.

In the portable computer illustrated in FIG. 28A, a top housing 9301 having a display portion 9303 and a bottom housing 9302 having a keyboard 9304 can overlap with each other by closing a hinge unit which connects the top housing 9301 and the bottom housing 9302. Thus, the portable computer illustrated in FIG. 28A is conveniently carried. Moreover, in the case of using the keyboard for input of data, the hinge unit is opened so that a user can input data looking at the display portion 9303.

The bottom housing 9302 includes a pointing device 9306 with which input can be performed, in addition to the keyboard 9304. Further, when the display portion 9303 is a touch panel, input can be performed by touching part of the display portion. The bottom housing 9302 includes an arithmetic function portion such as a CPU or hard disk. In addition, the bottom housing 9302 includes an external connection port 9305 into which another device, for example, a communication cable conformable to communication standards of a USB is inserted.

The top housing 9301, which further includes a display portion 9307 and can keep the display portion 9307 therein by sliding it toward the inside of the top housing 9301, can have a large display screen. In addition, the user can adjust the orientation of a screen of the display portion 9307 which can be kept in the top housing 9301. When the display portion 9307 which can be kept in the top housing 9301 is a touch panel, input can be performed by touching part of the display portion 9307 which can be kept in the top housing 9301.

The display portion 9303 or the display portion 9307 which can be kept in the top housing 9301 is formed using an image display device such as a liquid crystal display panel or a light-emitting display panel, e.g., an organic light-emitting element or an inorganic light-emitting element.

In addition, the portable computer in FIG. 28A can be provided with a receiver and the like and can receive a television broadcast to display an image on the display portion 9303 or the display portion 9307. The user can watch a television broadcast by adjusting the screen angle when the whole screen of the display portion 9307 is exposed by sliding the display portion 9307 while the hinge unit which connects the top housing 9301 and the bottom housing 9302 is kept closed. In this case, the hinge unit is not opened and display is not performed on the display portion 9303. In addition, start up of only a circuit for displaying a television broadcast is performed. Therefore, power consumption can be the minimum, which is useful for the portable computer whose battery capacity is limited.

FIG. 28B is a perspective view illustrating an example of a mobile phone that the user can wear on the wrist like a wristwatch.

This mobile phone is formed with a main body which includes a communication device including at least a telephone function, and a battery; a band portion which enables the main body to be worn on the wrist; an adjusting portion 9205 for adjusting the fixation of the band portion to the wrist; a display portion 9201; a speaker 9207; and a microphone 9208.

In addition, the main body includes operation switches 9203. The operation switches 9203 can serve, for example, as a switch for starting a program for the Internet when pushed, in addition to serving as a power switch, a switch for switching displays, a switch for instruction to start taking images, or the like.

Input to this mobile phone is performed by touching the display portion 9201 with a finger or an input pen, operating the operating switches 9203, or inputting voice into the microphone 9208. In FIG. 28B, input can be performed by touching the display buttons 9202 displayed in the display portion 9201 with a finger or the like.

Further, the main body includes a camera portion 9206 including an image pick-up means which converts an image of an object, which is formed through a camera lens, to an electronic image signal. Note that the camera portion is not necessarily provided.

The mobile phone illustrated in FIG. 28B may be provided with a receiver of a television broadcast and the like, and thus can display an image on the display portion 9201 by receiving a television broadcast. In addition, the mobile phone illustrated in FIG. 28B may be provided with a storage device such as a memory and the like, and thus can record a television broadcast in the memory. The mobile phone illustrated in FIG. 28B may have a function of collecting location information, such as GPS.

An image display device such as a liquid crystal display panel or a light-emitting display panel, e.g., an organic light-emitting element or an inorganic light-emitting element is used as the display portion 9201. The mobile phone illustrated in FIG. 28B is compact and lightweight and the battery capacity is limited. For the above reason, a panel which can be driven with low power consumption is preferably used as a display device for the display portion 9201.

Note that FIG. 28B illustrates the electronic device which is worn on the wrist; however, this embodiment is not limited thereto as long as a portable shape is employed.

[Example 1]

Thin film transistors were manufactured by the manufacturing method described in Embodiment 1, and the characteristics of the thin film transistors in environments at room temperature (25 °C) to 180 °C were evaluated. The results of the evaluation are described in this example.

In this example, a thin film transistor with a channel length $L$ of 3 $\mu$m, a thin film transistor with a channel length $L$ of 5 $\mu$m, and a thin film transistor with a channel length L of 10 $\mu$m were manufactured over one substrate, and the characteristics of the thin film transistors in environments at room temperature to 180 °C were evaluated. Note that the channel width $W$ was 20 $\mu$m in each thin film transistor. First, a method for manufacturing the thin film transistor is described.

First, a silicon oxynitride film with a thickness of 100 nm was formed as a base film over a glass substrate by a CVD method, and a tungsten film with a thickness of 150 nm was formed for a gate electrode layer over the silicon oxynitride film by a sputtering method. The tungsten film was etched selectively, thereby forming the gate electrode layer.

Then, as a gate insulating layer, a silicon oxynitride film with a thickness of 100 nm was formed over the gate electrode layer by a CVD method.

Next, an oxide semiconductor layer with a thickness of 50 nm was formed over the gate insulating layer using an In-Ga-Zn-O-based oxide semiconductor target ($In_2O_3 : Ga_2O_3 : ZnO = 1 : 1 : 1$) by film formation at room temperature (25 °C) in an atmosphere containing argon and oxygen (argon : oxygen = 30 sccm : 15 sccm) under the following conditions: the distance between the substrate and the target was 60 mm, the pressure was 0.4 Pa, and the direct current (DC) power supply was 0.5 kW. The oxide semiconductor layer was etched selectively, thereby forming an island-like oxide semiconductor layer.

Next, first heat treatment was performed on the oxide semiconductor layer at 450 °C for 1 hour in a nitrogen atmosphere.

Then, for source and drain electrode layers, a conductive film in which a titanium film (with a thickness of 50 nm), an aluminum film (with a thickness of 100 nm), and a titanium film (with a thickness of 50 nm) were stacked was formed over the oxide semiconductor layer at room temperature (25 °C) by a sputtering method. The conductive film was etched selectively to form the source and drain electrode layers. In this manner, the thin film transistor with a channel length $L$ of 3 $\mu$m, the thin film transistor with a channel length $L$ of 5 $\mu$m, and the thin film transistor with a channel length $L$ of 10 $\mu$m, each of which had a channel width $W$ of 20 $\mu$m, were manufactured.

Next, a silicon oxide film with a thickness of 300 nm was formed at 100 °C as a protective insulating layer by a sputtering method so as to be in contact with the oxide semiconductor layer. The silicon oxide film serving as a protective layer was etched selectively, whereby openings were formed over the gate electrode layer and the source and drain electrode layers.

As an electrode layer for measurement, a titanium film (with a thickness of 50 nm), an aluminum film (with a thickness of 100 nm), and a titanium film (with a thickness of 5 nm) were stacked at room temperature (25 °C) by a sputtering method. The electrode layer for measurement was etched selectively, so that an electrode layer for measurement which was electrically connected to the gate electrode layer through the opening, an electrode layer for measurement which was electrically connected to the source electrode layer through the opening, and an electrode layer for measurement which was electrically connected to the drain electrode layer through the opening were formed. After that, second heat treatment was performed at 250 °C for one hour in a nitrogen atmosphere.

Through the above process, the thin film transistor with a channel length $L$ of 3 $\mu$m, the thin film transistor with a channel length $L$ of 5 $\mu$m, and the thin film transistor with a channel length $L$ of 10 $\mu$m, each of which had a channel width $W$ of 20 $\mu$m, were manufactured over one substrate.

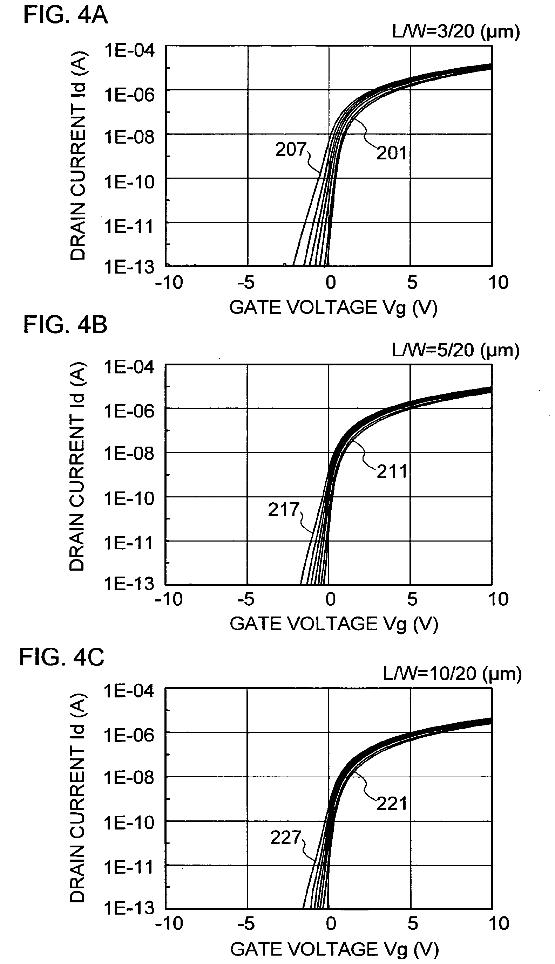

Then, current vs. voltage characteristics of each thin film transistor were measured. FIGS. 4A to 4C each show Vg-Id curves showing a change in current (hereinafter referred to as drain current or Id) flowing between a source and a drain with respect to a change in voltage (hereinafter referred to as gate voltage or Vg) between the source and a gate of the thin film transistor. FIG. 4A shows Vg-Id curves of the thin film transistor with a channel length L of 3 $\mu$m. FIG. 4B shows Vg-Id curves of the thin film transistor with a channel length L of 5 $\mu$m. FIG. 4C shows Vg-Id curves of the thin film transistor with a channel length L of 10 $\mu$m. In each of FIGS. 4A to 4C, gate voltage is plotted on a linear scale on the horizontal axis and drain current is plotted on a logarithmic scale on the vertical axis.

Current vs. voltage characteristics were measured by setting the voltage between the source and the drain to 10 V and by changing the gate voltage from -20 V to 20 V. In addition, the substrate temperature in measurement was changed in the following manner: room temperature (25 °C), 40 °C, 75 °C, 100 °C, 125 °C, 150 °C, and 180 °C. Current vs. voltage characteristics at each substrate temperature (operation temperature) were measured. Note that FIGS. 4A to 4C each show only the gate voltage from -10 V to 10 V for easy understanding of a relation between the substrate temperature in measurement and the Vg-Id curve.

A curve 201 in FIG. 4A, a curve 211 in FIG. 4B, and a curve 221 in FIG. 4C each show a Vg-Id curve when the substrate temperature in measurement is room temperature (25 °C). As the substrate temperature in measurement is increased, the Vg-Id curve sequentially shifts in a left direction in each of FIGS. 4A to 4C, that is, in a negative direction of Vg, which means that the transistor becomes normally on. For avoiding complication in the drawings, not all the Vg-Id curves are denoted by reference numerals; a curve 207, a curve 217, and a curve 227 positioned on the leftmost side are Vg-Id curves when the substrate temperature in measurement is 180 °C.

The threshold voltage of each transistor was calculated from the Vg-Id curves obtained. Although not described in detail in this specification, the maximum value of field effect mobility which is calculated while assuming the relative dielectric constant of the gate insulating layer to be 4.1 is greater than or equal to 20 cm$^2$/Vs under all the measurement conditions described above.

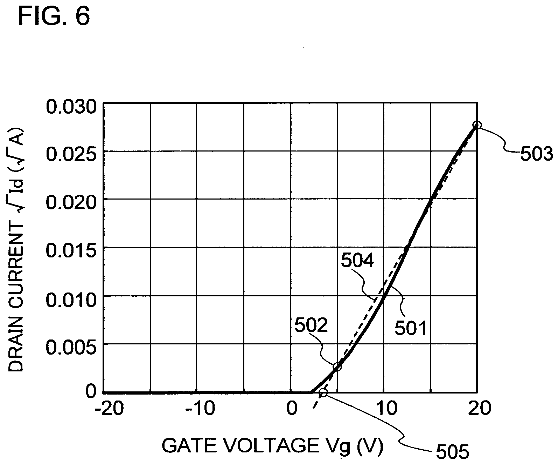

Definition of Vth in this specification is described below. In FIG. 6, gate voltage is plotted on a linear scale on the horizontal axis, and a square root of drain current (hereinafter also referred to as √Id) is plotted on a linear scale on the vertical axis. A curve 501 represents a square root of drain current with respect to a change in gate voltage and shows Id of a Vg-Id curve obtained by setting Vd to 10 V with its square root (such a Vd-Id curve is hereinafter also referred to as a √Id curve).

First, a √Id curve (the curve 501) is obtained from the Vg-Id curve obtained by measurement in which Vd is set to 10 V. Then, a straight line 504 which has a point 502 where Vg of the √Id curve is 5 V and a point 503 where Vg is 20 V is obtained. The straight line 504 is extended, and Vg at a point where Id is 0 A on the straight line 504, that is, a value at an intercept 505 of the straight line 504 and the gate voltage axis is defined as Vth.

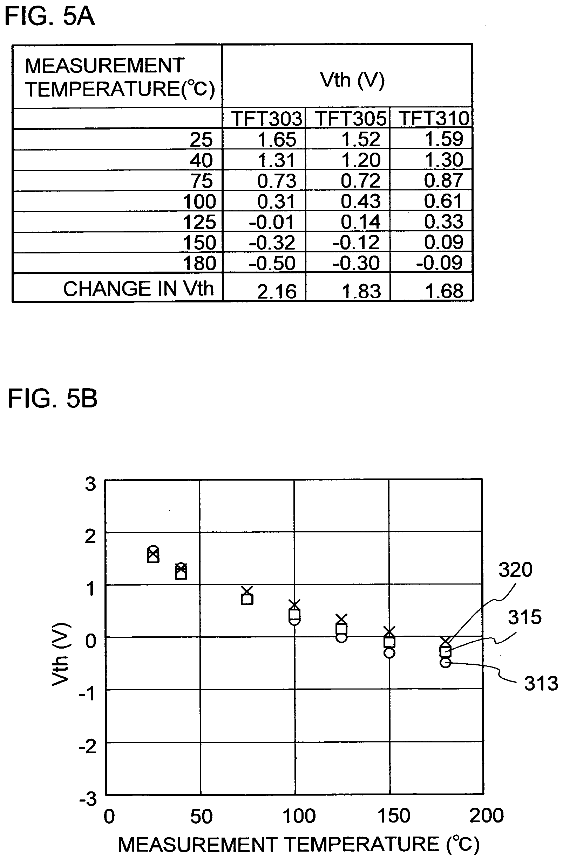

FIG 5A is a table showing Vth obtained from the Vg-Id curves in FIGS. 4A to 4C. In FIG. 5A, a column of a TFT 303 shows Vth of the thin film transistor with a channel length L of 3 μm, a column of a TFT 305 shows Vth of the thin film transistor with a channel length L of 5 μm, and a column of a TFT 310 shows Vth of the thin film transistor with a channel length L of 10 μm. In addition, the change in Vth in the bottom cell is a difference between the maximum value of Vth and the minimum value of Vth within the measurement temperature range of each thin film transistor.

FIG. 5B shows a graph based on FIG. 5A. The measurement temperature on the horizontal axis is the substrate temperature (operation temperature) in measuring current vs. voltage characteristics of the thin film transistor, and Vth on the vertical axis is a threshold voltage at each substrate temperature. A threshold voltage 313 represented by "open circle" is a threshold voltage of the thin film transistor whose channel length L is 3 μm. A threshold voltage 315 represented by "open square" is a threshold voltage of the thin film transistor whose channel length L is 5 μm. A threshold voltage 320 represented by "cross" is a threshold voltage of the thin film transistor whose channel length L is 10 μm.

It was confirmed that the amount of change in threshold voltage of the thin film transistor manufactured in this example is less than or equal to 3 V in environments at room temperature to 180 °C inclusive.

[Example 2]

Thin film transistors were manufactured by the manufacturing method described in Embodiment 1, and the characteristics of the thin film transistors in environments at -25 °C to 150 °C were evaluated. The results of the evaluation are described in this example.

In this example, a thin film transistor with a channel length L of 3 μm and a channel width W of 50 μm and a thin film transistor with a channel length L of 20 μm and a channel width W of 20 μm were manufactured over one substrate, and the characteristics of the thin film transistors in environments at -25 °C to 150 °C inclusive were evaluated. First, a method for manufacturing the thin film transistors is described.

First, a silicon oxynitride film with a thickness of 100 nm was formed as a base film over a glass substrate by a CVD method, and a tungsten film with a thickness of 150 nm was formed for a gate electrode layer over the silicon oxynitride film by a sputtering method. The tungsten film was etched selectively, thereby forming the gate electrode layer.

Then, as a gate insulating layer, a silicon oxynitride film with a thickness of 100 nm was formed over the gate electrode layer by a CVD method.

Next, an oxide semiconductor layer with a thickness of 50 nm was formed over the gate insulating layer using an In-Ga-Zn-O-based oxide semiconductor target ($In_2O_3$ : $Ga_2O_3$ : ZnO = 1 : 1 : 1) by film formation at room temperature (25 °C) in an atmosphere containing argon and oxygen (argon : oxygen = 30 sccm : 15 sccm) under the following conditions: the distance between the substrate and the target was 60 mm, the pressure was 0.4 Pa, and the direct current (DC) power supply was 0.5 kW. The oxide semiconductor layer was etched selectively, thereby forming an island-like oxide semiconductor layer.

Next, first heat treatment was performed on the oxide semiconductor layer at 450 °C for one hour in a nitrogen atmosphere.

Then, for source and drain electrode layers, a conductive film in which a titanium film (with a thickness of 100 nm), an aluminum film (with a thickness of 200 nm), and a titanium film (with a thickness of 50 nm) were stacked was formed over the oxide semiconductor layer by a sputtering method at room temperature (25 °C). The conductive film was etched selectively to form the source and drain electrode layers, so that the thin film transistor with a channel length L of 3 μm and a channel width W of 50 μm and the thin film transistor with a channel length L of 20 μm and a channel

width $W$ of 20 $\mu$m were manufactured.

Next, a silicon oxide film having a thickness of 300 nm was formed by a sputtering method at 100 °C as a protective insulating layer so as to be in contact with the oxide semiconductor layer. The silicon oxide film serving as a protective layer was etched selectively, whereby openings were formed over the gate electrode layer and the source and drain electrode layers.

Next, as an electrode layer for measurement, an ITO film (with a thickness of 110 nm) was formed at room temperature (25 °C) by a sputtering method. The electrode layer for measurement was etched selectively, so that an electrode layer for measurement which was electrically connected to the gate electrode layer through the opening, an electrode layer for measurement which was electrically connected to the source electrode layer through the opening, and an electrode layer for measurement which was electrically connected to the drain electrode layer through the opening were formed. After that, second heat treatment was performed at 250 °C for one hour in a nitrogen atmosphere.

Through the above process, the thin film transistor with a channel length $L$ of 3 $\mu$m and a channel width $W$ of 50 $\mu$m and the thin film transistor with a channel length $L$ of 20 $\mu$m and a channel width $W$ of 20 $\mu$m were manufactured over one substrate.

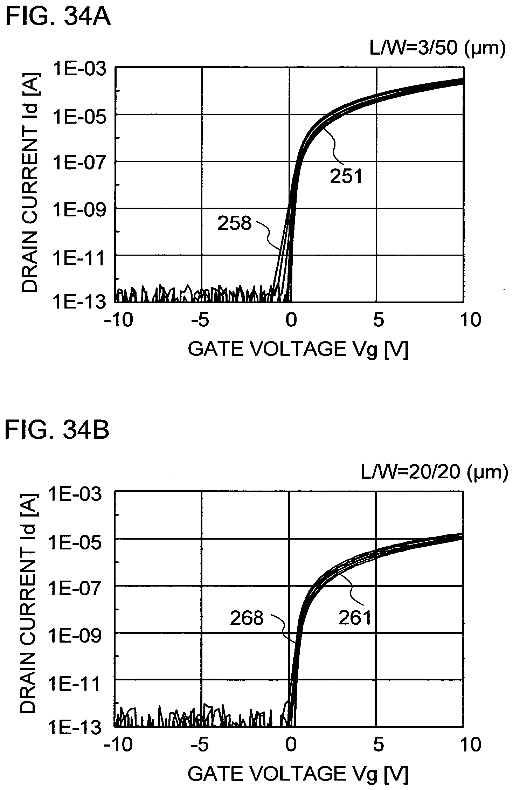

Then, current vs. voltage characteristics of the thin film transistors were measured. FIGS. 34A and 34B each show Vg-Id curves showing a change in current (hereinafter referred to as drain current or Id) flowing between a source and a drain with respect to a change in voltage (hereinafter referred to as gate voltage or Vg) between the source and a gate of the thin film transistor. FIG. 34A shows Vg-Id curves of the thin film transistor with a channel length $L$ of 3 $\mu$m and a channel width $W$ of 50 $\mu$m, and FIG. 34B shows Vg-Id curves of the thin film transistor with a channel length $L$ of 20 $\mu$m and a channel width $W$ of 20 $\mu$m. In each of FIGS. 34A and 34B, gate voltage is plotted on a linear scale on the horizontal axis and drain current is plotted on a logarithmic scale on the vertical axis.

Current vs. voltage characteristics were measured by setting the voltage between the source and the drain to 10 V and by changing the gate voltage from -20 V to 20 V. In addition, the substrate temperature in measurement was changed in the following manner: -25 °C, 0 °C, room temperature (25 °C), 40 °C, 85 °C, 100 °C, 125 °C, and 150 °C. Current vs. voltage characteristics at each substrate temperature (operation temperature) were measured. Note that FIGS. 34A and 34B each show only the gate voltage from -10 V to 10 V for easy understanding of a relation between the substrate temperature in measurement and the Vg-Id curve.

A curve 251 in FIGS. 34A and a curve 261 in FIG. 34B each show a Vg-Id curve when the substrate temperature in measurement is -25 °C. As the substrate temperature in measurement is increased, the Vg-Id curve sequentially shifts in a left direction in FIGS. 34A and 34B, that is, in a negative direction of Vg. In particular, in FIG. 34A, as the substrate temperature in measurement is increased, the transistor tends to be changed from normally-off type (in which Id scarcely flows when Vg is 0 V) to normally-on type. For avoiding complication in the drawings, not all the Vg-Id curves are denoted by reference numerals; a curve 258 and a curve 268 positioned on the leftmost side are Vg-Id curves when the substrate temperature in measurement is 150 °C.

In FIGS. 34A and 34B, Id has a value of less than or equal to $1 \times 10^{12}$ A in a region where Vg is negative. This is noise generated in the measurement. Note that this noise does not influence the calculation of Vth.

Vth of each transistor was calculated by a method similar to that of Example 1 from the Vg-Id curve obtained.

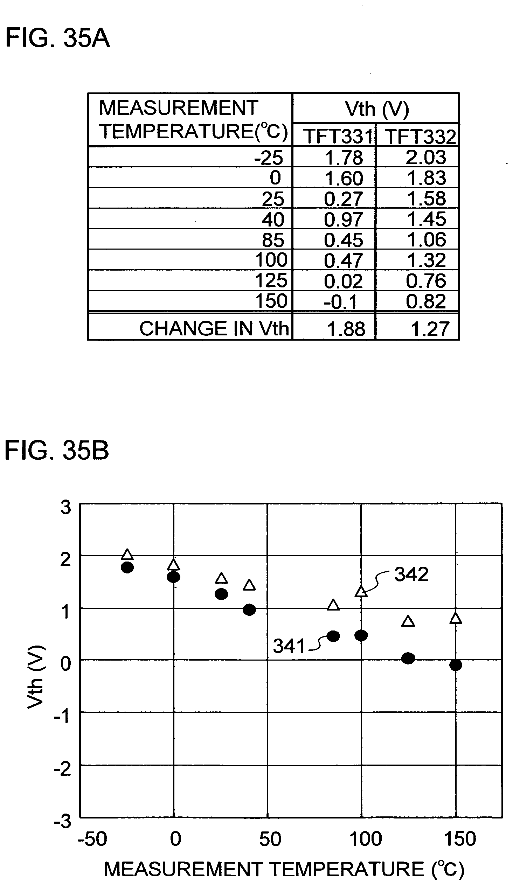

FIG. 35A is a table showing Vth obtained from the Vg-Id curves in FIGS. 34A and 34B. In FIG. 35A, a column of a TFT 331 shows Vth of the thin film transistor with a channel length $L$ of 3 $\mu$m and a channel width $W$ of 50 $\mu$m, and a column of a TFT 332 shows Vth of the thin film transistor with a channel length $L$ of 20 $\mu$m and a channel width $W$ of 20 $\mu$m. In addition, the amount of change in Vth in the bottom cell is a difference between the maximum value of Vth and the minimum value of Vth within the measurement temperature range of each thin film transistor.

FIG. 35B shows a graph based on FIG. 35A. The measurement temperature on the horizontal axis is the substrate temperature (operation temperature) in measuring current vs. voltage characteristics of the thin film transistor, and Vth on the vertical axis is a threshold voltage at each substrate temperature. A threshold voltage 341 represented by "black circle" is a threshold voltage of the thin film transistor whose channel length $L$ is 3 $\mu$m and whose channel width W is 50 $\mu$m. A threshold voltage 342 represented by "open triangle" is a threshold voltage of the thin film transistor whose channel length $L$ is 20 $\mu$m and whose channel width $W$ is 20 $\mu$m.

It was confirmed that the amount of change in threshold voltage of the thin film transistor manufactured in this example is less than or equal to 2 V in environments at -25 °C to 150 °C inclusive.

This application is based on Japanese Patent Application serial No. 2009-215077 filed with Japan Patent Office on September 16, 2009 and Japanese Patent Application serial No. 2010-035349 filed with Japan Patent Office on February 19, 2010.

[EXPLANATION OF REFERENCE]

10: pulse output circuit, 11: first wiring, 12, second wiring, 13: third wiring, 14: fourth wiring, 15: fifth wiring, 21: first input terminal, 22: second input terminal, 23: third input terminal, 24: fourth input terminal, 25: fifth input terminal, 26: first output terminal, 27: second output terminal, 28: thin film transistor, 31: first transistor, 32: second transistor, 33: third transistor, 34: fourth transistor, 35: fifth transistor, 36: sixth transistor, 37: seventh transistor, 38: eighth transistor, 39: ninth transistor, 40: tenth transistor, 41: eleventh transistor, 42: twelfth transistor, 43: thirteenth transistor, 51: power supply line, 52: power supply line, 53: power supply line, 61: period, 62: period, 100: substrate, 101: gate electrode layer, 102: gate insulating layer, 103: oxide semiconductor layer, 107: protective insulating layer, 110: channel protective layer, 150: thin film transistor, 160: thin film transistor, 170: thin film transistor, 180: thin film transistor, 201: curve, 207: curve, 211: curve, 217: curve, 221: curve, 227: curve, 251: curve, 258: curve, 261: curve, 268: curve, 303: TFT, 305: TFT, 310: TFT, 313: value, 315: value, 320: value, 331: TFT, 332: TFT, 341: value, 342: value, 400: glass substrate, 401: oxynitride insulating layer, 402: In-Ga-Zn-O-based oxide semiconductor layer, 403: analysis direction, 411: oxygen ionic strength profile, 412: hydrogen concentration profile, 413: hydrogen concentration profile, 501: curve, 502: point, 503: point, 504: straight line, 505: intercept, 580: substrate, 581: thin film transistor, 583: insulating film, 585: insulating layer, 587: first electrode layer, 588: second electrode layer, 589: spherical particle, 594: cavity, 595: filler, 596: substrate, 600: substrate, 601: counter substrate, 602: gate wiring, 603: gate wiring, 604: capacitor wiring, 605: capacitor wiring, 606: gate insulating film, 616: wiring, 617: capacitor wiring, 618: wiring, 619: wiring, 620: insulating film, 622: insulating film, 623: contact hole, 624: pixel electrode layer, 625: slit, 626: pixel electrode layer, 627: contact hole, 628: TFT, 629: TFT, 630: storage capacitor portion, 631: storage capacitor portion, 636: coloring film, 637: planarization film, 640: counter electrode layer, 641: slit, 644: projection, 646: alignment film, 648: alignment film, 650: liquid crystal layer, 651: liquid crystal element, 652: liquid crystal element, 690: capacitor wiring, 701: gate electrode layer, 702: gate insulating layer, 703: channel, 801: glass substrate, 802: gate electrode layer, 803: gate insulating layer, 804: oxide semiconductor layer, 805: source electrode layer, 806: drain electrode layer, 811: curve, 818: curve, 821: curve, 828: curve, 831: curve, 832: curve, 833: curve, 850: thin film transistor, 911: curve, 918: curve, 2600: TFT substrate, 2601: counter substrate, 2602: sealant, 2603: pixel portion, 2604: display element, 2605: coloring layer, 2606: polarizing plate, 2607: polarizing plate, 2608: wiring circuit portion, 2609: flexible wiring board, 2610: cold cathode tube, 2611: reflective plate, 2612: circuit substrate, 2613: diffusion plate, 2700: e-book reader, 2701: housing, 2703: housing, 2705: display portion, 2707: display portion, 2711: hinge, 2721: power switch, 2723: operation key, 2725: speaker, 4001: first substrate, 4002: pixel portion, 4003: signal line driver circuit, 4004: scan line driver circuit, 4005: sealant, 4006: second substrate, 4008: liquid crystal layer, 4010: thin film transistor, 4011: thin film transistor, 4013; liquid crystal element, 4015: connection terminal electrode, 4016: terminal electrode, 4018: FPC, 4019: anisotropic conductive film, 4020: insulating layer, 4021: insulating layer, 4030: pixel electrode layer, 4031: counter electrode layer, 4032: insulating layer, 4040: conductive layer, 4501: first substrate, 4502: pixel portion, 4505: sealant, 4506: second substrate, 4507: filler, 4509: thin film transistor, 4510: thin film transistor, 4511: light-emitting element, 4512: electroluminescent layer, 4513: second electrode layer, 4515: connection terminal electrode, 4516: terminal electrode, 4517: first electrode layer, 4519: anisotropic conductive film, 4520: partition, 4540: conductive layer, 4541: insulating layer, 4544: insulating layer, 5300: substrate, 5301: pixel portion, 5302: first scan line driver circuit, 5302: second scan line driver circuit, 5304: signal line driver circuit, 5305: timing control circuit, 5601: shift register, 5602: switching circuit, 5603: thin film transistor, 5604: wiring, 5605: wiring, 6400: pixel, 6401: switching transistor, 6402: transistor for driving light-emitting element, 6403: capacitor, 6404: light-emitting element, 6405: signal line, 6406: scan line, 6407: power supply line, 6408: common electrode, 7001: TFT, 7002: light-emitting element, 7003: cathode, 7004: EL layer, 7005: anode, 7009: partition, 7011: TFT, 7012: light-emitting element, 7013: cathode, 7014: EL layer, 7015: anode, 7016: light-blocking film, 7017: conductive film, 7019: partition, 7021: TFT, 7022: light-emitting element, 7023: cathode, 7024: EL layer, 7025: anode, 7027: conductive film, 7029: partition, 7031: oxide insulating layer, 7033: color filter layer, 7034: overcoat layer, 7035: protective insulating layer, 7041: oxide insulating layer, 7043: color filter layer, 7044: overcoat layer, 7045: protective insulating layer, 7051: oxide insulating layer, 7053: planarization insulating layer, 7055: insulating layer, 9201: display portion, 9202: display button, 9203: operation switch, 9205: adjusting portion, 9206: camera portion, 9207: speaker, 9208: microphone, 9301: upper housing, 9302: lower housing, 9303: display portion, 9304: keyboard, 9305: external connection port, 9306: pointing device, 9307: display portion, 9600: television set, 9601: housing, 9603: display portion, 9605: stand, 9607: display portion, 9609: operation key, 9610: remote controller, 9700: digital photo frame, 9701: housing, 9703: display portion, 9881: housing, 9882: display portion, 9883: display portion, 9884: speaker portion, 9886: recording medium insertion portion, 9887: connection terminal, 9888: sensor, 9889: microphone, 9890: LED lamp, 9891: housing, 9893: connection portion, 9900: slot machine, 9901: housing, 9903: display portion, 105a: source electrode layer, 105b: drain electrode layer, 4503a: signal line driver circuit, 4504a: scan line driver circuit, 4518a: FPC, 590a: black region, 590b: white region, 704a: drain electrode layer, 704b: source electrode layer, 705a: $N^+$ region, 705b: $N^+$ region

**Claims**

1.  A method for manufacturing a semiconductor device, comprising the steps of:

forming a gate electrode layer (101) over a substrate (100) having an insulating surface;
forming a gate insulating layer (102) over the gate electrode layer;
forming an oxide semiconductor layer (103) over the gate insulating layer;
performing a first heat treatment after forming the oxide semiconductor layer;
forming a source electrode layer (105a) and a drain electrode layer (105b) over the oxide semiconductor layer;
forming a protective insulating layer (107) in contact with a part of the oxide semiconductor layer, the source electrode layer, and the drain electrode layer; and
performing a second heat treatment after forming the protective insulating layer,
wherein the second heat treatment is performed at a lower temperature than the first heat treatment,
wherein the oxide semiconductor layer comprises silicon oxide, and
wherein the semiconductor device is configured in such a way that an amount of change in threshold voltage is less than or equal to 3 V in a temperature range of room temperature to 180 °C or in a temperature range of -25 °C to 150 °C.

2. The method for manufacturing a semiconductor device according to claim 1, wherein a channel length of the oxide semiconductor layer is greater than or equal to 1.5 $\mu$m and less than or equal to 100 $\mu$m.

3. The method for manufacturing a semiconductor device according to claim 1, wherein the first heat treatment is performed at a temperature of greater than or equal to 350 °C and less than or equal to 750 °C.

4. The method for manufacturing a semiconductor device according to claim 1, wherein the first heat treatment is performed in a nitrogen atmosphere or a rare gas atmosphere.

5. The method for manufacturing a semiconductor device according to claim 1, wherein the second heat treatment is performed at a temperature of greater than or equal to 100 °C and less than or equal to the temperature of the first heat treatment.

6. The method for manufacturing a semiconductor device according to claim 1, wherein the second heat treatment is performed in air, an oxygen atmosphere, a nitrogen atmosphere, or a rare gas atmosphere.

**Patentansprüche**

1. Verfahren zum Herstellen einer Halbleitervorrichtung, das die folgenden Schritte umfasst:

Ausbilden einer Gate-Elektrodenschicht (101) über einem Substrat (100) mit einer isolierenden Oberfläche;
Ausbilden einer Gate-Isolierschicht (102) über der Gate-Elektrodenschicht;
Ausbilden einer Oxidhalbleiterschicht (103) über der Gate-Isolierschicht;
Durchführen einer ersten Wärmebehandlung nach dem Ausbilden der Oxidhalbleiterschicht;
Ausbilden einer Source-Elektrodenschicht (105a) und einer Drain-Elektrodenschicht (105b) über der Oxidhalbleiterschicht;
Ausbilden einer Schutzisolierschicht (107) in Kontakt mit einem Teil der Oxidhalbleiterschicht, der Source-Elektrodenschicht und der Drain-Elektrodenschicht; und
Durchführen einer zweiten Wärmebehandlung nach dem Ausbilden der Schutzisolierschicht,
wobei die zweite Wärmebehandlung bei einer niedrigeren Temperatur als die erste Wärmebehandlung durchgeführt wird,
wobei die Oxidhalbleiterschicht Siliziumoxid umfasst, und
wobei die Halbleitervorrichtung derart konfiguriert ist, dass ein Änderungsbetrag einer Schwellenspannung in einem Temperaturbereich von Raumtemperatur bis 180 °C oder in einem Temperaturbereich von -25 °C bis 150 °C kleiner als oder gleich 3 V ist.

2. Verfahren zum Herstellen einer Halbleitervorrichtung nach Anspruch 1, wobei eine Kanallänge der Oxidhalbleiterschicht größer als oder gleich 1,5 $\mu$m und kleiner als oder gleich 100 $\mu$m ist.

3. Verfahren zum Herstellen einer Halbleitervorrichtung nach Anspruch 1, wobei die erste Wärmebehandlung bei einer Temperatur von höher als oder gleich 350 °C und niedriger als oder gleich 750 °C durchgeführt wird.

4. Verfahren zum Herstellen einer Halbleitervorrichtung nach Anspruch 1, wobei die erste Wärmebehandlung in einer Stickstoffatmosphäre oder einer Edelgasatmosphäre durchgeführt wird.

5. Verfahren zum Herstellen einer Halbleitervorrichtung nach Anspruch 1, wobei die zweite Wärmebehandlung bei einer Temperatur von höher als oder gleich 100 °C und niedriger als oder gleich der Temperatur der ersten Wärmebehandlung durchgeführt wird.

6. Verfahren zum Herstellen einer Halbleitervorrichtung nach Anspruch 1, wobei die zweite Wärmebehandlung in einer Luft, einer Sauerstoffatmosphäre, einer Stickstoffatmosphäre oder einer Edelgasatmosphäre durchgeführt wird.

**Revendications**

1. Procédé de fabrication d'un dispositif à semi-conducteur, le procédé comprenant les étapes de:

former une couche d'électrode de grille (101) au-dessus d'un substrat (100) ayant une surface isolante;
former une couche isolante de grille (102) au-dessus de la couche d'électrode de grille;
former une couche d'oxyde semi-conducteur (103) au-dessus de la couche isolante de grille;
effectuer un premier traitement thermique après la formation de la couche d'oxyde semi-conducteur;
former une couche d'électrode de source (105a) et une couche d'électrode de drain (105b) au-dessus de la couche d'oxyde semi-conducteur;
former une couche isolante de protection (107) en contact avec une partie de la couche d'oxyde semi-conducteur, de la couche d'électrode de source, et de la couche d'électrode de drain; et
effectuer un second traitement thermique après la formation de la couche isolante de protection,
dans lequel le second traitement thermique est effectué à une température inférieure à celle du premier traitement thermique,
dans lequel la couche d'oxyde semi-conducteur comprend un oxyde de silicium, et
dans lequel le dispositif à semi-conducteur est configuré de manière qu'une variation de la tension de seuil soit inférieure ou égale à 3 V dans une plage de température allant de la température ambiante à 180 °C ou dans une plage de température de -25 °C à 150 °C.

2. Procédé de fabrication d'un dispositif à semi-conducteur selon la revendication 1, dans lequel une longueur de canal de la couche d'oxyde semi-conducteur est supérieure ou égale à 1.5 $\mu$m et inférieure ou égale à 100 $\mu$m.

3. Procédé de fabrication d'un dispositif à semi-conducteur selon la revendication 1, dans lequel le premier traitement thermique est effectué à une température supérieure ou égale à 350 °C et inférieure ou égale à 750 °C.

4. Procédé de fabrication d'un dispositif à semi-conducteur selon la revendication 1, dans lequel le premier traitement thermique est effectué dans une atmosphère d'azote ou une atmosphère de gaz rare.

5. Procédé de fabrication d'un dispositif à semi-conducteur selon la revendication 1, dans lequel le second traitement thermique est effectué à une température supérieure ou égale à 100 °C et inférieure ou égale à la température du premier traitement thermique.

6. Procédé de fabrication d'un dispositif à semi-conducteur selon la revendication 1, dans lequel le second traitement thermique est effectué dans l'air, une atmosphère d'oxygène, une atmosphère d'azote, ou une atmosphère de gaz rare.

FIG. 1A

FIG. 1B

FIG. 1C

FIG. 1D

FIG. 1E

## FIG. 2A

## FIG. 2B

## FIG. 2C

FIG. 3A

FIG. 3B

FIG. 4A

L/W=3/20 (µm)

FIG. 4B

L/W=5/20 (µm)

FIG. 4C

L/W=10/20 (µm)

## FIG. 5A

| MEASUREMENT TEMPERATURE(°C) | Vth (V) | | |
|---|---|---|---|
| | TFT303 | TFT305 | TFT310 |
| 25 | 1.65 | 1.52 | 1.59 |
| 40 | 1.31 | 1.20 | 1.30 |
| 75 | 0.73 | 0.72 | 0.87 |
| 100 | 0.31 | 0.43 | 0.61 |
| 125 | -0.01 | 0.14 | 0.33 |
| 150 | -0.32 | -0.12 | 0.09 |
| 180 | -0.50 | -0.30 | -0.09 |
| CHANGE IN Vth | 2.16 | 1.83 | 1.68 |

## FIG. 5B

## FIG. 6

## FIG. 7A

## FIG. 7B

FIG. 8A

FIG. 8B

## FIG. 9A

## FIG. 9B

## FIG. 9C

## FIG. 9D

FIG. 10A

FIG. 10B

FIG. 11A-1

FIG. 11A-2

FIG. 11B

EP 2 478 563 B1

FIG. 12

# FIG. 13

FIG. 14

FIG. 15A

FIG. 15B

FIG. 15C

FIG. 16A

4504a  4503b

4502

H

4518b

4518a  4501  4503a  4504b  4505  4506

FIG. 16B

4540 4541  4513 4506 4511  4507  4544

4518a

4505

4519

4516  4515  4501  4509  4512 4517 4520  4510

4503a  4502

H  I

EP 2 478 563 B1

FIG. 17

FIG. 18

FIG. 19

# FIG. 20

FIG. 21

## FIG. 22

FIG. 23

## FIG. 24

FIG. 25

FIG. 26A

9600

9601 9603

9605

9609 — 9607
9610

FIG. 26B

9700

9701

9703

## FIG. 27A

## FIG. 27B

FIG. 28A

FIG. 28B

FIG. 29A

FIG. 29B

FIG. 29C

FIG. 29D

FIG. 30

EP 2 478 563 B1

## FIG. 31A

| MEASUREMENT TEMPERATURE (°C) | Vth(V) |
|---|---|
| 0 | 1.954 |
| 25 | 1.547 |
| 50 | 1.256 |
| 100 | 0.689 |
| 150 | 0.447 |
| CHANGE IN Vth | 1.507 |

## FIG. 31B

67

## FIG. 32A

## FIG. 32B

FIG. 33A

FIG. 33B

FIG. 33C

FIG. 33D

## FIG. 34A

L/W=3/50 (µm)

## FIG. 34B

L/W=20/20 (µm)

## FIG. 35A

| MEASUREMENT TEMPERATURE(°C) | Vth (V) | |
|---|---|---|
| | TFT331 | TFT332 |
| -25 | 1.78 | 2.03 |
| 0 | 1.60 | 1.83 |
| 25 | 0.27 | 1.58 |
| 40 | 0.97 | 1.45 |
| 85 | 0.45 | 1.06 |
| 100 | 0.47 | 1.32 |
| 125 | 0.02 | 0.76 |
| 150 | -0.1 | 0.82 |
| CHANGE IN Vth | 1.88 | 1.27 |

## FIG. 35B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007123861 A
- JP 200709605F B
- US 20080277663 A
- JP 2009215077 A
- JP 2010035349 A